# EUROPEAN PATENT SPECIFICATION

(11) **EP 3 481 046 B1**
(45) Date of publication and mention of the grant of the patent: **18.12.2024**
(21) Application number: 17788772.6
(22) Date of filing: 26.04.2017
(51) Int. Cl.: H04N 23/54, H01L 27/146, H04N 23/55

(54) **IMAGE CAPTURING MODULE AND MOLDED PHOTOSENSITIVE ASSEMBLY THEREFOR, MOLDED PHOTOSENSITIVE ASSEMBLY SEMI-FINISHED PRODUCT AND MANUFACTURING METHOD, AND ELECTRONIC DEVICE**
BILDERFASSUNGSMODUL UND GEFORMTE LICHTEMPFINDLICHE ANORDNUNG DAFÜR, HALBZEUG MIT GEFORMTER LICHTEMPFINDLICHER ANORDNUNG HERSTELLUNGSVERFAHREN UND ELEKTRONISCHE VORRICHTUNG
MODULE DE CAPTURE D'IMAGE ET ENSEMBLE PHOTOSENSIBLE MOULÉ POUR CELUI-CI, PRODUIT SEMI-FINI D'ENSEMBLE PHOTOSENSIBLE MOULÉ ET PROCÉDÉ DE FABRICATION ASSOCIÉ, AINSI QUE DISPOSITIF ÉLECTRONIQUE

(30) Priority: 28.04.2016 CN 201610278035; 28.04.2016 CN 201620373323 U; 12.08.2016 CN 201610668807; 12.08.2016 CN 201620875383 U; 12.08.2016 CN 201620875381 U; 12.08.2016 CN 201610669214; 12.08.2016 CN 201620876056 U; 12.08.2016 CN 201620875781 U
(43) Date of publication of application: 08.05.2019
(73) Proprietor: Ningbo Sunny Opotech Co., Ltd., Ningbo, Zhejiang 315400 (CN)
(72) Inventor: WANG, Mingzhu, Ningbo Zhejiang 315400 (CN); TANAKA, Takehiko, Nara Nara (JP); GUO, Nan, Ningbo Zhejiang 315400 (CN); CHEN, Zhenyu, Ningbo Zhejiang 315400 (CN); ZHAO, Bojie, Ningbo Zhejiang 315400 (CN); MEI, Zhewen, Ningbo Zhejiang 315400 (CN); HUANG, Zhen, Ningbo Zhejiang 315400 (CN); LUAN, Zhongyu, Ningbo Zhejiang 315400 (CN)
(74) Representative: Gong, Jinping
(86) International application number: PCT/CN2017/082000
(87) International publication number: WO 2017/186120

(56) References cited:
- WO-A1-2015/126328
- CN-A- 103 700 634
- JP-A- 2011 035 458
- JP-B2- 3 626 661
- KR-A- 20090 105 594
- US-A1- 2009 085 138

## Description

### FIELD OF INVENTION

The present invention relates to optical imaging, and more particularly to an image capturing module.

### DESCRIPTION OF RELATED ARTS

In recent years, image capturing module for acquiring images has become more and more widely used in many electronic devices such as personal electronic products, automotive products, medical products and so on. For example, the image capturing module is one of the standard accessories in portable electronic devices such as smart phones and tablet computers. The image capturing module in portable electronic devices can not only capture images but also enable portable electronic devices to have more functions such as real-time video calls. With the increasingly thinner and lighter requirements for portable electronic devices, and the higher imaging quality requirements of the image capturing module, more stringent requirements are focused on the overall size of the image capturing module and the imaging capabilities of the image capturing module. In other words, with the trend of development in portable electronic devices, the imaging capability of the image capturing module needs to be improved and enhanced with reducing the overall size of the image capturing module.

It is well known that the improvement of the imaging capability of the image capturing module is based on the configuration of a photosensitive element with a larger imaging area and more passive electronic components such as driving resistors and capacitors. Mainly because the image capturing module needs to be configured by photosensitive element with larger imaging area and more passive electronic components, it has to improve the packaging process of the image capturing module to reduce the overall size of the image capturing module. The conventional packaging process used for theimage capturing module is a COB (Chip On Board) packaging process, that is, a circuit board, a photosensitive element, a supporter, and the like of the image capturing module are respectively fabricated. Then, the passive electronic components, photosensitive element and the supporter are sequentially disposed to be packaged on the circuit board. In order to ensure the imaging quality of the image capturing module, it is necessary to fill glue between every two elements, for example, filling glue between the supporter and the circuit board to package the supporter on the circuit board and leveling the supporter with the circuit board. Therefore, the size of the image capturing module can not be effectively reduced in the COB packaging process and the packaging efficiency of the image capturing module is relatively low.

In order to solve these problems, a molding process is introduced into the field of image capturing module, which allows the supporter of the image capturing module to be integrally formed on the circuit board during manufacturing. In this way, not only the size of the image capturing module can be effectively reduced, it can also reduce manufacturing errors of the image capturing module to improve the imaging quality. However, there are still some shortcomings in introducing the molding process into the field of the image capturing module directly.

Firstly, the photosensitive element of the image capturing module mounted on the circuit board is electrically connected with the circuit board through a plurality of wires. Usually, the two ends of one of the lead wires are respectively soldered to the photosensitive element and the circuit board. And limited by the bonding process and the properties of the wire, after the two ends of the wire are soldered to the photosensitive element and the wire board, the wire is curved upwardly and protruded from the upper surface of the photosensitive element. During the molding process of the image capturing module, an upper mold of a set of molds is pressed downwardly, and the surface of the upper mold may press a protruding portion of the wire that may cause deformation of the wire. Once the wire is deformed, the wire is difficult to return to its original shape when the upper mold is removed.

Secondly, when the molding material for forming the supporter is added into a molding cavity inside the molds and solidified in the molding cavity to form the supporter, the deformed wire is preferred to be wrapped inside the supporter to be maintained in the deformed shape. The ability to transmit electrical signals between the photosensitive element and the circuit board of the deformed wire is greatly reduced, so that the imaging capability and imaging efficiency of the image capturing module are adversely affected. More importantly, when the wire is deformed by the pressing surface of the upper mold, the deformation direction and degree of deformation of the wire are uncontrollable. Therefore, two adjacent deformed lead wires may come in contact with each other that would cause a short-circuit, which leads to increasing the defect rate of the image capturing module. In addition, after the photosensitive element is mounted on the circuit board, a gap is formed between the photosensitive element and the circuit board. During the molding process, the molding material in fluid is capable of entering the gap formed between the photosensitive element and the circuit board, so that the mounting relationship between the photosensitive element and the circuit board is changed. Once the mounting relationship between the photosensitive element and the circuit board is changed, it inevitably causes inclination between the photosensitive element and the circuit board which adversely affects the imaging quality of the image capturing module.

CN103700634A provides a camera module, and an encapsulating structure and an encapsulating method thereof. The encapsulating structure of the camera module comprises a circuit board, an image sensing chip, a passive element, an encapsulating part and an infrared filter.

WO2015126328A1 discloses optical modules, which are made using customizable spacers to reduce variations in the focal lengths of the optical channels, to reduce the occurrence of tilt of the optical channels, and/or prevent adhesive from migrating to active portions of an image sensor.

JP2011035458A provides a camera module, wherein mounting components are incorporated. A case whose bottom surface is opened is bonded to the upper surface of a substrate where the image sensor is mounted, and a lens unit is attached onto the case.

KR20090105594A relates to a camera module and a manufacturing method thereof mounting a wafer lens on a second molding unit. The camera module includes a lead frame, a first molding unit, an image sensor, a second molding unit, and a lens.

US2009/085138A1 provides a glass cap molding package, a manufacturing method thereof and a camera module. The glass cap molding package includes a substrate; an image sensor mounted on the top surface of the substrate; a transparent member installed on an upper part of the image sensor; and a molding unit formed to seal the image sensor and the transparent member.

JP3626661B2 discloses a manufacturing method of an image pick-up device, an image pick-up device mounting product and an image pick-up device.

### SUMMARY OF THE PRESENT INVENTION

The present invention provides an image capturing module according to claim 1. Some features of optional or preferred embodiments are recited in the dependent claims.

The invention is advantageous in that it provides an image capturing module, wherein the molded photosensitive assembly of the image capturing module provides a supporting member (or supporting element) which is capable of avoiding an upper mold of a molding-die pressing on a wire connected between a photosensitive element and a circuit board of the molded photosensitive assembly, so as to prevent the wire from being deformed by being pressed during molding process.

### Brief description of the drawings

Fig. 1 is a schematic view of one of the manufacturing steps of an image capturing module according to a preferred embodiment of the present disclosure, illustrating that the photosensitive element of the image capturing module is mounted on the circuit board and the non-photosensitive area of the photosensitive element is connected with the circuit board by a set of lead wires.
Fig. 2A and 2B are a schematic view of one of the manufacturing steps of the image capturing module according to the above preferred embodiment of the present disclosure, illustrating that the supporting member of the image capturing module is disposed in the non-photosensitive area of the photosensitive element.
Fig. 3A is a schematic view of one of the manufacturing steps of the image capturing module according to the above preferred embodiment of the present disclosure, illustrating that the circuit board, the photosensitive element and the supporting member are placed in the molding-die between the upper mold and the lower mold, and the upper mold is pressed against the supporting member.
Fig. 3B is a schematic view of an alternative mode of one of the manufacturing steps of the image capturing module according to the above preferred embodiment of the present disclosure, illustrating that the circuit board, the photosensitive element and the supporting member are placed in a molding cavity between the upper mold and the lower mold of the molding-die, and a covering film is disposed between the pressing surface of the upper mold and the supporting member.
Fig. 4 is a schematic view of one of the manufacturing steps of the image capturing module according to the above preferred embodiment of the present disclosure, illustrating that a molding material for forming the molded base of the image capturing module is filled in the molding cavity formed between the upper mold and the lower mold.
Fig. 5 is a perspective view of one of the manufacturing steps of the image capturing module according to the above preferred embodiment of the present disclosure, illustrating that the molding material is solidified and cured to form the molded base.
Fig.6 is a schematic view of one of the manufacturing steps of the image capturing module according to the above preferred embodiment of the present disclosure, illustrating that a filter member of the image capturing module is mounted on the molded base.
Fig. 7 is a schematic view of one of the manufacturing steps of the image capturing module according to the above preferred embodiment of the present disclosure, illustrating that an optical lens of the image capturing module is mounted on a driver, wherein the driver is mounted on the molded base to manufacture the image capturing module.
Fig. 8 is a schematic view of an alternative mode of the image capturing module according to the above preferred embodiment of the present disclosure.
Fig. 9A is a schematic view of a first alternative mode of a molded photosensitive assembly of the image capturing module according to the above preferred embodiment of the present disclosure.
Fig. 9B is a schematic view of a second alternative mode of the molded photosensitive assembly of the image capturing module according to the above preferred embodiment of the present disclosure.
Fig. 9C is a schematic view of a third alternative mode of the molded photosensitive assembly of the image capturing module according to the above preferred embodiment of the present disclosure.
Fig. 10A is a schematic view of a fourth alternative mode of the molded photosensitive assembly of the image capturing module according to the above preferred embodiment of the present disclosure.
Fig. 10B is a schematic view of a fifth alternative mode of the molded photosensitive assembly of the image capturing module according to the above preferred embodiment of the present disclosure.
Fig. 11 is a schematic view of a sixth alternative mode of the molded photosensitive assembly of the image capturing module according to the above preferred embodiment of the present disclosure.
Fig. 12 is a schematic view of an alternative mode of the image capturing module according to the above preferred embodiment of the present disclosure.
Fig. 13 is a schematic view of an alternative mode of the image capturing module according to the above preferred embodiment of the present disclosure.
Fig. 14 is a block diagram of the image capturing module according to the above preferred embodiment of the present disclosure, illustrating an electronic device.
Fig. 15A is a schematic top view of the first manufacturing stage for an image capturing module according to another preferred embodiment of the present disclosure.
Fig. 15B is a schematic sectional view of the first manufacturing stage for the image capturing module according to the above preferred embodiment of the present disclosure.
Fig. 16 is a schematic sectional view of the second manufacturing stage for the image capturing module according to the above preferred embodiment of the present disclosure.
Fig. 17 is a schematic sectional view of the third manufacturing stage for the image capturing module according to the above preferred embodiment of the present disclosure.
Fig. 18 is a schematic sectional view of the fourth manufacturing stage for the image capturing module according to the above preferred embodiment of the present disclosure.
Fig. 19 is a schematic sectional view of the fifth manufacturing stage for the image capturing module according to the above preferred embodiment of the present disclosure.
Fig. 20 is a schematic sectional view of the sixth manufacturing stage for the image capturing module according to the above preferred embodiment of the present disclosure.
Fig. 21 is a schematic sectional view of the seventh manufacturing stage for the image capturing module according to the above preferred embodiment of the present disclosure.
Fig. 22 is a schematic sectional view of the eighth manufacturing stage for the image capturing module according to the above preferred embodiment of the present disclosure.
Fig. 23 is a schematic sectional view of the ninth manufacturing stage for the image capturing module according to the above preferred embodiment of the present disclosure.
Fig. 24 is a schematic sectional view of the tenth manufacturing stage for the image capturing module according to the above preferred embodiment of the present disclosure.
Fig. 25 is a schematic sectional view of the eleventh manufacturing stage for the image capturing module according to the above preferred embodiment of the present disclosure.
Fig. 26A and Fig. 26B are schematic sectional views of the twelfth manufacturing stage for the image capturing module according to the above preferred embodiment of the present disclosure.
Fig. 27A is a schematic sectional view of the thirteenth manufacturing stage for the image capturing module according to the above preferred embodiment of the present disclosure.
Fig. 27B is a schematic sectional view of the fourteenth manufacturing stage for the image capturing module according to the above preferred embodiment of the present disclosure.
Fig. 28 is a schematic sectional view of the fourteenth manufacturing stage for the image capturing module according to the above preferred embodiment of the present disclosure.
Fig. 29 is a schematic sectional view of the fifteenth manufacturing stage for the image capturing module according to the above preferred embodiment of the present disclosure.
Fig. 30 is a schematic sectional view of the sixteenth manufacturing stage for the image capturing module according to the above preferred embodiment of the present disclosure.
Fig. 31 is a schematic sectional view of the seventeenth manufacturing stage for the image capturing module according to the above preferred embodiment of the present disclosure.
Fig. 32 is a schematic sectional view of the eighteenth manufacturing stage for the image capturing module according to the above preferred embodiment of the present disclosure.
Fig. 33 is a schematic sectional view of the nineteenth manufacturing stage for the image capturing module according to the above preferred embodiment of the present disclosure.
Fig. 34 is a schematic sectional view of the twentieth manufacturing stage for the image capturing module according to the above preferred embodiment of the present disclosure.
Fig. 35 is a schematic sectional view of the twenty-first manufacturing stage for the image capturing module according to the above preferred embodiment of the present disclosure, with illustrating the internal structure of the image capturing module sectioned along the middle position.
Fig. 36 is a schematic view of the inner structure of a modified embodiment manner of the image capturing module according to the above preferred embodiment of the present disclosure, sectioned along the middle.
Fig. 37 is a schematic view of the inner structure of another modified embodiment manner of the image capturing module according to the above preferred embodiment of the present disclosure, sectioned along the middle.
Fig. 38 is a schematic view of the inner structure of another modified embodiment manner of the image capturing module according to the above preferred embodiment of the present disclosure, sectioned along the middle.
Fig. 39 is a schematic view of the inner structure of another modified embodiment manner of the image capturing module according to the above preferred embodiment of the present disclosure, sectioned along the middle.
Fig. 40 is a schematic view of the inner structure of another modified embodiment manner of the image capturing module according to the above preferred embodiment of the present disclosure, sectioned along the middle.
Fig. 41 is a schematic view of the inner structure of another modified embodiment manner of the image capturing module according to the above preferred embodiment of the present disclosure, sectioned along the middle.
Fig. 42 is a schematic view of the inner structure of another modified embodiment manner of the image capturing module according to the above preferred embodiment of the present disclosure, sectioned along the middle.
Fig. 43 is a sectional view of a manufacturing stage for the image capturing module according to the above preferred embodiment of the present disclosure.
Fig. 44 is a sectional view of another manufacturing stage for the image capturing module according to the above preferred embodiment of the present disclosure.
Fig. 45 is a sectional view of another manufacturing stage for the image capturing module according to the above preferred embodiment of the present disclosure.
Fig. 46 is a sectional view of another manufacturing stage for the image capturing module according to the above preferred embodiment of the present disclosure.
Fig. 47 is a sectional view of another manufacturing stage for the image capturing module according to the above preferred embodiment of the present disclosure.
Fig. 48 is a sectional view of another manufacturing stage for the image capturing module according to the above preferred embodiment of the present disclosure.
Fig. 49 is a sectional view of another manufacturing stage for the image capturing module according to the above preferred embodiment of the present disclosure.
Fig. 50 is a sectional view of another manufacturing stage for the image capturing module according to the above preferred embodiment of the present disclosure.
Fig. 51A and Fig. 51B are sectional views of another manufacturing stage for the image capturing module according to the above preferred embodiment of the present disclosure.
Fig. 52 is a schematic view of the inner structure of a modified embodiment manner of the image capturing module according to the above preferred embodiment of the present disclosure, sectioned along the middle.
Fig. 53A and Fig. 53B are combined as a cross-sectional view of another manufacturing method of the image capturing module according to the above preferred embodiment of the present disclosure at different manufacturing stages.
Fig. 54 is a schematic view showing the internal structure of the image capturing module according to a preferred embodiment of the present disclosure, sectioned along the intermediate position.
Fig. 55 is a perspective view showing the structural relationship between a circuit board, a photosensitive chip, and a protective frame of the image capturing module according to the above preferred embodiment of the present disclosure.
Fig. 56A is a cross-sectional view showing the first step of a manufacturing process of the image capturing module according to the above preferred embodiment of the present disclosure.
Fig. 56B is a cross-sectional view showing the second step of the manufacturing process of the image capturing module according to the above preferred embodiment of the present disclosure.
Fig. 56C is a cross-sectional view showing the third step of the above manufacturing process of the image capturing module according to the above preferred embodiment of the present disclosure.
Fig. 56D is a cross-sectional view showing the fourth step of the above manufacturing process of the image capturing module according to the above preferred embodiment of the present disclosure.
Fig. 56E is a cross-sectional view showing the fifth step of the above manufacturing process of the image capturing module according to the above preferred embodiment of the present disclosure.
Fig. 56F is a cross-sectional view showing the sixth step of the above manufacturing process of the image capturing module according to the above preferred embodiment of the present disclosure.
Fig. 57A is a cross-sectional view showing a modified embodiment of the third step of the manufacturing process of the image capturing module according to the above preferred embodiment of the present disclosure.
Fig. 57B is a cross-sectional view showing a modified embodiment of the fourth step of the above manufacturing process of the image capturing module according to the above preferred embodiment of the present disclosure.
Fig. 58 is a cross-sectional view showing another modified embodiment of the fourth step of the above-described manufacturing process of the image capturing module according to the above preferred embodiment of the present disclosure.
Fig. 59A is a cross-sectional view showing the first step of another manufacturing process of the image capturing module according to the above preferred embodiment of the present disclosure.
Fig. 59B is a cross-sectional view showing the second step of the manufacturing process of the image capturing module according to the above preferred embodiment of the present disclosure.
Fig. 59C is a cross-sectional view showing the third step of the above manufacturing process of the image capturing module according to the above preferred embodiment of the present disclosure.
Fig. 59D is a cross-sectional view showing the fourth step of the manufacturing process of the image capturing module according to the above preferred embodiment of the present disclosure.
Fig. 59E is a cross-sectional view showing the fifth step of the above manufacturing process of the image capturing module according to the above preferred embodiment of the present disclosure.
Fig. 59F is a cross-sectional view showing the sixth step of the above manufacturing process of the image capturing module according to the above preferred embodiment of the present disclosure.
Fig. 59G is a cross-sectional view showing the seventh step of the above manufacturing process of the image capturing module according to the above preferred embodiment of the present disclosure.
Fig. 60 is a schematic view showing the internal structure of the image capturing module according to another preferred embodiment of the present disclosure, sectioned along the intermediate position.
Fig. 61 is a perspective view showing the structural relationship between a circuit board, a photosensitive chip, a filter element, and a protective frame of the image capturing module according to the above preferred embodiment of the present disclosure.
Fig. 62A is a cross-sectional view showing the first step of a manufacturing process of the image capturing module according to the above preferred embodiment of the present disclosure.
Fig. 62B is a cross-sectional view showing the second step of the manufacturing process of the image capturing module according to the above preferred embodiment of the present disclosure.
Fig. 62C is a cross-sectional view showing the third step of the above manufacturing process of the image capturing module according to the above preferred embodiment of the present disclosure.
Fig. 62D is a cross-sectional view showing the fourth step of the manufacturing process of the image capturing module according to the above preferred embodiment of the present disclosure.
Fig. 62E is a cross-sectional view showing the fifth step of the above manufacturing process of the image capturing module according to the above preferred embodiment of the present disclosure.
Fig. 62F is a cross-sectional view showing the sixth step of the above manufacturing process of the image capturing module according to the above preferred embodiment of the present disclosure.

### Detailed Description of the Embodiment

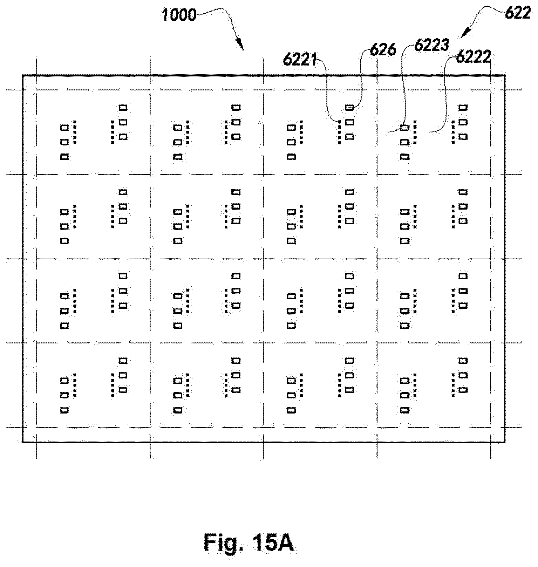

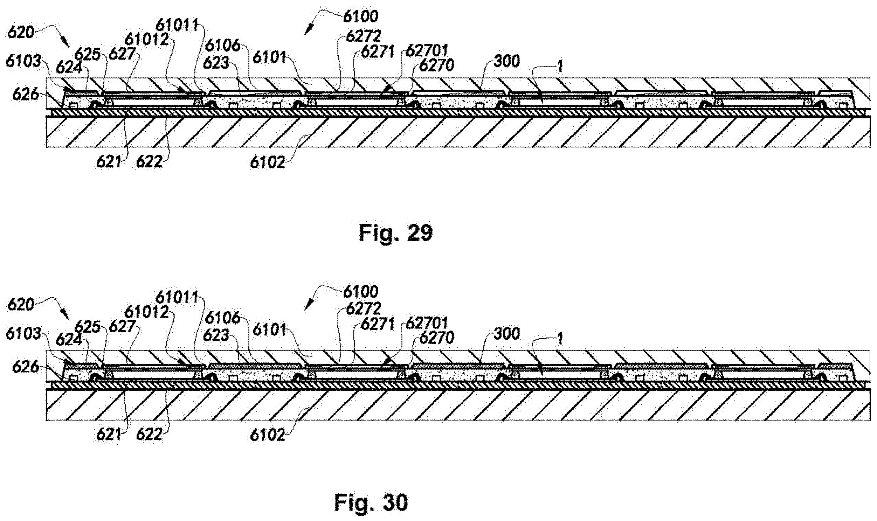

It should be understood by those skilled in the art that in the disclosure of the present application, the terms "longitudinal", "transverse", "upper", "lower", "front", "back", "left", "right", " "upright", "horizontal", "top", "bottom", "inside", "outside", etc. indicates the orientation or positional relationship, based on the orientation or positional relationship shown in the drawings, which is merely for the convenience of describing the present disclosure, rather than indicates or implies that the device or component referred must have a particular orientation, be constructed and operated in a particular orientation, and, thus, the above description of the disclosure is not to be construed as a limitation of the invention. The scope of protection of the present application is defined by the appended claims. Some specific embodiments of the invention are explained in detail based on Fig. 15A to Fig. 53B. The embodiments / aspects / examples, which are not according to the invention covered by the claims, are present for illustration purposes only.

It will be understood that the term "a" is understood to mean "at least one" or "one or more", that is, in one embodiment, the number of one element may be one, and in other embodiments, the number of one element can be multiple, and the term "a" cannot be construed as a limitation on the quantity.

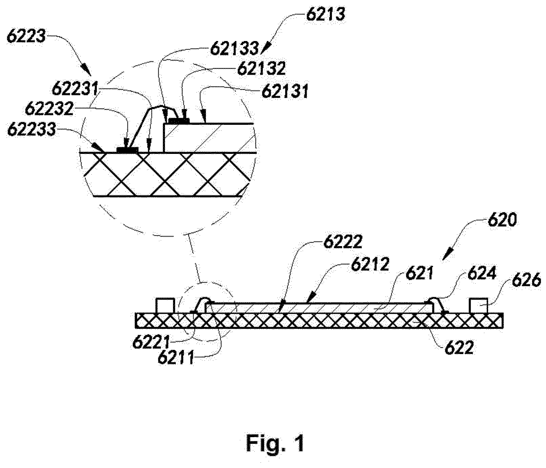

According to Figs.1 to 7 of the drawings of the present disclosure, an image capturing module according to a preferred embodiment of the present disclosure is illustrated, wherein the image capturing module comprises at least one optical lens 610 and at least one molded photosensitive assembly 620. The at least one molded photosensitive element 620 further comprises a photosensitive element 621, a circuit board 622, a molded base 623, and a set of lead wires 624, wherein each of the lead wires 624 has two ends extended to be connected toa non-photosensitive area of the photosensitive element 621 and the circuit board 622, wherein the molded base 623 is integrally molded with the circuit board 622, so that the molded base 623 and the circuit board 622 are formed in an integrated structure, and the at least one optical lens 610 is disposed in a photosensitive path of the photosensitive element 621 of the molded photosensitive element 620. Light reflected by an object enters the inside of the image capturing module from the optical lens 610 to be received and photoelectrically converted by the photosensitive element 621 subsequently, for obtaining an image about the object.

It is worth to mention that the photosensitive element 621 has a set of chip connectors 6211, and the circuit board 622 has a set of circuit connectors 6221, wherein two ends of each of the lead wires 624 can be respectively connected to the respective chip connector 6211 of the photosensitive element 621 and the respective circuit connector 6221 of the circuit board 622 in such a manner that the photosensitive element 621 and the circuit board 622 are electrically connected. For example, in the present disclosure, each of the chip connectors 6211 of the photosensitive element 621 and each of the circuit connectors 6221 of the circuit board 622 may be a pad. That is, each of the chip connectors 6211 of the photosensitive element 621 and each of the circuit connectors 6221 of the circuit board 622 may be in a round shape for connecting with the two ends of each of the lead wires 624 to connect the respective chip connector 6211 of the photosensitive element 621 and the respective circuit connector 6221 of the circuit board 622. For another example in the present disclosure, each of the chip connectors 6211 of the photosensitive element 621 and each of the circuit connectors 6221 of the circuit board 622 may be in spherical shape, such as solder paste or the like. A solder material is placed on the photosensitive element 621 and the circuit board 622 to form the chip connector 6211 of the photosensitive element 621 and the circuit connector 6221 of the circuit board 622. Nevertheless, the shape of the chip connector 6211 of the photosensitive element 621 and the circuit connector 6221 of the circuit board 622 is not limited in the present disclosure.

The photosensitive element 621 comprises a photosensitive area 6212 and a non-photosensitive area 6213, wherein the photosensitive area 6212 and the non-photosensitive area 6213 of the photosensitive element 621 are integrally formed, wherein the photosensitive area 6212 is positioned in the middle of photosensitive element 621 and the non-photosensitive area 6213 is positioned at the periphery of the photosensitive element 621, wherein the photosensitive area 6212 is circularly surrounded by the surrounding non-photosensitive area 213. After the light reflected by the object enters the inside of the image capturing module from the optical lens 610, it can be received and photoelectrically converted by the photosensitive area 6212 of the photosensitive element 621 to obtain an image associated with the object.

One skilled in the art will understand that each of the chip connectors 6211 of the photosensitive element 621 is disposed in the non-photosensitive area 6213 of the photosensitive element 621. In addition, the non-photosensitive area 6213 of the photosensitive element 621 has a chip-inner portion 62131, a chip-connecting portion 62132, and a chip-outer portion 62133, wherein the photosensitive area 212is surrounded by the chip-inner portion 62131. Both sides of the chip-connecting portion 62132 are respectively extended and connected to the chip-inner portion 62131 and the chip-outer portion 62133. That is, from a position where the chip connector 6211 is disposed to a position of the periphery of the photosensitive area 6212 to the non-photosensitive area 6213 is defined as the chip-inner portion 62131, wherein an area where the chip connector 6211 is disposed on the non-photosensitive area 6213 is defined as the chip-connecting portion 62132,whereinan area from the position where the chip connector 6211 is disposed on the non-photosensitive area 6213 to the outer periphery of the photosensitive element 21 is defined as the chip-outer portion 62132. In other words, from the top view of the photosensitive element 621, in order from the outer periphery to the inside, the photosensitive element 621 is formed by the chip-outer portion 62133, the chip-connecting portion 62132, the chip-inner portion 62131, and the photosensitive area 6212.

In addition, the circuit board 622 comprises a flat chip mounting area 6222 and a periphery area 6223, wherein the periphery area 6223 is integrally formed with the chip mounting area 6222, and the periphery area 6223 is positioned near the periphery of the mounting area 6222. The chip mounting area 6222 is adapted to mount the photosensitive element 621 thereon, and the circuit connector 6221 is disposed on the periphery area 6223. The periphery area 6223 of the circuit board 622 has a circuit-inner portion 62231, a circuit-connecting portion 62232, and a circuit-outer portion 62233. The chip mounting area 222 is surrounded by the circuit-inner portion 62231. The two sides of the circuit-connecting portion 62232 are respectively extended and connected to the circuit-inner portion 62231 and the circuit-outer portion 62233. That is, an area from a position where the board connector 6221 is disposed on the periphery area 6223 to a position of the periphery of the chip mounting area 6222 is defined as the circuit-inner portion 62231, an area of the periphery area 6223 where the circuit connector 6221 is disposed is defined as the circuit-connecting portion 62232, and an area from the position where the circuit connector 6221 is disposed on the periphery area 6223 to the outer edge of the periphery area 6223 is defined as the circuit-outer portion 62233. In other words, from the top view of the circuit board 622, in order from the inside to the outer edge, the circuit board 622 is formed by the circuit-outer portion 62233, the circuit-connecting portion 62232, the circuit-inner portion 62231, and the chip mounting area 6222. The type of the lead wires 624 is not limited in the image capturing module of the present disclosure. For example, in one specific example, the lead wires 624 each may be implemented as a gold wire, that is in a manner of connecting gold lead wires between the photosensitive element 621 and the circuit board 622, so that the optical signal after converting into an electrical signal in the photosensitive element 621 can be further transmitted to the circuit board 622 through the lead wires 624. One skilled in the art will understand that in other examples of the image capturing module, the wire 624 can be implemented as a silver wire, a copper wire, or the like that the material can realize transferring the electrical signal between the photosensitive element 621 and the circuit board 622.

In addition, in one example, the image capturing module can be implemented as a fixed focus image capturing module, wherein the optical lens 610 is held in the photosensitive path of the photosensitive element 621 by a lens holder mounted on the molded base 623 of the image capturing module.

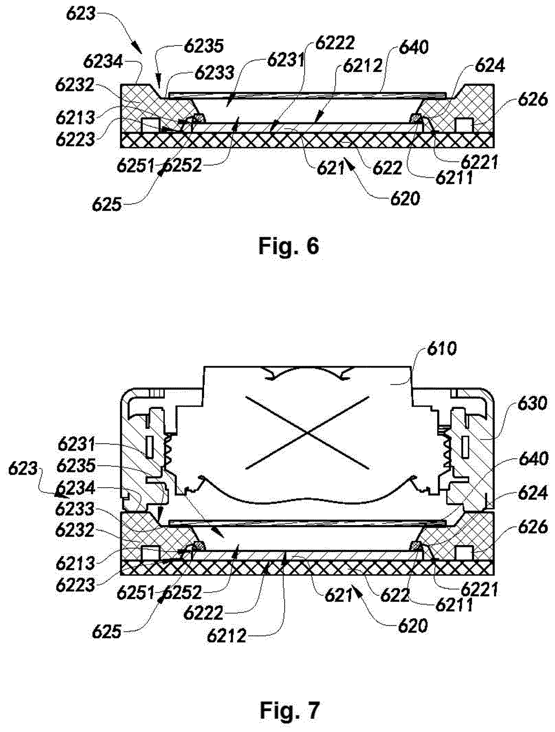

In another example, the image capturing module can be implemented as a zoom image capturing module, wherein the focal length of the image capturing module is adjusted by changing the distance between the optical lens 610 and the photosensitive element 621. Specifically, in the example shown in Fig. 7, the image capturing module further comprises at least one driver 630, wherein the optical lens 610 is disposed correspondingly to the at least one driver 630, wherein the driver 630 dismounted on the molded base 623 and is electrically and respectively connected to the circuit board 622 to drive the optical lens 610 to move along the photosensitive path of the photosensitive element 621 by the driver 30after transmitting power and control signals with the circuit board 622 to the driver 630, thereby adjusting the focal length of the image capturing module. That is, the optical lens 610 is drivably disposed with respect to the driver 630.

It is worth to mention that the type of the driver 630 of the image capturing module is not limited in the present disclosure. For example, in one example, the driver 630 can be implemented as a drive unit, such as a voice coil motor, to move the optical lens 610 along the photosensitive path of the photosensitive element 621, wherein the driver 630 is capable of receiving electrical power and control signals to be in an operational state.

Furthermore, according to Fig. 7, the image capturing module further comprises at least one filter member 640, wherein the at least one filter member 640 is mounted on each of the molded base 623 and positioned in the photosensitive path of each of the photosensitive elements 621. The light reflected by the object enters the inside of the image capturing module from the optical lens 610 and is filtered by the filter member 640 to be received and photoelectrically converted by the photosensitive element 621. That is, the filter member 640 can filter stray light reflected by the object from the optical lens 610 into the interior of the image capturing module, such as an infrared light. In such a manner, the imaging quality of the image capturing module is improved.

One skilled in the art will understand that in different examples of the image capturing module, the filter members 640 can be implemented with different types, for example, the filter members 640 can be implemented as infrared cutoff filters, full transmissive spectral filters, and other filters or a combination of multiple types of filters. For example, the filter member 640 can be implemented as a combination of an infrared cutoff filter and a full transmissive filter that is the infrared cutoff filter and the full transmissive spectral filter can be selectively switched to be positioned along the photosensitive path of the photosensitive element 621. For example, in an environment where light is sufficient during daytime, the infrared cutoff filter may be chosen in the photosensitive path of the photosensitive element 621 to filter infrared rays reflected by the object entering the image capturing module. When the image capturing module is used in a dark environment, such as a dark night, the full-transmission spectral filter can be chosen in the photosensitive path of the photosensitive element 621 to allow the infrared part of the light reflected by the object entering the image capturing module.

According to Fig. 7, the molded photosensitive assembly 620 of the image capturing module further comprises a supporting member 625, wherein the supporting member 625 is disposed on the non-photosensitive area 6213 of the photosensitive element21 before the molded base 623 is molded. After the molded base 623 is molded, the circuit board 622, the non-photosensitive area 6213 of the photosensitive element 621, and a part of the supporting member 625 is covered by the molded base 623 to form the molded photosensitive assembly 620, wherein the supporting member 625 can effectively improve the product yield of the image capturing module and improve the imaging quality of the image capturing module. In the following description, features and advantages of the supporting member 625 will be further illustrated and disclosed.

Furthermore, the supporting member 625 has a top surface 62501, an inner surface 62502 and an outer surface 62503, wherein the two sides of the top surface 62501 are respectively connected to the inner surface 62502 and the outer surface 62503. It is worth mentioning that the side of the supporting member 625 facing the photosensitive element 621 is defined as the inner surface 62502 of the supporting member 625 and the side of the supporting members 625 facing the circuit board 622 is defined as the outer surface 62503 of the supporting member 625.

According to Fig. 7, the molded photosensitive assembly 620 of the image capturing module further comprises a plurality of electronic components 626, wherein each of the electronic components 626 can be mounted on the periphery area 6223 of the circuit board 622 by a process such as SMT (Surface Mount Technology). Preferably, each of the electronic components 626 is mounted on the circuit-outer portion 62233 of the periphery area 6223. The photosensitive element 621 and each of the electronic components 626 may be mounted on the same side or opposite sides of the circuit board 622. For example, the photosensitive element 621 and each of the electronic components 626 are mounted on the same side of the circuit board 622, the photosensitive element 621 is mounted on the chip mounting area 6222 of the circuit board 622, and each of the electronic components 626 is mounted on the periphery area 6223 of the circuit board 622. After the molded base 623 is integrally molded to the circuit board 622, each of the electronic components 626 is covered by the molded base 623 to be isolated from the adjacent electronic components 626. Even the distance between two of the adjacent electronic components 626 is relatively close, the molded base 623 can prevent the adjacent electronic components 626 from contacting or interfering with each other by isolating the adjacent electronic components 626 with the photosensitive element 621 in the image capturing module of the present disclosure. And in a manner that the electronic components 626 are covered by the molded base 623, it can also be avoided the electronic contaminants generated on the surface of the electronic components 226 from contaminating the photosensitive area 6212 of the photosensitive element 621, thereby reducing the size of the image capturing module and improving the imaging quality of the image capturing module. That is, the circuit board 622 in a small area can be mounted with more electronic components 626 of the image capturing module of the present disclosure by covering the electronic components 626 by the molded base 623. It is worth mentioning that the types of the electronic component26 include, but are not limited to, resistor, capacitor, driving device, and the like.

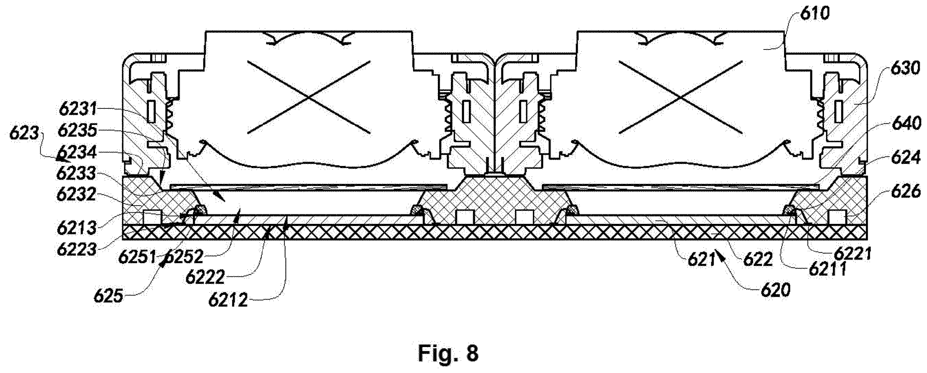

In addition, it will be understood by one skilled in the art that, although the single image capturing module is taken as an example to disclose the manufacturing steps of the image capturing module and the manufacturing steps of the molded photosensitive assembly 620 as shown in Fig. 1 to Fig.7, the image capturing module can also be implemented as a dual lens image capturing module or an array image capturing module as shown in Fig. 8, in which the disclosure should not be limited to the number of molded photosensitive assembly of the image capturing module.

The manufacturing steps of the image capturing module and the manufacturing steps of the molded photosensitive assembly 620 are illustrated as shown in Figs. 1 to 7.

According to Fig. 1, the photosensitive element 621 is mounted on the chip mounting area 6222 of the circuit board 622, and each of the chip connectors211 of the non-photosensitive area 6213 of the photosensitive element 621 and the circuit connectors 6221 on the periphery area 6223 of the circuit board 622 are connected by a set of the lead wires 624 respectively. Furthermore, each of the electronic components 626 is mounted on the circuit-outer portion 62233 of the periphery area 6223 of the circuit board 622. That is, both ends of the lead wires 624 are respectively connected to the photosensitive element 621 and the circuit board 622, wherein each of the lead wires 624 upwardly protrudes on the surface of the photosensitive element 621. It can be understood that, limited to the wire bonding process of connecting the photosensitive element 621 and the circuit board 622 with the lead wires 624 and the characteristics of the lead wires 624 themselves. After the two ends of the lead wires 624 are respectively connected to the respective chip connector 6211 of the non-photosensitive area 6213 of the photosensitive element 621 and the respective circuit connector 6221 of the periphery area 6223 of the circuit board 622, the lead wires 624 need to be in an arc shape to be protruded on the upper surface of the photosensitive element 621. In addition, maintaining the arc shape of each of the lead wires 624 in a curved state facilitates the ability to transmit the electrical signals between the photosensitive element 621 and the circuit board 622. Each of the lead wires 624 is arranged between the photosensitive element 621 and the circuit board 622, for example, be equally spaced. One skilled in the art will understand that during the process of manufacturing the image capturing module and during using of the image capturing module, maintaining each of the lead wires 624 in this initial state has advantages for ensuring the ability of the lead wires 24transmitting the electrical signals between the photosensitive element 621 and the circuit board 622 so as to ensure the image quality of the image capturing module.

One skilled in the art will understand that although one of the photosensitive elements 621 is mounted on one of the circuit boards 622 as an example in Fig. 1, as illustrated in the manufacturing steps and the manufacturing steps of the image capturing module of the present disclosure are explained. In another example of the manufacturing steps of the molded photosensitive assembly 620 of the image capturing module, a plurality of the photosensitive elements 621 may be mounted on different positions of one of the circuit board 622 to be subsequently fabricated in a duel lens image capturing module or an array image capturing module. In another example, a plurality of the circuit boards 622 may be pieced together to form one of the circuit board, and then each of the photosensitive element 621 is respectively mounted on one of the pieced circuit board correspondingly to the position of the circuit board 622, so as to separate the pieced circuit board later. The disclosure is not limited in this way.

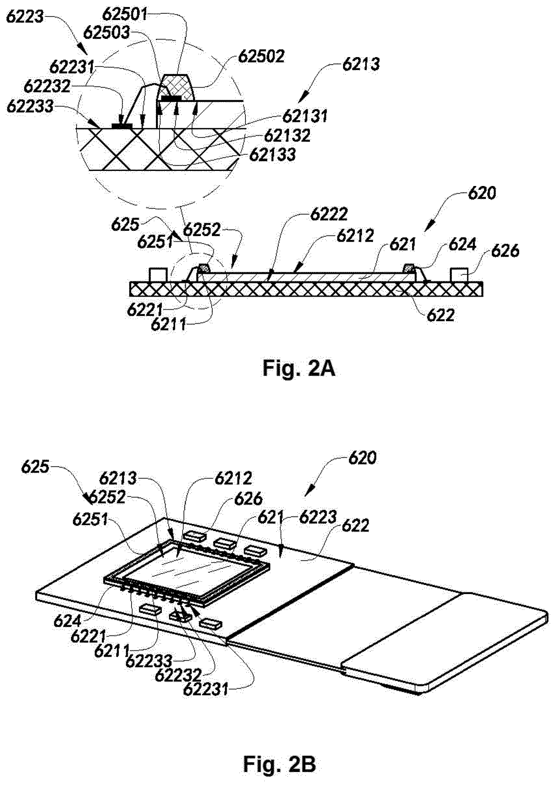

According to Figs. 2A and 2B, the supporting member 625 is disposed on the non-photosensitive area 6213 of the photosensitive element 621,so as to form molded photosensitive assembly semi-finished product by the photosensitive element 621, the circuit board 622, and the supporting member 625, wherein the supporting member 625 is provided to cover the chip-inner portion 62131, the chip-connecting portion 62232, and the chip-outer portion 62233 of the non-photosensitive area 6213 of the photosensitive element 621. In other words.

The supporting member 625 can cover a part of each of the lead wires 624 to enable the lead wires 624 to be wrapped during manufacturing the image capturing module and during the molding of the photosensitive element 620 to improve the imaging quality of the image capturing module by protecting the good electrical properties of the lead wires 624. One skilled in the art will understand that in this embodiment of the image capturing module of the present disclosure, the chip connector 6211 of the photosensitive element 621 is covered by the supporting member 625. Furthermore, the supporting member 625 comprises a frame-shaped supporting body 6251 and has a through hole 6252, wherein the supporting body 6251 is disposed on the non-photosensitive area 6213 of the photosensitive element 621 to make the photosensitive area 6212 of the photosensitive element21 corresponding to the through hole 6252 of the supporting member 625, so that the supporting body 6251 can protect the photosensitive area 6212 of the photosensitive element 621 during a molding process. The molded base 623 covers the outer surface 62503 of the supporting body 6251 and at least a part of the top surface 62501 after molded. It is worth mentioning that the inner surface 62502 of the supporting member 625 forms the through hole 6252 of the supporting member 625.

Preferably, the chip-inner portion 62131, the chip-connecting portion 62132, and the chip-outer portion 62133 of the photosensitive element 621 are covered by the supporting body 6251, that is the supporting body 6251 can cover the chip connector 6211 of the supporting body such that the supporting body 6251 can prevent the lead wires 624 and the connection position of the chip connector 6211 from contacting the molding material for forming the molded base 623 to avoid the lead wires 624 being detached from the chip connector 6211. It can be understood that when the supporting body 6251 covers the lead wires 624 and the connection position of the chip connector 6211, the supporting body 6251 can isolate the lead wires 624 and the connection position of the chip connector 6211 for preventing deformation of the end portion of each of the lead wires 624 connecting the chip connector 6211 and detaching of the lead wires 624 from the chip connector 6211 causing by the molding material during a molding process. In one embodiment, the supporting body 6251 may be formed by a cured glue applied in the non-photosensitive area 6213 of the photosensitive element 621, so that the supporting body 6251 has a predetermined elasticity, wherein after the supporting body 6251 is formed, the inner surface 62502 of the supporting body 6251 forms the through hole 6252 while the photosensitive area 6212 of the photosensitive element 621 is positioned corresponding to the through hole 6252. In addition, the supporting body 6251 formed by the glue after cured may also have a viscosity for adhering contaminant such as dust subsequently, thereby preventing the contaminants from contaminating the photosensitive area 6212 of the photosensitive element 621 to cause the stain point in the photosensitive area 6212 of the photosensitive element 621 so as to further ensure the image quality of the image capturing module. For example, the supporting body 6251 is disposed between the photosensitive area 6212 of the photosensitive element 621 and the electronic component 626, thereby preventing contamination by contaminants, such as the solder powder generated during the electronic component 626 is mounted on the circuit board 622 from contaminating the photosensitive area 6212 of the photosensitive element 621 in a way that the solder powder may be adhered by the supporting body 6251.

Preferably, the supporting body 6251 may cover the non-photosensitive area 6213 of the photosensitive element 621 in a gel state and be formed after cured to prevent covering the non-photosensitive area 6213 of the photosensitive element 21flowing to contaminate the photosensitive area 6212 of the photosensitive element 621. In other words, the glue has good plasticity and self-setting properties before cured to form the supporting body 6251, so that the glue is not deformed during applying to the non-photosensitive area 6213 of the photosensitive element 621 and curing. One skilled in the art will understand that the supporting body 6251 formed by the glue can cover the lead wires 624 by applying the glue in a gel state to the non-photosensitive area 6213 of the photosensitive element 621 to prevent damaging the lead wires 624 during applying of the glue to the non-photosensitive area 6213 of the photosensitive element 621.

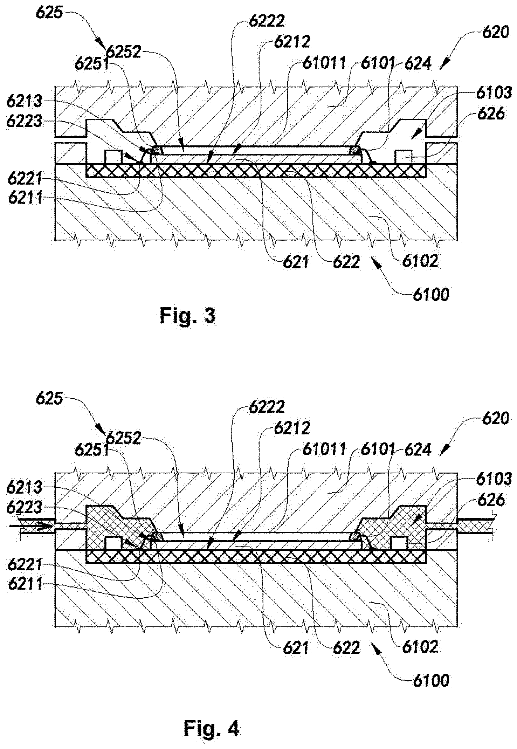

According to Fig. 3A, during the molding process, the molding material is solidified and cured by a molding-die 6100 to form the molded base 623 which is at least integrally molded on the circuit board 622, such that the method can reduce the size of the image capturing module and reduce the assembly error of the image capturing module, thereby making the structure of the image capturing module more compact and improving the imaging quality of the image capturing module.

Specifically, the molding-die 6100 comprises the upper mold 6101 and the lower mold 6102, wherein at least one of the upper mold 6101 and the lower mold 6102 can be moved to make the upper mold 6101 and the lower mold 6102 being operated to close the upper mold 6101 and the lower mold 6102 by a mold clamping operation, wherein at least one molding cavity 6103 is formed between the upper mold 6101 and the lower mold 6102 and the molding material is filled in the molding cavity 6103 to form the molded base 623 after solidifying and curing. For example, in one embodiment, the lower mold 6102 is generally fixed, and the upper mold 6101 can be moved relative to the lower mold 6102 along at least a guiding rod to face the lower mold 6102 to be clamped when the upper mold 101 is moved, thereby forming the molding cavity 6103 between the upper mold 6101 and the lower mold 6102, and the molding-die 6100 can be demolded while the upper mold 6101 moving away from the lower mold 6102. Or, in another example, the upper mold 6101 is fixed, and the lower mold 6102 can be moved relative to the upper mold 6101 along the guiding rod to be clamped toward the upper mold 6101, thereby forming the molding cavity 6103 between the lower mold 6102 and the upper mold 6101, and that the molding-die 6100 can be demolded while the lower mold 6102 moving away from the upper mold 6101.

The photosensitive element 621 and the circuit board 622 are electrically connected by a set of the lead wires 624 and the supporting body 6251 is formed in the non-photosensitive area 6213 of the photosensitive element 621 at to cover at least a part of each of the lead wires 624 to forming the molded photosensitive assembly semi-finished product. Place the molded photosensitive assembly semi-finished product on the lower mold 6102 of the molding-die 6100, and operate the upper mold 6101 of the molding-die 100and/or the lower mold 6102 to clamp the upper mold 6101 and/or the lower mold 6102 to form the molding cavity 6103 therebetween, wherein the photosensitive element 621, the circuit board 622 and the supporting member 625 are respectively partially in contact with the molding cavity 6103 of the molding-die 6100, wherein the pressing surface 61011 of the upper mold 6101 is in contact with the top surface 62501 of the supporting body 6251. The upper mold 6101 is supported upwardly by the supporting body 6251 to prevent the pressing surface 61011 of the upper mold 6101 from being pressed against the lead wires 624. For example, in this specific example of the present disclosure as illustrated in Fig. 7, the outside of the circuit board 622, the non-photosensitive area of the photosensitive element 621, and a part of the supporting member 625 are positioned in the molding cavity 6103 of the molding-die 6100 such that when the molded base 623 is molded in the molding cavity 6103, the molded base 623 covers the outside of the circuit board 622, the non-photosensitive area of the photosensitive element 621, and a portion of the supporting member 625.

Therefore, it will be understood by one skilled in the art that the molding cavity 6103 of the molding-die 6100 may be an annular space to form a ring shape after the molding material is filled and cured in the molding cavity 6103.

It is worth mentioning that the supporting body 6251 has a predetermined elasticity so that when the molding-die 6100 is closed and clamped for molding, the instantaneous impact force generated by the pressing surface 61011 of the upper mold 6101 of the molding-die 6100 against the top surface 62501 of the supporting body 6251 is absorbed by the supporting body 6251 to prevent the impact force from being further transmitted to the photosensitive element 621, thereby preventing the photosensitive element 621 from being damaged or avoiding the photosensitive element 621 being displaced relative to the circuit board 622 due to the impact force. One skilled in the art will understand that the supporting body 6251 absorbs the impact force to prevent the impact force from being further transmitted to the photosensitive element 621, and also ensures that the flatness of the photosensitive element 621 mounted on the circuit board 622 is not affected, thereby ensuring the image quality of the image capturing module.

It is worth to mention that the supporting body 6251 has a Shore hardness ranging from A50 to A80 and an elastic modulus ranging from 0.1 GPa to 1 GPa.

Preferably, in the example of the present disclosure as shown in Fig. 7, the height of the supporting body 6251 may be implemented to be higher than or equal to the height of each of the lead wires 624 protruded upwardly. In the mold clamping operation of the molding-die 6100, when the pressing surface 61011 of the upper mold 6101 of the molding-die 6100 is in contact with the top surface 62501 of the supporting body 6251, the supporting body 6251 can support the upper mold101 upwardly which prevents the upper mold 6101 from being pressed against the lead wires 624. For example, in one example, the height of the supporting body 6251 is equal to the height of each of the lead wires 624 protruded upwardly, so that when the upper mold 6101 and the lower mold 6102 of the molding-die 6100 are closed and clamped, the supporting body 6251 supports the upper mold 6101 upwardly so that the pressing surface 61011 of the upper mold 6101 can contact the lead wires 624, but the pressing surface 61011 of the upper mold 6101 does not press on the wire 624. In another example, the height of the supporting body 6251 is higher than the height of each of the lead wires 624 protruded upwardly, so that when the upper mold 6101 and the lower mold 6102 of the molding-die 6100 are closing and clamping, the supporting body 6251 supports the upper mold 6101 in an upward direction, so that the pressing surface 61011 of the upper mold 6101 will not contact with the lead wires 624, thereby avoiding the pressing surface 61011 of the upper mold 6101 being pressed on the lead wires 624. That is, the supporting body 6251 can support the upper mold 6101 in an upward direction to maintain a safe distance between the pressing surface 61011 of the upper mold 6101 and the lead wires 624.

In addition, the supporting body 6251 has a predetermined elasticity, and after the upper mold 6101 and the lower mold 6102 of the molding-die 6100 are closed and clamped during molding, the pressing surface 61011 of the upper mold 6101 is in contact with the top surface 62501 of the supporting body 6251, wherein the pressure of the pressing surface 61011 of the upper mold 6101 applied to the top surface 62501 of the supporting body 6251 can cause slight deformation of the supporting body 6251 for preventing a gap from being formed between the pressing surface 61011 of the upper mold 6101 and the top surface 62501 of the supporting body 6251. That is, the upper mold 6101 of the molding module 6100 can be closely matched with the supporting body 6251 such that the photosensitive area of the photosensitive element 621 corresponding to the through hole 6252 of the supporting member 625 is remained in a sealed environment to prevent the molding material entering the sealed environment to contaminate the photosensitive area of the photosensitive element 621 during the molding process.

Fig. 3B shows an alternative mode of the embodiment of the molded photosensitive assembly 260 of the present disclosure, wherein the supporting member 625 can be made of a hard material. That is, when the supporting body 6251 of the supporting member 625 is formed on at least a part of the non-photosensitive area 6213 of the photosensitive element 621, and the pressing surface 61011 of the upper mold 6101 of the molding-die 6100 is pressed against the top surface 62501 of the supporting body 6251 without deformation to ensure good electrical properties of the lead wires 624, thereby ensuring the yield of the image capturing module in the subsequent process and further ensuring the imaging quality of the image capturing module.

It is worth to mention that the supporting body 6251 has a Shore hardness greater than D70 and a modulus of elasticity greater than 1 Fpa.

The molding-die 6100 further comprises a covering film 6106 adapted to be positioned between the pressing surface 61011 of the upper mold 6101 and the top surfaces 62501 of the supporting body 6251 during the closing and clamping of the upper mold 6101 and the lower mold 6102. Preferably, the covering film 6106 may be placed on the pressing surface 61011 of the upper mold 6101 before the upper mold 6101 and the lower mold 6102 are closed and clamped. The covering film 6106 is disposed between the pressing surface 61011 of the upper mold 6101 and the supporting body 6251 and, on the one hand, a gap can be prevented being formed between the pressing surface 61011 of the upper mold 6101 and the supporting body 6251, such that the covering film 6106 can absorb the impact force generated by the upper mold 6101 and the clamped lower mold 6102, thereby avoiding the photosensitive element 621, the circuit board 622, and the lead wires 624 being damaged when the upper mold 6101 and the lower mold 6102 is closed and clamped.

According to Fig. 4, after the molten molding material is added into the molding cavity 6103 of the molding-die 6100, the molding material fills the entire molding cavity 6103 where the photosensitive element 621 is disposed. The supporting body 6251 formed on the non-photosensitive area 6213 of the photosensitive element 621 can prevent the molding material from entering from a connection position of the supporting body 6251 and the non-photosensitive area 6213 of the photosensitive element 621 into the photosensitive area 212of the photosensitive element 621. In addition, the supporting body 6251 can prevent any gap formed between the pressing surface 61011 of the upper mold 6101 and the top surface 62501 of the supporting body 6251 due to deformation, thereby preventing the molding material entering into the sealing environment from a connection position of the top surface 62501 of the supporting body 6251 and the pressing surface 61011 of the upper mold 6101, that can avoid occurrence of "flashing" after the molding material is solidified.

It is worth to mention that the molding material in fluid form according to the present disclosure may be a liquid material or a solid particulate material or a mixed material of liquid and solid particles. It can be understood that whether the molding material is implemented as a liquid material or implemented as a solid particulate material or as a liquid and solid particulate mixed material, after being added into the molding cavity 6103 of the molding-die 6100, the molding material can be solidified and cured to form the molded base 623. For example, in this specific example of the disclosure, the flowing molding material is embodied as a liquid thermosetting material, wherein the molding material is solidified and cured after being filled in the molding cavity 6103 of the molding-die 6100 to form the molded base 623. It is worth mentioning that, when the molding material is added into the molding cavity 6103 of the molding-die 6100, the manner of how the flowing molding material is solidified and cured is not limited in the present disclosure.

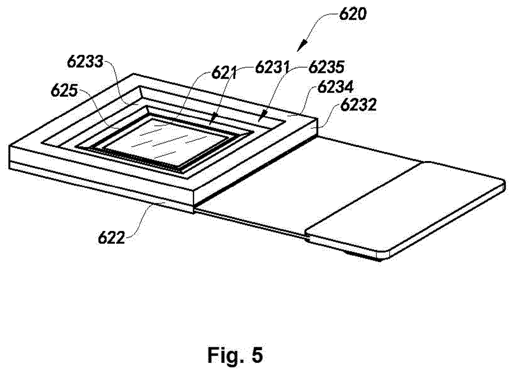

According to Fig. 5, the supporting body 6251 is disposed on the non-photosensitive area 6213 of the photosensitive element 621, wherein after the molding material is added into the molding cavity 6103 of the molding-die 6100, the supporting body 6251 can prevent the molding material from entering the photosensitive area 6212 of the photosensitive element 621, so that after the molding material is solidified and cured to form the molded base 623, a light window 6231 of the molded base 623 is formed with respect to the photosensitive area 6212 of the photosensitive element 621. Accordingly, the light window 6231 of the molded base 623 allows light to pass through and to be received by the photosensitive element 621, wherein the photosensitive area 6212 receives and performs photoelectric conversion. That is, the molding material filled in the molding cavity 6103 of the molding-die 6100 forms a molded body 6232 of the molded base 623 and the light window 6231 is formed in a middle portion of the molded base 623 after curing. In other words, the molded base 623 comprises the molded body 6232 and has the light window 6231, which provides a light path between the optical lens 610 and the photosensitive element 621. After the light reflected by an object enters the interior of the image capturing module from the optical lens 610, itis photoelectrically converted through the light window 6231 of the molded base 23and is received by the photosensitive area 6212 of the photosensitive element 621.

It is worth mentioning that, after the molded base 623 is formed, the molded base 623 covers each of the electronic components 626, thereby isolating each of the electronic components 26by the molded base 623. The electronic components 626 and the photosensitive element 621 are isolated by the molded base 623 in such a manner that, even the adjacent electronic components 626 are relatively close with each other, the molded base 623 can also prevent the adjacent electronic components 626 from contacting with each other and the contaminants generated by the electronic components 626 from contaminating the photosensitive area of the photosensitive element 621 to improve the imaging quality of the image capturing module.

According to Fig. 6, the filter member 640 is mounted on the top surface of the molded base 623, such that the light window 6231 of the molded base 623 is sealed by the filter member 640.Therefore, the light from the optical lens entering the inside of the image capturing module can be further filtered by the filter member 640 to improve the imaging quality of the image capturing module.

Furthermore, the top surface of the molded base 623 forms an inner surface 6233 and an outer surface 6234, wherein in one example, the inner surface 6233 and the outer surface 6234 of the molded base 623 are on the same level. The top surface of the molded base 623 is formed into a whole flat plane, wherein the filter member 640 is mounted on the inner surface 6233 of the molded base 623, wherein the driver 630 or the lens holder is mounted on the outer surface 6234 of the molded base 623, or the optical lens 610 is directly mounted on the outer surface 6234 of the molded base 623. In another example, the inner surface 6233 of the molded base 623 may be positioned lower than the plane in which the outer surface 6234 is positioned, thereby the top surface of the molded base 623 forms stepped shape. A surface in which the inner surface 6233 of the molded base 623 is positioned lower than a plane in which the outer surface 6234 is positioned forms a recess 235 of the molded base 623, wherein the filter member 40mounted on the inner surface 6233 of the molded base 623 is received in the recess 235 of the molded base 623 and the driver 630 is mounted on the outer surface 6234 of the molded base 623, such that the optical lens 610 mounted on the driver 630 is further held in the photosensitive path of the photosensitive element 621, as shown in Fig. 7, thereby the image capturing module is manufactured.

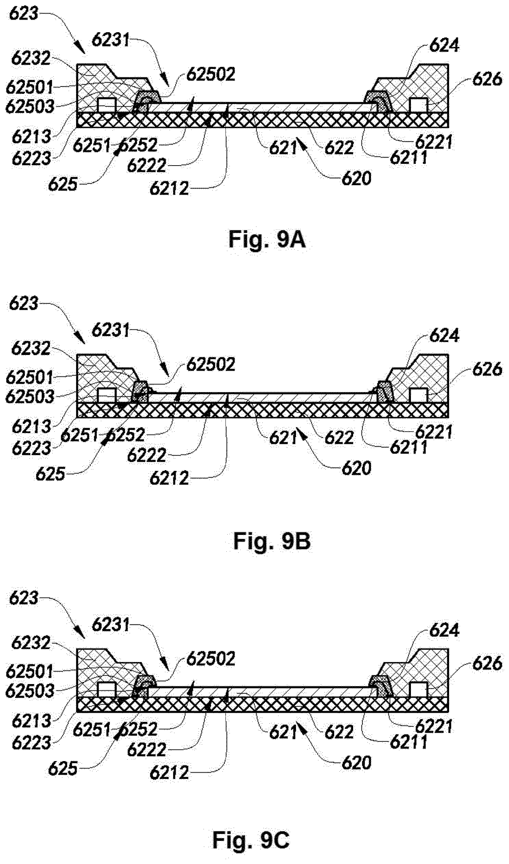

According to Fig. 9A, a first alternative mode of the above embodiment of the image capturing module of the present disclosure is illustrated, which is different from the above-described embodiment of the image capturing module of the present disclosure that each of the lead wires 624 of the plastic photosensitive element 620 is entirely covered inside the supporting body 6251 of the image capturing module of the present disclosure.

Specifically, the supporting body 6251 covers at least a part of the chip-inner portion 62131, the chip-connecting portion 62132, the chip-outer portion 62133, the circuit-inner portion 62231, the circuit-connecting portion 62232,and at least a part of the circuit-outer portion 62233, wherein the supporting body 6251 not only covers an extended portion of the lead wires 624 but also covers the connection positions of the lead wires 624 and the photosensitive element 621 and the chip connector 6211 as well as the connection positions of the circuit connector 221 of the circuit board 622 and the lead wires 624, so as to pre-fix the lead wires 624 by the supporting body 6251. Thus, in the subsequent molding process to form the molded base 623, while he upper mold 6101 and the lower mold 6102 of the molding-die 6100 are closed and clamped, the pressing surface 61011 of the upper mold 6101 is in contact with the top surface 62501 of the supporting body 6251 to prevent the pressing surface 61011 of the upper mold 6101 from directly pressing the lead wires 624, thereby preventing the lead wires 624 from being stressed to be deformed or damaged.

In addition, the lead wires 624 are entirely covered inside the supporting body 6251, so that the supporting body 6251 can prevent the molding material from being direct contact with the lead wires 624 when the molding material is added into the molding cavity 6103 formed between the upper mold 6101 and the lower mold 6102 to prevent the molding material with high temperature and rapid flowing to damage the lead wires 624. Preferably, the supporting body 6251 has good heat insulation to prevent the temperature of the molding material from transferring to the lead wires 624. More preferably, height of the supporting body 6251 is higher than height of the protruding portion of each of the lead wires 624, so that the supporting body 6251 supports the upper mold 6101 in an upward direction during the molding process. A safety distance is reserved between the pressing surface 61011 and the protruding portion of each of the lead wires 624.

And, the supporting body 6251 covers the chip-outer portion 62133 of the photosensitive element 621 and the circuit-inner portion 62231 of the circuit board 622 to cover the mounting position of the photosensitive element21 mounted on the circuit board 622 by the supporting body 6251, such that the supporting body 6251 can not only pre-fix the photosensitive element 621 and the circuit board 622, but also prevent the respective portions of the photosensitive element 621 and the circuit board 622 from being displaced due to uneven force during the molding process. In addition, the supporting body 6251 can also prevent the molding material from contacting the mounting position of the photosensitive element 621 to the circuit board 622 which ensures the flatness of the photosensitive element 21 to improve the image quality of the image capturing module.

One skilled in the art should understand that the supporting body 6251 is disposed along the mounting position of the photosensitive element 621 and the circuit board 622, so that the supporting body 6251 is in a square shape. Therefore, the supporting body 6251 is capable of preventing the molding material from entering the photosensitive area 6212 of the photosensitive element 621 during the molding process, thereby forming the molded body 6232 covering the edge region 6223 of the circuit board 622 and the outer surface 62503 of the supporting body 6251 and the light window 231 formed in the middle of the molded body 6232 by the molding material after curing. The photosensitive area 6212 of the photosensitive element 621 is positioned corresponding to the light window 6231 of the molded base 623 such that the light window 6231 provides a light path from the optical lens 610 to the photosensitive element 621. Preferably, the molded body 6232 covers the periphery area 6223 of the circuit board 622, the outer surface 62503 of the supporting body 6251, and at least a part of the top surface 62501 after molded.

In a second alternative mode of the embodiment of the image capturing module of the present disclosure as shown in Fig. 9B, the supporting body 6251 covers the chip-outer portion 62133 of the photosensitive element 621 and at least a part of the circuit-inner portion 62231, the circuit-connecting portion 62232, and the circuit-outer portion 62233 of the circuit board 622. That is, in the example of the image capturing module as shown in Fig. 9B, the supporting body 6251 may not cover the chip-connecting portion 62132 of the photosensitive element 621. In a third alternative mode of the embodiment of the image capturing module of the present disclosure as shown in Fig. 9C, the supporting body 6251 covers the chip-connecting portion 62132 and the chip-outer portion 62133 of the photosensitive element 621, and the circuit-inner portion 62231 and the circuit-connecting portion 62232 of the circuit board 622. That is, in this alternative mode of the embodiment of the image capturing module of the present disclosure as shown in Fig. 9C, the supporting body 6251 may not cover the chip-inner portion 62131 of the photosensitive element 621 and the circuit-outer portion 62233 of the circuit board 622. That is, in the alternative modes of the embodiments of the image capturing module as shown in Figs. 9A, 9B, and 9C, the supporting body 6251 can simultaneously cover the photosensitive element 621 and a mounting position of the circuit board 622 to pre-fix the photosensitive element 621 and the circuit board 622 by the supporting body 6251, and avoid the mounting position of the photosensitive element 621 and the circuit board 622 generating a slit by the supporting body 6251, so that the supporting body 6251 can prevent the respective portion of the photosensitive element 621 and the circuit board 622 from being displaced due to uneven force during the molding process, and the molding material from entering between the photosensitive element 621 and the circuit board 622 to ensure the flatness of the photosensitive element 621.

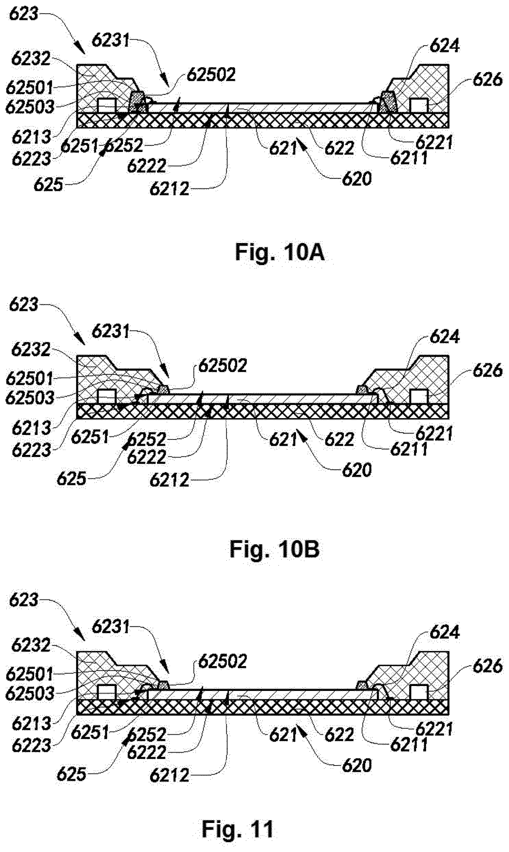

According to Fig. 10A, a fourth alternative mode of the embodiment of the image capturing module of the present disclosure is illustrated, wherein the supporting body 6251 covers the circuit-inner portion 62231 of the periphery area 6223 of the circuit board 622, at least a part of the circuit-connecting portion 62232 and at least a part of the circuit-outer portion 62233. That is, the supporting body 6251 covers the circuit connector 6221 of the circuit board 622 during molding. On the one hand, the lead wires 624 is pre-fixed by the supporting body 6251, and the lead wires 624 and the circuit connector 6221 are prevented from coming into contact with the molding material by means of the supporting body 6251, thereby the lead wires 624 are prevented from falling off from the circuit connector 221.

According to Fig. 10B, a fifth alternative mode of the embodiment of the image capturing module of the present disclosure is illustrated, wherein the supporting body 6251 covers only the chip-inner portion 62131 of the photosensitive element 621 to be molded. In the molding process, the supporting body 6251 blocks the molding material from entering the photosensitive area 6212 of the photosensitive element 621, thereby forming the molded body 232covering the periphery area 6223 of the circuit board 622 and chip-outer portion 62133 of the photosensitive element 621 and the chip-connecting portion 62132 after the molding material is solidified and cured. The light window 6231 is formed at a position with respect to the photosensitive area 6212 of the photosensitive element 621.

According to Fig. 11, a sixth alternative mode of the embodiment of the image capturing module of the present disclosure is illustrated, which is different from the above-described embodiment of the present disclosure in that the molded body 6232 is not covered with the top surface 62501 of the supporting body 251 after molded. For example, in this particular example as illustrated in Fig. 11, the molded body 6232 covers the periphery area 6223 of the circuit board 622 and the outer surface 62503 of the supporting body 6251 after molded.

It is to be mentioned that, although the embodiments in which the height of the supporting body 6251 is higher than the height of the protruding portion of each of the lead wires 624 are shown in Figs. 1 to 11, in other alternative modes of the present disclosure, the height of the supporting body 6251 may also be equal to the height of the protruding portion of each of the lead wires 624, or that the height of the supporting body 6251 may also be lower than each of the height of the protruding portion of the lead wires 624 as long as, during the molding process, the pressing surface 61011 of the upper mold 6101 of the molding-die 6100 is in contact with the top surface of the supporting body 6251 and the pressing surface of the mold 6101 is not directly pressed against each of the lead wires 624.

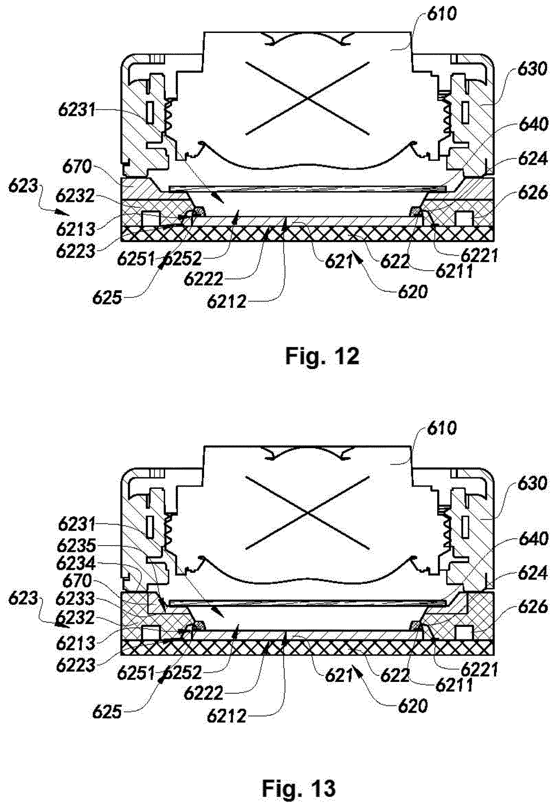

Fig. 12 shows an alternative mode of the above embodiment of the image capturing module, wherein the filter member 640 is not directly mounted on the module body 6232, but at least one holder 670 is provided by the image capturing module, wherein the filter member 640 is mounted on the holder 670 and the holder 670 is mounted on the top surface of the molded body 6232, such that the filter member 640 is held and positioned between the optical lens 610 and the photosensitive element 621. Accordingly, the size of the filter member 640 can be reduced and the height of the image capturing module is reduced correspondingly too.

Furthermore, the top surface of the molded body 6232 can be a flat surface, so that after the molded base 623 is molded, the holder 670 is firstly mounted on the top surface of the molded body 6232, and then the driver 630 or the lens barrel 60 is mounted on the holder 670. That is, the driver 630 or the lens barrel 60 may not be directly mounted on the top surface of the molded body 6232 but may be mounted on the holder 670.

Fig. 13 shows another alternative mode of the above embodiment of the image capturing module, wherein the top surface of the molded body 6232 has a recess 6235 and the holder 670 mounted on the top surface of the molded body 6232 is received in the recess 6235 to further reduce the height of the image capturing module. In this situation, the driver 630 or the lens barrel 660 can be directly mounted on the top surface of molded body 6232.

However, it will be understood by one skilled in the art that, in other alternative modes of the image capturing module of the present disclosure, the optical lens 610 may also be directly mounted on the top surface of the molded body 6232 or the optical lens 610 can also be directly mounted on the top surface of the holder 670. According to another aspect of the present disclosure, a manufacturing method of a molded photosensitive assembly 620 is provided, which comprises the steps of:
(a) electrically connecting photosensitive element 621 and a circuit board 22througha set of lead wires 624;
(b) placing the photosensitive element 621 and the circuit board 622 in an upper mold 6101 or a lower mold 6102 of a molding-die 6100;
(c) in the process of closing and clamping the upper mold 6101 and the lower mold 6102 of the molding-die 6100, supporting the upper mold 6101 in an upward direction by a supporting member 625 to prevent the pressing surface 61011 of the upper mold 6101 from being pressed against each set of the lead wires 624; and
(d) adding a fluid molding material into a molding cavity 6103 formed between the upper mold 6101 and the lower mold 6102 of the molding-die 6100 to form a molded base 623 after the molding material is cured, wherein the molded base 623 comprises a molded body 6232 and has a light window 6231, wherein at least a part of an periphery area 6223 of the circuit board 622 and at least a part of the supporting member 25is covered by the molded body 6232.

According to another aspect of the present disclosure, the present disclosure further provides a manufacturing method of a molded photosensitive assembly 620, wherein the manufacturing method comprises the steps of:
(A) electrically connecting a photosensitive element 621 and a circuit board 22by a set of lead wires 624;
(B) covering at least a partial of the lead wires 624 by a supporting member 625 to form a molded photosensitive assembly semi-finished product;
(C) placing the molded photosensitive assembly semi-finished product in an upper mold 6101 or a lower mold 6102 of a molding-die 6100, wherein the supporting member 625 is upwardly supporting the upper mold 6101 to prevent the pressing surface 61011 of the upper mold 6101 from being pressed against the wire 24duringthe closing and clamping process of the upper mold 6101 and the lower mold 102; and
(D) adding a fluid molding material into a molding cavity 6103 formed between the upper mold 6101 and the lower mold 6102 to form a molded base 623 after the molding material is solidified and cured, wherein the molded base 623 comprises a molded body 6232 and has a light window 6231,wherein the molded body 6232 covers an periphery area 6223 of the circuit board 622 and at least a part of the supporting member 625, wherein the photosensitive area 6212 of the photosensitive element of 621 faces the light window 6231.

According to another aspect of the present disclosure, the present disclosure further provides a manufacturing method of a molded photosensitive element 620, wherein the manufacturing method comprises the steps of:
(h) mounting a photosensitive element 621 on a circuit board 622;
(i) pre-fixing the photosensitive element 621 and the circuit board 622 by a supporting member 625 to obtain a molded photosensitive assembly semi-finished product, wherein the supporting member 625 prevents a gap formed between the photosensitive element 621 and the circuit board 622;
(j) placing the molded photosensitive assembly semi-finished product in an upper mold 6101 or a lower mold 6102 of a molding-die 6100 which forms an annular molding cavity 6103 between the upper mold 6101 and the lower mold 6102 when the upper mold 6101 and the lower mold 6102 are closed and clamped; and
(k) adding a fluid molding material to the molding cavity 6103 to form the molded base 623 after the molding material is solidified and cured, wherein the molded base 623 comprises a molded body 6232 and has a light window 6231,wherein at least a part of a periphery area 6223 of the circuit board 622 and at least a part of the supporting member 25are covered by the molded body 6232, wherein the photosensitive area212 of the photosensitive element 621 is positioned corresponding to the light window 6231.

According to another aspect of the present disclosure, the present disclosure further provides a manufacturing method of a molded photosensitive element 620, wherein the manufacturing method comprises the steps of:
(H) electrically connecting to a chip connector 6211 of a photosensitive element 621 and a circuit connector 6221 of a circuit board 622 through a set of lead wires 624;
(I) placing the photosensitive element 621 and the circuit board 622 on an upper mold 6101 or a lower mold 6102 of a molding-die 6100 which forms an annular molding cavity 6103 between the upper mold 6101 and the lower mold 6102 when the upper mold 6101 and the lower mold 6102 are closed and clamped;
(J) when a fluid molding material is added to the molding cavity 6103, reducing the impact force towards the lead wires 624 generated by the molding material with a supporting member 625 positioned in the molding cavity 6103 to block the molding material; and
(K) forming a molded base 623 after the molding material is solidified and cured, wherein the molded base 623 comprises a molded body 6232 and has a light window 6231, wherein a periphery area 6223 of the circuit board 622, the supporting member 625 and at least a part of the non-photosensitive area 6213 of the photosensitive element 621 are covered by said molded body 6232.

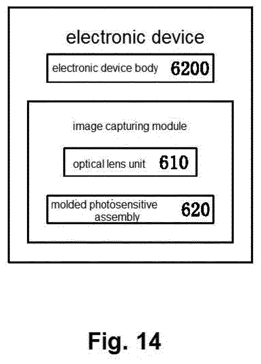

Referring to Fig. 14, the present disclosure further provides an electronic device, wherein the electronic device comprises an electronic device body 6200 and at least one image capturing module, wherein each of the image capturing modules is respectively disposed on the electronic device body 6200. For obtaining graphics, each of the image capturing modules further includes at least one optical lens 610 and at least one molded photosensitive assembly 620, the molded photosensitive assembly 620 includes a supporting member 625, a photosensitive element 621, a circuit board 622, a set of lead wires 624 and a molding base 623, wherein two ends of each of the lead wires 624 are respectively connected to the chip connector 6211 of the photosensitive element 621 and a circuit board connector 6221 of the circuit board 622, wherein the molding base 623 includes a molded body 6232 and has a light window 6231, wherein when the molding process is performed by a molding die 6100 to mold the molded body 6232, the supporting member 625 is used for preventing the pressing surface 61111 of the molding die 6100 from being pressed against the lead wire 624, wherein the photosensitive region 6212 of the photosensitive element 621 corresponds to the light window 6231, wherein each of the optical lens 610 are provided in the photosensitive path of the photosensitive element 621 of each of the molded photosensitive assembly 620.

Referring to Figs. 15A to 35 of the drawings of the present disclosure, the states of another manufacturing method of the image capturing module at various stages are shown.

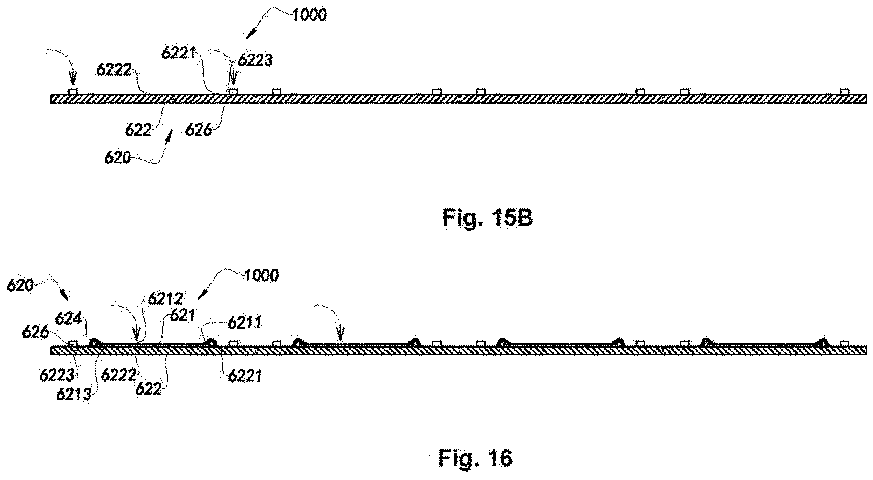

At a stage shown in Figs. 15A and 15B, a plurality of the circuit boards 622 are arranged together to form a splicing unit 1000, and at least one of the electronic components 626 is conductively connected to each of the circuit boards 622 forming the splicing unit 1000. For example, in a preferred example of the image capturing module of the present disclosure, each of the electronic components 626 can be conductively connected to the circuit board 622 by being clingingly mounted on the circuit board 622. It can be understood that in other examples of the image capturing module, it is also possible to semi-embed each of the electronic components 626 into the circuit board 622, or to completely embed the circuit board 622.

It should be noted that each of the electronic components 626 may be clingingly mounted on one side of the circuit board 622 or may be clingingly mounted on both sides of the circuit board 622, and the image capturing module of the present disclosure is not limited in this regard. It can be understood that each of the electronic components 626 protrudes from the circuit board 622 after it is clingingly mounted on the circuit board 622.

In addition, the arrangement of the circuit board 622 forming the splicing unit 1000 is not limited in the present disclosure. For example, the number of the circuit boards 622 in each column may be two or more, and the number of the circuit boards 622 in each row may be two or more. Preferably, when the circuit board 622 is implemented as a hard board, both the number of the circuit boards 622 in each row and the number of the circuit boards 622 in each column forming the splicing unit 1000 may be more than two.

At a stage shown in Fig. 16, the photosensitive element 621 is clingingly mounted on the chip mounting region 6222 of the circuit board 622, and each of the lead wires 624 is formed between the chip connector 6211 of the photosensitive member 621 and the circuit board connector 6221 of the circuit board 622 by a wire bonding process, so as to conductively connect the photosensitive element 621 and the circuit board 622 by each of the lead wires 624. It is to be noted that the wire bonding direction of the lead wire 624 is not limited in the image capturing module of the present disclosure. For example, the wire bonding direction of the lead wire 624 may be from the photosensitive element 621 to the circuit board 622, or alternatively may be from the circuit board 622 to the photosensitive element 621. Preferably, the wire bonding direction of the lead wire 624 is from the circuit board 622 to the photosensitive element 621, that is, one end of the lead wire 624 is conductively connected to the circuit board connector 621 of the circuit board 622, and then another end of the lead wire 624 is conductively connected to the chip connector 6211 of the photosensitive element 621. In this way, the height size of the highest end of the lead wire 624 can be reduced.

It is to be noted that the type of the lead wire 624 is not limited in the image capturing module of the present disclosure. For example, the lead wire 424 may be a gold wire, a silver wire, a copper wire or a wire of any material that can conductively connect the photosensitive element 621 and the circuit board 622.

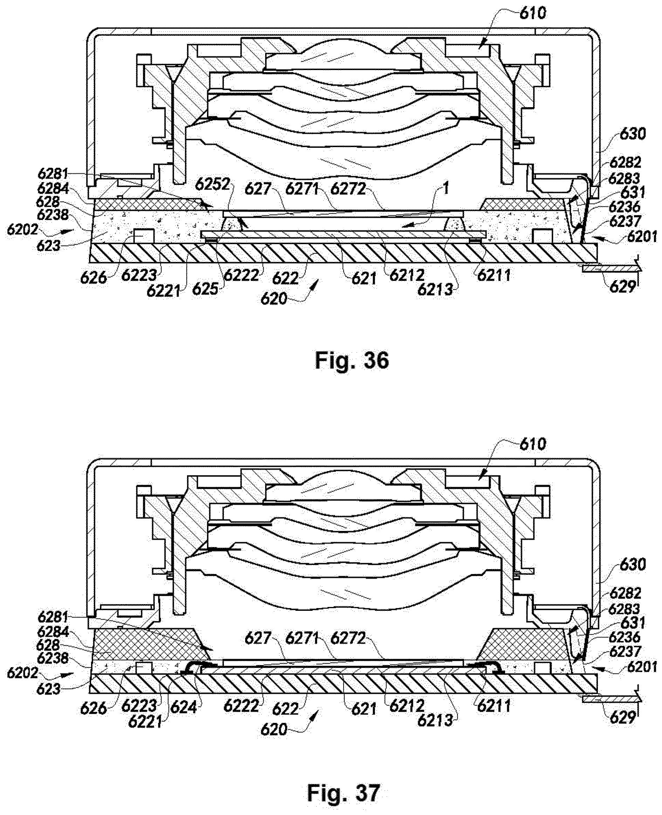

However, it can be understood by those skilled in the art that in a modified embodiment of the image capturing module of the present disclosure shown in Fig. 36, the chip connector 6211 of the photosensitive element 621 can also be directly conductive to the circuit board connector 6221 of the circuit board 622. Specifically, the circuit board connector 6221 of the circuit board 622 may is convexly disposed on the chip mounting region 6222 of the circuit board 622, the chip connector 6211 of the photosensitive element 621 is convexly disposed on the back surface of the photosensitive element 620, accordingly, when the photosensitive element 621 is clingingly mounted on the chip mounting region 6222 of the circuit board 622, the chip connector 6211 of the photosensitive element 621 can be directly conductive to the chip connector 6211 of the circuit board 622.

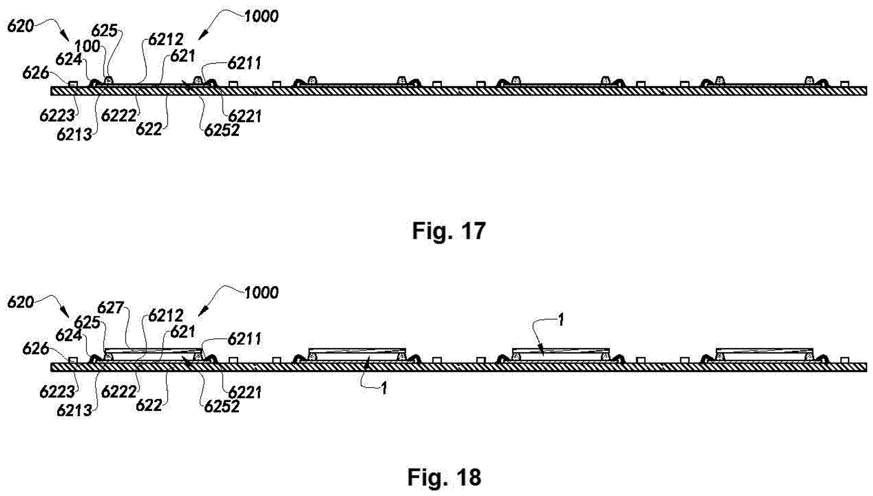

At a stage shown in Fig. 17, a first medium 6100 is applied to at least a part of the non-photosensitive region 6213 of the photosensitive element 621 to make the first medium 6100 form the supporting element 625 held in at least a part of the non-photosensitive region 6213 of the photosensitive element 621 after being cured, wherein the supporting element 625 is frame-shaped to form the through hole 6252 in a middle portion of the supporting element 625, and the photosensitive region 6212 of the photosensitive element 621 corresponds to the through hole 6252 of the supporting element 625. That is, the supporting element 625 surrounds the photosensitive region 6212 of the photosensitive element 621. It is to be understood that a part of the non-photosensitive region 6213 of the photosensitive element 621 may also correspond to the through hole 6252 of the supporting element 625. For example, the first medium 6100 may be a resin, glue or the like, and after it is applied to the non-photosensitive region 6213 of the photosensitive element 621, it can form the supporting element 625 after being cured. The supporting element 625 is resilient so as to provide a buffering effect in a subsequent molding process.

In other possible examples, the supporting element 625 may also, after being fabricated, be disposed on at least a part of the non-photosensitive region 6213 of the photosensitive element 621 in an overlapping manner, so that the supporting element 625 is held in the non-photosensitive region 6213 of the photosensitive element 621, and the support member 625 surrounds around the photosensitive region 6212 of the photosensitive element 621, thereby causing the photosensitive region 6212 of the photosensitive element 621 to correspond to the through hole 6252 of the supporting element 625.

At a stage shown in Fig. 18, a light-transmitting protective element 627 is disposed on the photosensitive element 621 in an overlapping manner, and the supporting element 625 is held between the non-photosensitive region 6213 of the photosensitive element 621 and the protective elements 627. That is, the protective element 627 can completely cover the photosensitive region 6212 of the photosensitive element 621. Preferably, the protective element 627 can further cover at least a part of the non-photosensitive region 6213 of the photosensitive element 621 so as to prevent the photosensitive region 6212 of the photosensitive element 621 from being contaminated in the subsequent molding process.

It is to be noted that the type of the protective element 627 is not limited in the image capturing module of the present disclosure. For example, the protective element 627 can be implemented as, but not limited to, glass, resin, or the like.

It will be understood by those skilled in the art that the supporting element 625 can not only form a buffer portion held between the photosensitive element 621 and the protective element 627, but can also prevent a gap from being formed between the photosensitive element 621 and the protective element 627, so that the photosensitive region 6212 of the photosensitive element 621 is avoided from being contaminated in the subsequent molding process.

It is to be noted that in other examples of the image capturing module of the present disclosure, there may be no stage shown in Fig. 17, that is, the protective element 627 may also be directly disposed on the photosensitive element 620 in an overlapping manner, so that the protective element 627 covers the entirety of the photosensitive region 6212 of the photosensitive element 621, as shown in Fig. 37.

It can be understood that, after the protective element 627 is disposed on the photosensitive element 621 in an overlapping manner, a sealed space 1 is formed among the protective element 627, the photosensitive element 621 and the supporting element 625, wherein the photosensitive region 6212 of the photosensitive element 621 is held in the sealed space 1 so as to prevent the photosensitive region 6212 of the photosensitive element 621 from being contaminated in subsequent processes.

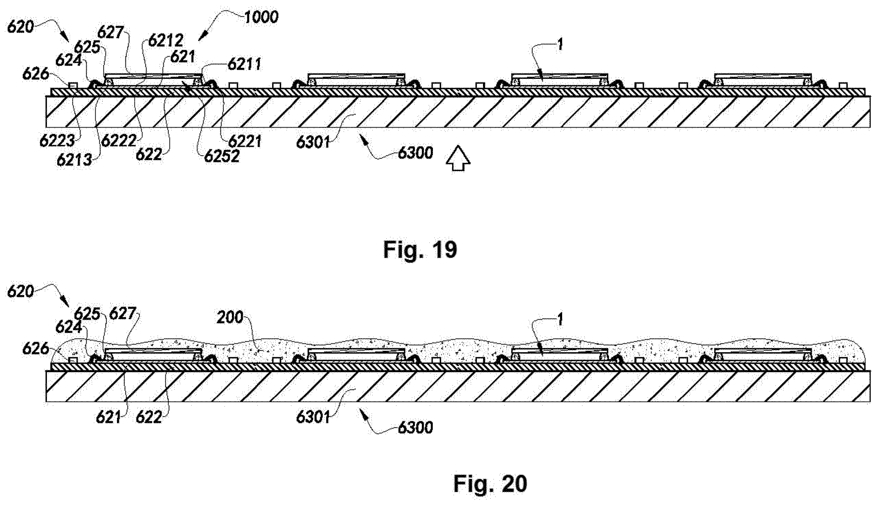

At the stages shown in Figs. 19 to 22, the splicing unit 1000 on which the photosensitive element 621 is clingingly mounted is placed in a molding die 6300 for a molding process.

Specifically, the splicing unit 1000 is first placed in a first die 6301 of the molding die 6300, and then a second medium 200 is overlaid on the splicing unit 1000 so as to make the second medium 200 cover the circuit board 622 and the lead wire 626. It can be understood that the photosensitive element 621 is also covered with the second medium 200. In this exemplary illustration, the second medium 200 may also cover at least a part of an upper surface of the protective element 627, such as at a stage shown in Fig. 620, and the second medium 200 may cover the entirety of the upper surface of the protective element 627. Nevertheless, it will be understood by those skilled in the art that the entirety of the upper surface of the protective element 627 is covered with the second medium 200 shown in Fig. 620 and subsequent figures only as an example, and it should not be considered as limiting the substance and scope of the image capturing module of the present disclosure.

It is to be noted that the type of the second medium 200 is not limited in the image capturing module of the present disclosure. For example, the second medium 200 may be, but not limited to, solid particles, liquid or a mixture of solid particles and liquid, and the like. Preferably, the second medium 200 is in a form of fluid.

Then, at a stage shown in Fig. 621, a second die 6302 of the molding die 6300 is overlaid on the second medium 200 so that the splicing unit 1000 and the second medium 200 are held between the first die 6301 and the second medium 6302, and the splicing unit 1000 and the second medium 200 are held within a molded space 6303 formed between the first die 6301 and the second die 6302.

Nevertheless, it will be understood by those skilled in the art that the stage shown in Fig. 621 can also precede the stage shown in Fig. 620, so that the second die 6302 and the first die 6301 are first clamped to form the molding space 6303 between the first die 6301 and the second die 6302, and hold the splicing unit 1000 within the molding space 6303, and then the second medium 200 are added into the molding space 6303 so that the second medium 200 covers at least the circuit board 622 and the lead wire 626. At this stage shown in Fig. 621, the second medium 200 also covers the upper surface of the protective element 627.

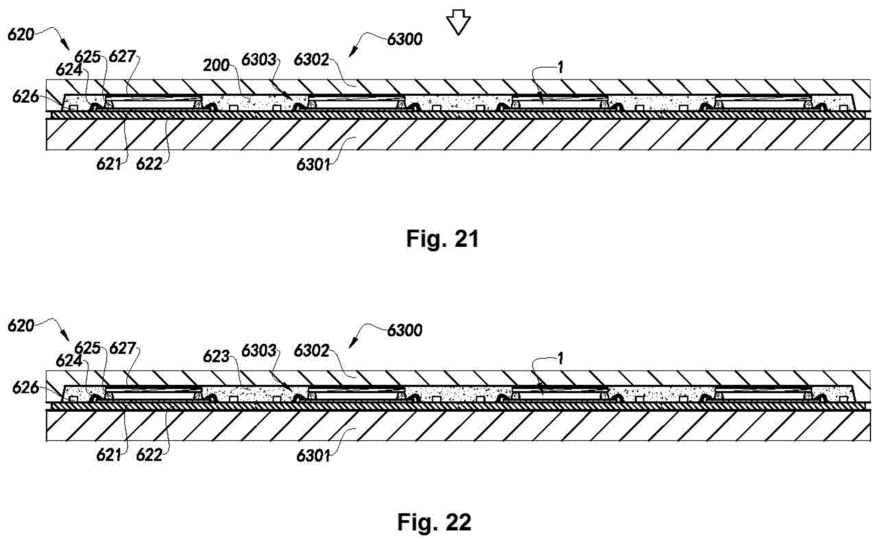

At a stage shown in Fig. 22, at least one of the first die 6301 and the second die 6302 of the molding die 6300 is heated to make the second medium 200 containing solid particles held within the molding space 6303 melted. In one example, after the second medium 200 is melted, the temperature of at least one of the first die 6301 and the second die 6302 of the molding die 6300 is continued to be raised, to cause the melted second medium 200 to be cured and form the molded base 623. In another example, after the second medium 200 is melted, the temperature of the first die 6301 and the second die 6302 of the molding die 6300 is reduced to cause the melted second medium 200 to be cured and form the molded base 623. Of course, those skilled in the art can understand that the melted second medium 200 can also be cured by ultraviolet light irradiation or the like, and the disclosure is not limited in this regard.

In addition, when the second medium 200 is implemented as a liquid, the second medium 200 can be cured to form the molded base 623 directly by heating at least one of the first die 6301 and the second die 6302 of the molding die 6300, or the second medium 200 is cured to form the molded base 623 by reducing the temperature of the first die 6301 and the second die 6302 of the molding die 6300.

It is to be noted that when the first die 6301 and the second die 6302 of the molding die 6300 are operated to be clamped, the supporting element 625 held between the protective element 627 and the photosensitive element 621 can absorb the impact force generated by the first die 6301 and the second die 6302 during die clamping, so as to protect the protective element 627 and the photosensitive element 621. Also, the supporting element 625 can prevent the second medium 200 from entering the photosensitive region 6212 of the photosensitive element 621 from the protective element 627 and the photosensitive element 621 by preventing a gap from being formed between the protective element 627 and the photosensitive element 621, thereby protecting the photosensitive region 6212 of the photosensitive element 621 so as to avoid the photosensitive region 6212 of the photosensitive element 621 from being contaminated.

It can be understood by those skilled in the art that in the image capturing module of the present disclosure, the second medium 200 can be molded and formed in the molding space 6303 by, but not limited to, compression molding.

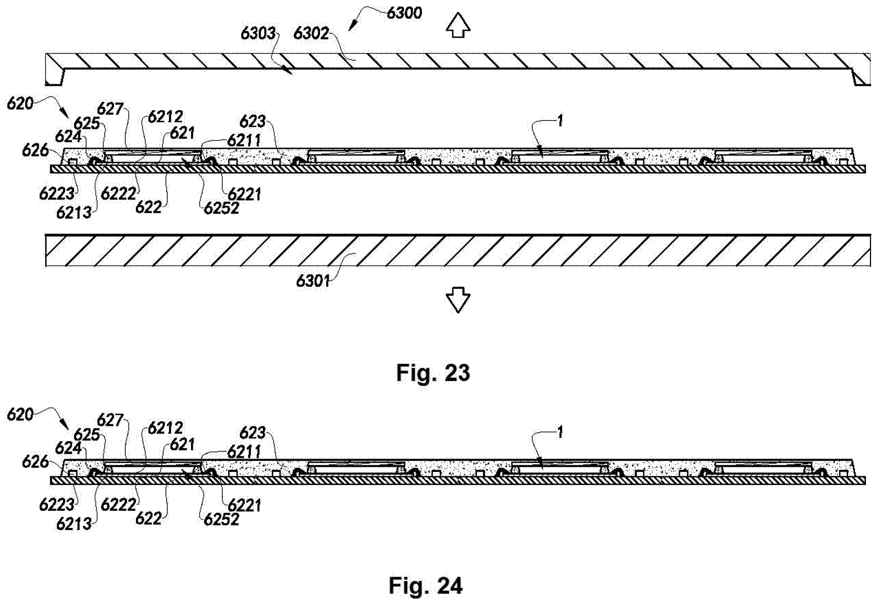

At the stages shown in Figs. 23 and 24, after the second medium 200 is cured within the molding space 6303 to form the molded base 623 integrally bonded to the circuit board 622, the lead wire 624, the photosensitive element 621 and the protective element 627, a drafting operation is performed on the molding die 6300 so as to form a semi-finished product of molded photosensitive assembly 620.

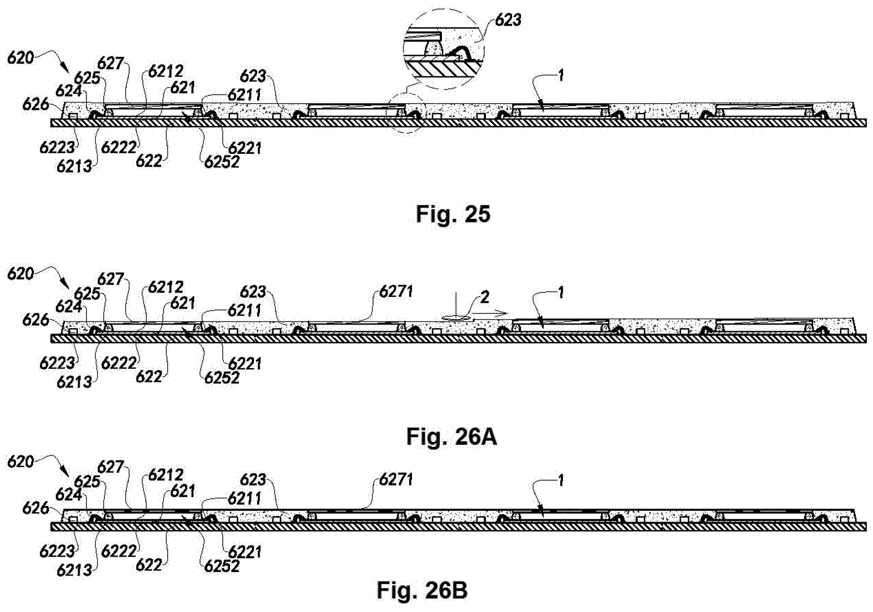

At a stage shown in Fig. 25, a baking process is performed on the semi-finished product of molded photosensitive assembly 620 to further cure the molded base 623.

At a stage shown in Figs. 26A and 26B, at least a part of the top portion of the semi-finished product of molded photosensitive assembly 620 is removed so that a part of the protective element 627 corresponding to the photosensitive region 6212 of the photosensitive element 621 is exposed, thereby subsequently allowing light to be received by the photosensitive region 6212 of the photosensitive element 621 after passing through the protective element 627.

Preferably, at least a part of the upper portion of the semi-finished product of molded photosensitive assembly 620 is removed by a grinding process so as to expose a part of the protective element 627 corresponding to the photosensitive region 6212 of the photosensitive element 621. It will be understood by those skilled in the art that the manner in which at least a part of the top portion of the semi-finished product of molded photosensitive assembly 620 is removed by a grinding process can ensure the flatness of the top portion of the semi-finished product of molded photosensitive assembly 620, especially ensuring the flatness of the exposed face 6271 of the protective element 627, so that when light is incident from the exposed face 6271 of the protective element 627, light does not occur refraction and other undesirable phenomena so as to ensure the product yield of the image capturing module.

Specifically, in the example shown in Fig. 26A, the label of the molded photosensitive assembly 620 may be ground by a grinding apparatus 2 so as to remove at least a part of the upper portion of the semi-finished product of molded photosensitive assembly 620, thereby obtaining a semi-finished product of molded photosensitive assembly 620 shown in Fig. 26B.

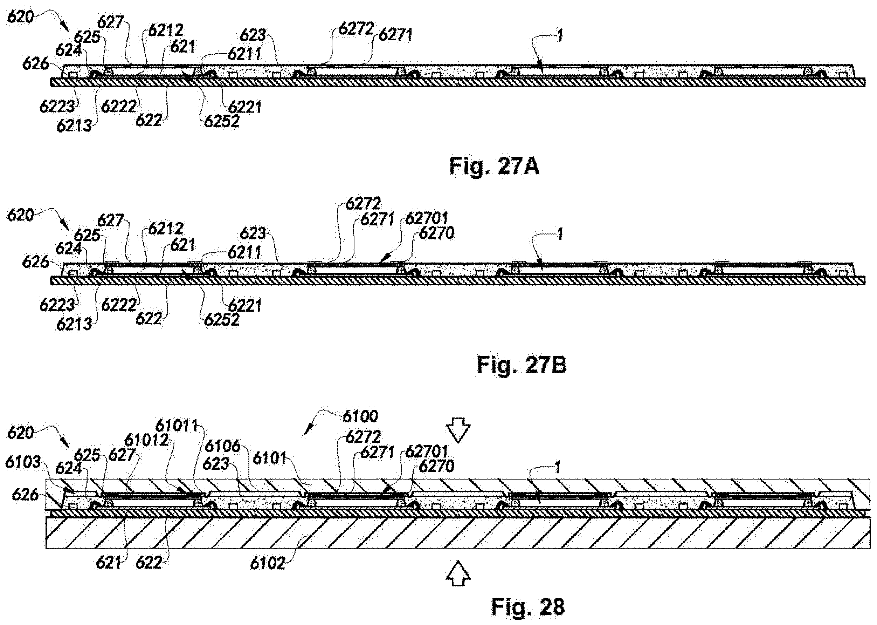

At a stage shown in Fig. 27A, a filtering material is applied to the exposed surface 6271 of the protective element 627 so that the filtering material forms a filter layer 6272 in the exposed surface 6271 of the protective element 627, wherein the filter layer 6272 can be used to filter the type of characteristic ray in the light incident from the protective element 627. For example, in a specific example of the image capturing module of the present disclosure, the filtering material may be an infrared-filtering material, so that the infrared-filtering material applied to the exposed surface 6271 of the protective element 627 forms the filter layer 6272 to subsequently absorb infrared light in the light incident from the protective element 627. Of course, those skilled in the art can understand that in other examples of the image capturing module of the present disclosure, the filtering material may also be other material types, which need to be chosen according to the specific use of the image capturing module.

It should be noted that the manner in which the filter layer 6272 filters a specific type of light in the light incident from the protective element 627 is not limited. For example, in one embodiment, the filter layer 6272 filters the specific type of light in the light incident from the protective element 627 by a reflection enhancement manner, that is, the filter layer 6272 can prevent this portion of light from passing through the protective element 627 by reflecting the specific type of light in the light incident from the protective element 627. In another embodiment, the filter layer 6272 can filter a specific type of light in the light incident from the protective element 627 by an anti-reflection manner. For example, for the desired light, the filter layer 6272 can allow it to easily transmit through the filter layer 6272 and then pass through the protective element 627. In another embodiment, the filter layer 6272 can also filter a specific type of light in the light incident from the protective element 627 in an absorption manner, that is, the filter layer 6272 can filter a specific type of light in the light incident from the protective element 627 by a manner of absorbing the specific type of light in the light incident from the protective element 627.

It should also be noted that the number of layers of the filter layer 6272 is not limited. For example, in one embodiment, the number of layers of the filter layer 6272 may be only one layer. In another embodiment, the number of layers of the filter layer 6272 may be two layers or more than two layers. In addition, when the number of layers of the filter layer 6272 is two layers or more than two layers, the material forming each layer of the filter layers 6272 may be the same, or may be different.

Preferably, the filtering material is a compound which may be a solvent-soluble pigment compound. More preferably, the filtering material is at least one selected from the group consisting of a phthalocyanine-based compound, a squarylium-based compound, a naphthalocyanine-based compound, a hexavalent porphyrin-based compound, a croconium-based compound, and a cyanine-based compound. Additionally, a plurality of layers of the filtering material may be applied to the protective element 627, respectively, to form a multilayered filter layer 6272. For example, in one example of the image capturing module of the present disclosure, at least one or more of the group consisting of a phthalocyanine-based compound, a squarylium-based compound, a naphthalocyanine-based compound, a hexavalent porphyrin-based compound, a croconium-based compound, and a cyanine-based compound are applied to the protective element 627, to form the filter layer 6272 carried by the protective element 627.

Further, for the filtering material, Formula I and Formula II represent the squarylium-based compound. 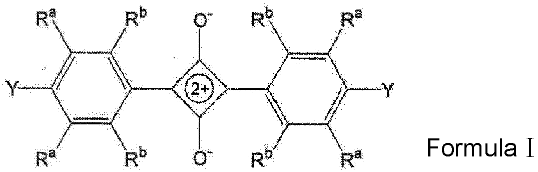 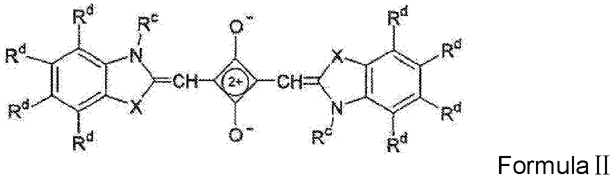 wherein, in the formula I, R^{a}, R^{b} and Y satisfy the following condition (a) or (b)

### Condition (a)

There are a plurality of R^{a} each independently representing a hydrogen atom, a halogen atom, a sulfo group, a hydroxyl group, a cyano group, a nitro group, a carboxyl group, a pity acid group, a -L¹ or a -NR^{e}R^{f} group. R^{e} and R^{f} each independently represent a hydrogen atom, -L^{a}, -L^{b}, -L^{c}, -L^{d} or -L^{e}.

There are a plurality of R^{b} each independently representing a hydrogen atom, a halogen atom, a sulfo group, a hydroxyl group, a cyano group, a nitro group, a carboxyl group, a pity acid group, a -L¹ or a -NR^{g}R^{h} group. R⁹ and R^{h} each independently represent a hydrogen atom, -L^{a}, -L^{b}, -L^{c}, -L^{d} or -L^{e} or a -C(O)Rⁱ group (Rⁱ represents -L^{a}, -L^{b}, -L^{c}, -L^{d} or -L^{e}).

There are a plurality of Y each independently representing a -NR^{j}R^{k} group. R^{j} and R^{k} each independently represent a hydrogen atom, -L^{a}, -L^{b}, -L^{c}, -L^{d} or -L^{e}.

L¹ is L^{a}, L^{b}, L^{c}, L^{d}, L^{e}, L^{f}, L^{g} or L^{h}.

L^{a} to L^{h} represent the following groups:
L^{a} may have an aliphatic hydrocarbon group having a substituent L of 1 to 12 carbon atoms
L^{b} may have a halogen-substituted alkyl group having a substituent L of 1 to 12 carbon atoms
L^{c} may have an alicyclic hydrocarbon group having a substituent L of 3 to 14 carbon atoms
L^{d} may have an aromatic hydrocarbon group having a substituent L of 6 to 14 carbon atoms
L^{e} may have a heterocyclic group having a substituent L of 3 to 14 carbon atoms L^{f} may have an alkoxy group having a substituent L of 1 to 9 carbon atoms
L^{g} may have an acyl group having a substituent L of 1 to 9 carbon atoms
L^{h} may have an alkoxycarbonyl group having a substituent L of 1 to 9 carbon atoms

The substituent L is at least one of a group consisting of an aliphatic hydrocarbon group having 1 to 12 carbon atoms, a halogen-substituted alkyl group having 1 to 12 carbon atoms, an alicyclic hydrocarbon group having 3 to 14 carbon atoms, an aromatic hydrocarbon group having 6 to 14 carbon atoms, a heterocyclic group having 3 to 14 carbon atoms, a halogen atom, a sulfo group, a hydroxyl group, a cyano group, a nitro group, a carboxyl group, a pity acid group, and an amino group.

In the above-mentioned L^{a} to L^{h}, the total number of carbon atoms including the substituent is preferably 50 or less, more preferably 640 or less, and particularly preferably 630 or less. When the carbon number is more than the above range, it may be difficult to synthesize a compound, and the absorption intensity of light per unit weight tends to be small.

### Condition (b)

At least one of the two R^{a} on one benzene ring is bonded to Y on the same benzene ring, to form a hetero ring having at least one nitrogen atom and having a constituent number of 5 or 6. The heterocyclic ring may have a substituent, and R^{b} and R^{a} not participating in the formation of the heterocyclic ring are independently synonymous with R^{b} and RR^{a} of Condition (a), respectively.

### Specific examples of each group

Examples of the aliphatic hydrocarbon group having 1 to 12 carbon atoms in the above-mentioned L^{a} and L include an alkyl group such as methyl (Me) , ethyl (Et), n-propyl (n-Pr), isopropyl (i-Pr), n-butyl (n-Bu), sec-butyl (s-Bu) , tert-butyl (t-Bu), pentyl, hexyl, octyl, nonyl, decyl and dodecyl; an alkenyl group such as vinyl, 1-propenyl, 2-propenyl, butenyl, 1,3-butadienyl, 2-methyl-1-propenyl, 2-pentenyl, hexenyl and octenyl; and an alkynyl group such as ethynyl, propynyl, butynyl group, 2-methyl-1-propynyl, hexynyl and octynyl.

Examples of the halogen-substituted alkyl group having 1 to 12 carbon atoms in the L^{b} and L include trichloromethyl, trifluoromethyl, 1,1-dichloroethyl, pentachloroethyl, pentafluoroethyl, heptachloropropyl and heptafluoropropyl.

Examples of the alicyclic hydrocarbon group having 3 to 14 carbon atoms in the L^{c} and L include a cycloalkyl group such as cyclobutyl, cyclopentyl, cyclohexyl, cycloheptyl and cyclooctyl; and a polycyclic alicyclic group such as norbornyl or adamantyl.

Examples of the aromatic hydrocarbon group having 6 to 14 carbon atoms in the L^{d} and L include phenyl, tolyl, xylyl, mesityl, cumenyl, 1-naphthyl, 2-naphthalene, anthranyl, phenanthryl, fluorenyl, phenalenyl, tetraamendyl, indanyl and biphenyl.

Examples of the heterocyclic group having 3 to 14 carbon atoms of L^{e} and L include a heterocyclic group containing furan, thiofuran, pyrrole, pyrazole, imidazole, triazole, oxazole, oxadiazole, thiazole, thiadiazole, indole, indoline, pseudoindole, benzofuran, benzothiophene, carbazole, dibenzofuran, dibenzothiophene, pyridine, pyrimidine, pyrazine, pyridazine, quinoline, isoquinoline, acridine, morpholine and phenazine.

Examples of the alkoxy group having 1 to 12 carbon atoms in the L^{f} include methoxy, ethoxy, n-propoxy, isopropoxy, butoxy, pentyloxy, hexyloxy and octyloxy.

Examples of the acyl group having 1 to 9 carbon atoms in the L^{g} include acetyl, propionyl, butyryl, isobutyryl, valeryl, isovaleryl and benzoyl.

Examples of the alkoxycarbonyl group having 1 to 9 carbon atoms in the L^{h} include methoxycarbonyl, ethoxycarbonyl, propoxycarbonyl, isopropoxycarbonyl, butoxycarbonyl, pentyloxycarbonyl, hexyloxycarbonyl and octyloxycarbonyl.

L^{a} is preferably methyl, ethyl, n-propyl, isopropyl, n-butyl, sec-butyl, tert-butyl, pentyl, hexyl, octyl, 4-phenylbutyl or 2-cyclohexylethyl, more preferably methyl, ethyl, n-propyl, isopropyl, n-butyl, sec-butyl or tert-butyl.

L^{b} is preferably trichloromethyl, pentachloroethyl, trifluoromethyl, pentafluoroethyl, or 5-cyclohexyl-2,2,3,3-tetrafluoropentyl, more preferably trichloromethyl, pentachloroethyl, trifluoromethyl or pentafluoroethyl.

L^{c} is preferably cyclobutyl, cyclopentyl, cyclohexyl, 4-ethylcyclohexyl, cyclooctyl or 4-phenylcycloheptyl, more preferably cyclopentyl, cyclohexyl, or 4-ethylcyclohexyl.

L^{d} is preferably phenyl, 1-naphthyl, 2-naphthyl, tolyl, xylyl, mesityl, cumenyl, 3,5-di-tert-butylphenyl, 4-cyclopentylphenyl, 2,3,6-triphenylphenyl, or 2,3,4,5,6-pentaphenylphenyl, more preferably phenyl, tolyl, xylyl, mesityl, cumenyl, or 2,3,4,5,6-pentaphenylphenyl.

L^{e} is preferably a group containing furan, thiophene, pyrrole, indole, indoline, pseudoindol, benzofuran, benzothiophene or morpholine, more preferably a group containing furan, thiophene, pyrrole or morpholine.

L^{f} is preferably methoxy, ethoxy, propoxy, isopropoxy, butoxy, methoxymethyl, methoxyethyl, 2-phenylethoxy, 3-cyclohexylpropoxy, pentyloxy, hexyloxy, or octyloxy, more preferably methoxy, ethoxy, propoxy, isopropoxy, or butoxy.

L^{g} is preferably acetyl, propionyl, butyryl, isobutyryl, benzoyl, 4-propylbenzoyl or trifluoromethylcarbonyl, more preferably acetyl, propionyl or benzoyl.

L^{h} is preferably methoxycarbonyl, ethoxycarbonyl, propoxycarbonyl, isopropoxycarbonyl, butoxycarbonyl, 2-trifluoromethylethoxycarbonyl or 2-phenylethoxycarbonyl, more preferably methoxycarbonyl or ethoxycarbonyl.

L^{a} to L^{h} may further have at least one atom or group selected from the group consisting of a halogen atom, a sulfo group, a hydroxyl group, a cyano group, a nitro group, a carboxyl group, a phosphoric acid group, and an amino group. Such an example includes 4-sulfobutyl, 4-cyanobutyl, 5-carboxypentyl, 5-aminopentyl, 3-hydroxypropyl, 2-phosphorylethyl, 6-amino-2,2-dichlorohexyl , 2-chloro-4-hydroxybutyl, 2-cyanocyclobutyl, 3-hydroxycyclopentyl, 3-carboxycyclopentyl, 4-aminocyclohexyl, 4-hydroxycyclohexyl, 4-hydroxyphenyl, pentafluorophenyl, 2-hydroxynaphthyl, 4-aminophenyl, 4-nitrophenyl, a group containing 3-methylpyrrole, 2-hydroxyethoxy, 3-cyanopropoxy, 4-fluorobenzoyl, 2-hydroxyethoxycarbonyl, 4-cyanobutoxycarbonyl.

R^{a} in Condition (a) is preferably an hydrogen atom, a chlorine atom, a fluorine atom, methyl, ethyl, n-propyl, isopropyl, n-butyl, sec-butyl, tert-butyl, cyclohexyl, phenyl, hydroxy, amino, dimethylamino or nitro, more preferably a hydrogen atom, a chlorine atom, a fluorine atom, methyl, ethyl, n-propyl, isopropyl or hydroxyl.

R^{b} in Condition (a) is preferably a hydrogen atom, a chlorine atom, a fluorine atom, methyl, ethyl, n-propyl, isopropyl, n-butyl, sec-butyl, tert-butyl, cyclohexyl, phenyl, hydroxy, amino, dimethylamino, cyano, nitro, acetylamino, propionylamino, N-methylethylcarboamino, trifluoroformylamino, pentafluoroacetylamino, tert-butyrylamino or cyclohexanoylamino, more preferably a hydrogen atom, a chlorine atom, a fluorine atom, methyl, ethyl, n-propyl, isopropyl, hydroxyl, dimethylamino, nitro, acetylamino, propionylamino, trifluoroformylamino, pentafluoroacetylamino, tert-butyrylamino or cyclohexanoylamino.

Y is preferably amino, methylamino, dimethylamino, diethylamino, di-n-propylamino, diisopropylamino, di-n-butylamino, di-tert-butylamino, N-ethyl-N-Methylamino or N-cyclohexyl-N-methylamino, more preferably dimethylamino, diethylamino, di-n-propylamino, diisopropylamino, di-n-butylamino or di-tert-butylamino.

Examples of the heterocyclic ring having the number of constituent atoms of 5 or 6 including at least one nitrogen atom formed by bonding at least one of two R^{a} on one benzene ring in Condition (b) of Formula I to Y on the same benzene ring include pyrrolidine, pyrrole, imidazole, pyrazole, piperidine, pyridine, piperazine, pyridazine, pyrimidine, and pyrazine etc.he heterocyclic rings, the perferable one is a heterocyclic ring constituting the heterocycle with one atom - being a nitrogen atom - adjacent to the carbon atom(s) constituting the benzene ring, and more preferably a pyrrolidine.

Herein, in the formula II, X independently represents 0, S, Se, N-R^{c} or C(R^{d}R^{d}), and there are a plurality of R^{c} each independently representing a hydrogen atom, L^{a}, L^{b}, L^{c}, L^{d} or L^{e}, and there is a plurality of R^{d} each independently representing a hydrogen atom, a halogen atom, a sulfo group, a hydroxyl group, a cyano group, a nitro group, a carboxyl group, a phosphoric acid group, -L¹ or -NR^{e}R^{f}, and adjacent R^{d}s may be bonded to each other to form a ring which may have a substituent, and L^{a} to L^{e}, L¹, R^{e} and R^{f} are synonymous with L^{a} to L^{e}, L¹, R^{e} and R^{f} as defined in the formula I.

R^{c} in the formula II is preferably a hydrogen atom, methyl, ethyl, n-propyl, isopropyl, n-butyl, sec-butyl, tert-butyl, n-pentyl, n-hexyl, cyclohexyl, phenyl, trifluoromethyl or pentafluoroethyl, more preferably a hydrogen atom, methyl, ethyl, n-propyl or isopropyl.

R^{d} in the formula II is preferably an hydrogen atom, a chlorine atom, a fluorine atom, methyl, ethyl, n-propyl, isopropyl, butyl, sec-butyl, tert-butyl, n-pentyl, n-hexyl, cyclohexyl, phenyl, methoxy, trifluoromethyl, pentafluoroethyl or 4-aminocyclohexyl, more preferably a hydrogen atom, a chlorine atom, a fluorine atom, methyl, ethyl, n-propyl, isopropyl, trifluoromethyl or pentafluoroethyl.

X is preferably 0, S, Se, N-Me, N-Et, CH₂, C-Me₂, or C-Et₂, and more preferably S, C-Me₂, or C-Et₂.

In the formula II, adjacent R^{d}s are bonded to each other to form a ring. Examples of such a ring include a benzopseudoindole ring, a α-naphthimidazole ring, a β-naphthimidazole ring, a α-naphthoxazole ring, a β-naphthoxazole ring, a α-naphthylthiazole ring, a β-naphthylthiazole ring, a α-naphthazole ring and a β-naphthazole ring.

Further, for the filtering material, Formula III also represents the squarylium-based compound.

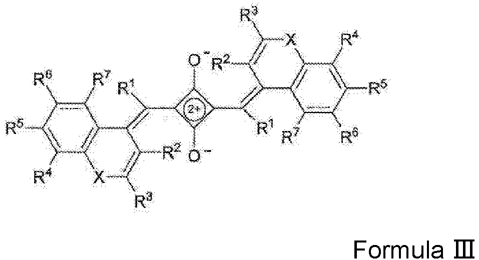

In the formula III, X independently represents an oxygen atom, a sulfur atom, a selenium atom or -NH-, and R¹ to R⁷ each independently represent a hydrogen atom, a halogen atom, a sulfo group, a hydroxyl group, a cyano group, a nitro group, a carboxyl group, a phosphoric acid group, -L¹ or -NR^{g}R^{h}. R^{g} and R^{h} each independently represent a hydrogen atom, -L^{a}, -L^{b}, -L^{c}, -L^{d} or -L^{e} or a - C(O)R' group (Rⁱ represents -L^{a}, -L^{b}, -L^{c}, -L^{d} or -L^{e}) .

L¹ is L^{a}, L^{b}, L^{c}, L^{d}, L^{e}, L^{f}, L^{g} or L^{h}.

L^{a} to L^{h} are synonymous with L^{a} to L^{h} as defined in the formula I.

R¹ is preferably an hydrogen atom, a chlorine atom, a fluorine atom, methyl, ethyl, n-propyl, isopropyl, n-butyl, sec-butyl, tert-butyl, cyclohexyl, phenyl, hydroxy, amino, dimethylamino or nitro, more preferably a hydrogen atom, a chlorine atom, a fluorine atom, methyl, ethyl, n-propyl, isopropyl or hydroxyl.

R² to R⁷ are preferably a hydrogen atom, a chlorine atom, a fluorine atom, methyl, ethyl, n-propyl, isopropyl, n-butyl, sec-butyl, tert-butyl, cyclohexyl, phenyl, hydroxy, amino, dimethylamino, cyano, nitro, acetylamino, propionylamino, N-methylethylcarboamino, trifluoroformylamino, pentafluoroacetylamino, tert-butyrylamino or cyclohexanoylamino, more preferably a hydrogen atom, a chlorine atom, a fluorine atom, methyl, ethyl, n-propyl, isopropyl, hydroxyl, dimethylamino, nitro, acetylamino, propionylamino, trifluoroformylamino, pentafluoroacetylamino, tert-butyrylamino or cyclohexanoylamino.

X is preferably an oxygen atom or a sulfur atom, and particularly preferably an oxygen atom.

Further, for the filtering material, Formula IV also represents the phthalocyanine-based compound.

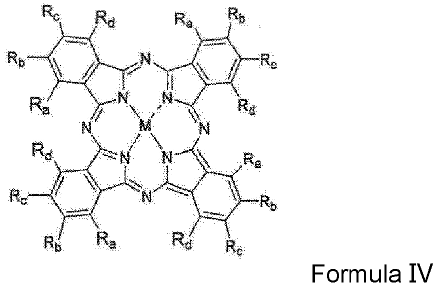

Herein, in the formula IV, M represents two hydrogen atoms, two monovalent metal atoms, a divalent metal atom, or a substituted metal atom containing a trivalent or tetravalent metal atom, and there are a plurality of R_{b}, R_{c} and R_{d} each independently representing a hydrogen atom, a halogen atom, a hydroxyl group, a carboxyl group, a nitro group, an amino group, an amide group, an imide group, a cyano group, a silane group, -L¹, -S-L², -SS-L², -S0₂-L³, -N = N-L⁴, or at least one of combination bonds of Rₐ and R_{b}, R_{b} and R_{c}, and R_{c} and R_{d}. Herein, at least one of R_{b}, R_{c} and R_{d} bonded to the same aromatic ring is not a hydrogen atom.

The amino group, the amide group, the imide group, and the silane group may have the substituent L defined in the formula I,
L¹ is synonymous with L¹ as defined in the formula I,
L² represents a hydrogen atom or any one of L^{a} to L^{e} as defined in the formula I,
L³ represents a hydroxyl group or any one of L^{a} to L^{e},
L⁴ represents any one of L^{a} to L^{e}.

At the stage shown in Fig. 27B, a frame-shaped light blocking portion 6270 may be formed on the protective element 627, wherein the photosensitive region 6212 of the photosensitive element 621 corresponds to a light passing hole 62701 of the light blocking portion 6270, such that light entering the interior of the image capturing module from the optical lens unit 610 can pass only through the light passing hole 62701 of the light blocking portion 6270 and is received by the photosensitive region 6212 of the photosensitive element 621. Preferably, the light blocking portion 6270 can be formed on the protective element 627 by a screen printing process. It should be noted that the material of the light blocking portion 6270 is not limited as long as it can block light from passing through it.

It should be noted that the stage shown in Fig. 27B can also be before the stage shown in Fig. 27A, so that the frame-shaped light blocking portion 6270 can be firstly formed on the protective element 627, and then the filter layer 6272 is formed on the protective element 627.

In addition, the light blocking portion 6270 may be formed only on the upper surface of the protective element 627. For example, the light blocking portion 6270 may be disposed only along the outer circumference of the protective element 627. In another example, the light blocking portion 6270 may also extend from the protective element 627 to at least a part of the upper surface of the molded base 623. In another example, it is also possible that the light blocking portion 6270 is formed on the lower surface of the protective element 627. For example, the frame-shaped light blocking portion 6270 may be firstly formed on the protective element 627, and then the protective element 627 is disposed on the photosensitive element 621 in an overlapping manner again so that the light blocking portion 6270 is located on the lower surface of the protective element 627.

In addition, the light blocking portion 6270 and the filter layer 6272 may or may not overlap with each other, and the image capturing module of the present disclosure is not limited in this respect.

At a stage shown in Fig. 28, a die clamping operation is performed on the forming die 6100, so that the semi-finished product of molded photosensitive assembly 620 is held between the upper die 6101 and the lower die 6102 of the forming die 6100, wherein the pressing surface 61011 of the upper die 6101 is pressed against a part of the molded base 623, so that another part of the molded base 623 is located within the molding space 6103 formed between the upper die 6101 and the lower die 6102.

It can be understood that, in other examples of the image capturing module of the disclosure, it is also possible that the upper die 6101 is pressed against the protective element 627, and at this time, the entirety of the top surface of the molded base 623 can be held within the molding space 6103, or the outer edge of the protective element 627 can also be held within the molding space 6103.

Preferably, the inner surface of the upper die 6101 is recessed to form a safety groove 61012, wherein at least a part of the protective element 627 corresponds to the mounting groove 61012 of the upper die 6101. In this way, when the forming die 6100 is clamped, at least a part of the protective element 627 can be received in the safety groove 61012, so as to avoid the pressing surface 61011 of the upper die 6101 from being pressed against the protective element 627, thereby avoiding the pressing surface 61011 of the upper die 6101 of the forming die 6100 from being pressed against the filter layer 6272 carried by the protective element 627.

In addition, the inner surface of the upper die 6101 is provided with the cover film 6106 in an overlapping manner, wherein when the forming die 6100 is clamped, the cover film 6106 is held between the pressing surface 61011 of the upper die 6101 and the top surface of the molded base 623, to prevent a gap from being formed between the pressing surface 61011 of the upper die 6101 and the top surface of the molded base 623. Moreover, the cover film 6106 is also capable of absorbing the impact force generated by the upper die 6101 and the lower die 6102 when being clamped, to avoid the impact force from directly acting on the molded photosensitive assembly 620. Additionally, the cover film 6106 can facilitate subsequent demolding.

At the stages shown in Fig.s 29 and 630, a third medium 300 is added into the molding space 6103, so that the third medium 300 fills the molding space 6103 and the third medium 300 forms a frame-shaped support member 628 integrally bonded to the top surface of the molded base 623 after it is cured in the molding space 6103, and at least one light passing hole 6281 is formed in a middle portion of the support member 628, wherein the photosensitive region 6212 of the photosensitive element 621 corresponds to the light passing hole 6281 of the support member 628.

Preferably, the third medium 300 is fluid so that the third medium 300 added to the molding space 6103 can fill the molding space 6103. For example, the third medium 300 can be, but is not limited to, solid particles, a liquid, or a mixture of solid particles and liquid.

It should be noted that the type of the third medium 300 and the type of the second medium 200 may be the same or different, and the image capturing module of the present disclosure is not limited in this regard.

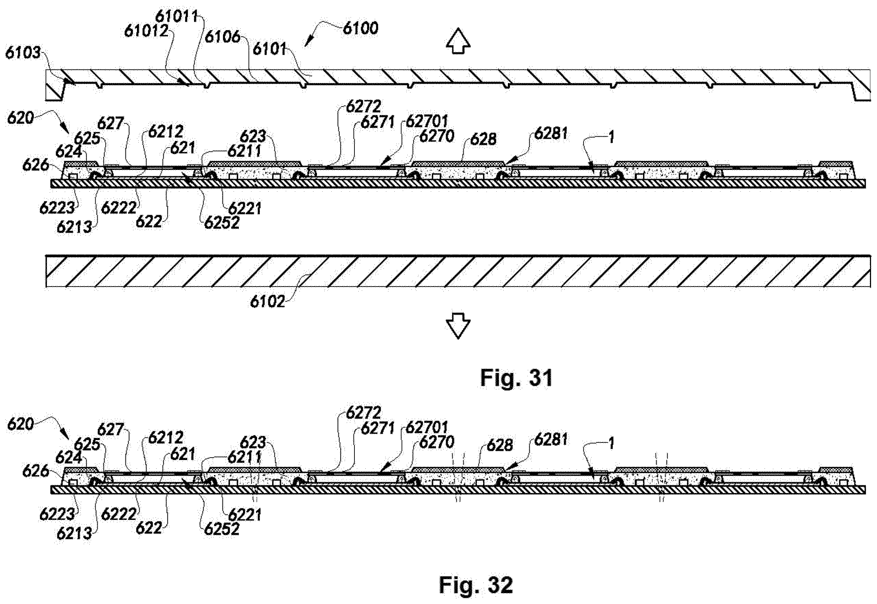

At a stage shown in Fig. 31, after the drafting operation is performed on the forming die 6100, the semi-finished product of molded photosensitive assembly 620 shown in Fig. 32 is obtained.

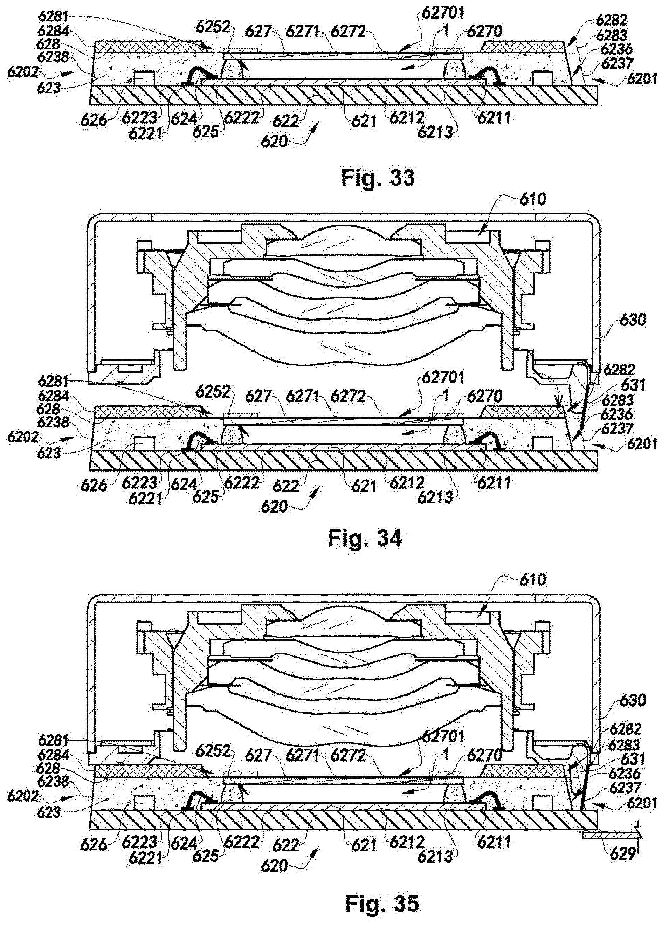

At a stage shown in Fig. 33, the semi-finished product of molded photosensitive assembly 620 is divided so as to obtain the molded photosensitive assembly 620.

It should be noted that in one example of the image capturing module of the present disclosure, the semi-finished product of molded photosensitive assembly 620 can be divided by cutting so as to obtain the molded photosensitive assembly 620. In another example of the image capturing module of the present disclosure, the semi-finished product of molded photosensitive assembly 620 may also be divided by etching so as to obtain the molded photosensitive assembly 620.

It is also to be noted that the segmentation direction of the image capturing module is not limited in the image capturing module of the present disclosure. For example, the segmentation direction of the image capturing module may be from the support member 628 to the circuit board 622, or may also be from the circuit board 622 to the support member 628.

In addition, in a specific example of the image capturing module of the present disclosure, the molded photosensitive assembly 620 has at least one demoulding side 6201 and at least one dividing side 6202, wherein a side of the molded photosensitive assembly 620, formed after the molding die 6300 and the forming die 6100 are drafted, is defined as the demoulding side 6201, and a side of the molded photosensitive assembly 620, formed after division, is defined as the dividing side 6202. It will be understood by those skilled in the art that the shape and inclination of the molded photosensitive assembly 620 on the demoulding side 6201 and the dividing side 6202 may be different. For example, at the demoulding side 6201 of the molded photosensitive assembly 620, the molded photosensitive assembly 620 may have a first demoulding surface 6237 and a second demoulding surface 6283, and at the dividing side 6202 of the molded photosensitive assembly 620, the molded photosensitive assembly 620 may have a first dividing surface 6238 and a second dividing surface 6284, wherein the first demoulding surface 6237 and the first dividing face 6238 of the molded photosensitive assembly 620 is used to define the molded base 623, and the second demoulding surface 6283 and the second dividing surface 6284 are used to define the support member 628.

It can be understood that the first demoulding surface 6237 and the second demoulding surface 6283 of the molded photosensitive assembly 620 may have the same inclination, or may have different inclinations, which are limited by the molding die 6300 and the forming die 6100. Correspondingly, the first dividing surface 6238 and the second dividing surface 6284 of the molded photosensitive assembly 620 have the same inclination, and preferably, the first dividing surface 6238 and the second dividing surface 6284 is in common plane.

It is to be noted that, in another example of the image capturing module of the present disclosure, the molded photosensitive assembly 620 may also have no demoulding side 6201, that is, each of four sides of the image capturing module can be the dividing side 6202 formed by division.

At a stage shown in Fig. 34, the driver 630, to which the optical lens unit 610 is assembled, is clingingly mounted on the support member 628. In addition, a motor pin 631 of the driver 630 may be conductively connected to the circuit board 622. Preferably, the molded base 623 has at least one first pin slot 6236, and the support member 628 has at least one second pin slot 6282, wherein the second pin slot 6282 of the support member 628 communicates with the first pin slot 6236 of the molded base 623, and the motor pin 631 of the driver 630 is held in the second pin slot 6282 and the first pin slot 6236, to avoid the motor pin 631 from protruding from an outer surface of the support member 628 and an outer surface of the molded base 623, thereby protecting the motor pin 631. It can be understood that it is possible to clingingly mount the lens barrel 660, in which the optical lens unit 610 is assembled, on the support member 628 or directly mount the optical lens unit 610 on the support member 628.

At a stage shown in Fig. 35, a connection board 629 is clingingly mounted on the circuit board 622 so as to fabricate the image capturing module. For example, the connection board 629 may be clingingly attached to the back surface of the circuit board 622 by an anisotropic conductive tape or an anisotropic conductive glue. Preferably, at least a part of the connection board 629 is a flexible connection board.

It is to be noted that, the stage shown in Fig. 35 can also be between the stages shown in Fig. 34, so that the connection board 629 is first clingingly mounted on the circuit board 622, and then the driver 630 where the optical lens unit 610 is assembled is clingingly mounted on the support member 628, so that the optical lens unit 610 is held in a photosensitive path of the photosensitive element 620.

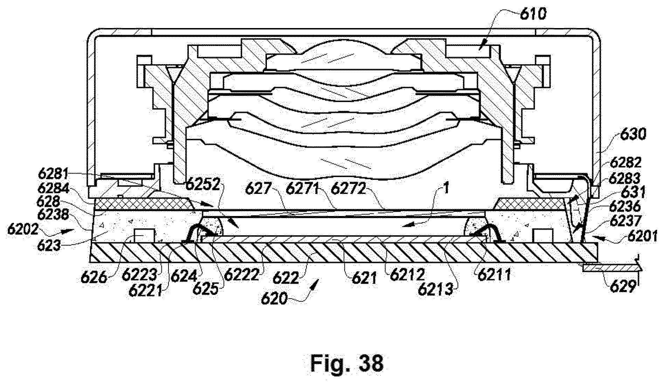

In a modified embodiment of the image capturing module shown in Fig. 38, the supporting element 625 may also be disposed on at least a part of the non-photosensitive region 6213 of the photosensitive element 621 and at least a part of the edge region 6223 of the circuit board 622, or the supporting element 625 is formed on at least a part of the non-photosensitive region 6213 of the photosensitive element 621 and at least a part of the edge region 6223 of the circuit board 622.

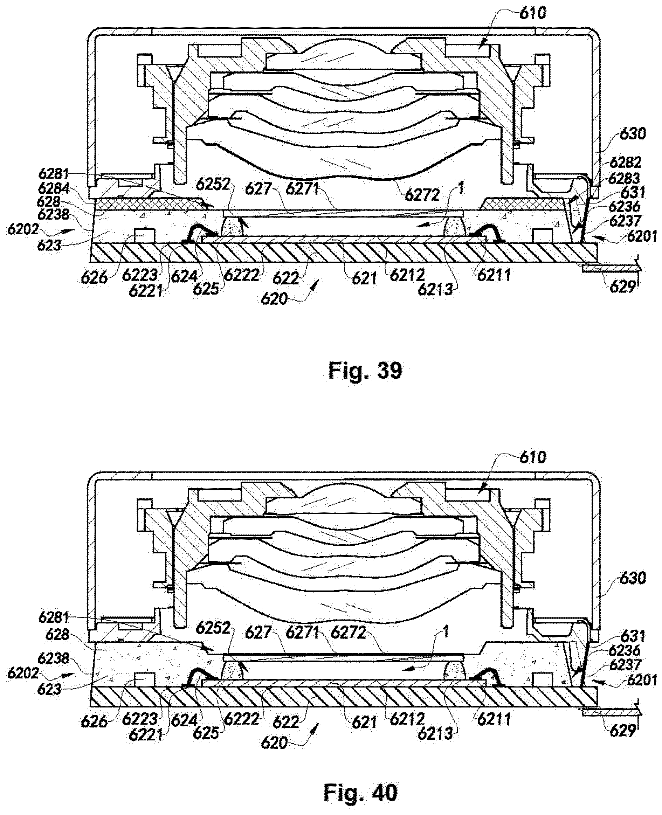

In another modified embodiment of the image capturing module shown in Fig. 39, the filtering material may also be applied to a surface of at least one lens of the optical lens unit 610, to form a filter layer 6272 overlapped with at least one lens of the optical lens unit 610.

In another modified embodiment of the image capturing module shown in Fig. 640, the support member 628 and the molded base 623 may also be integrally formed, that is, the support member 628 integrally extends from the top surface of the molded base 623. Specifically, at a stage shown in Figs. 26A and 26B, only the middle portion of the semi-finished product of molded photosensitive assembly 620 may be ground by a grinding process, so as to expose only at least a part of the protective element 627, so that the support member 628 can be formed around the protective element 627. In other words, the support member 628 integrally extends from the molded base 623 and the support member 628 surrounds around the protective element 627.

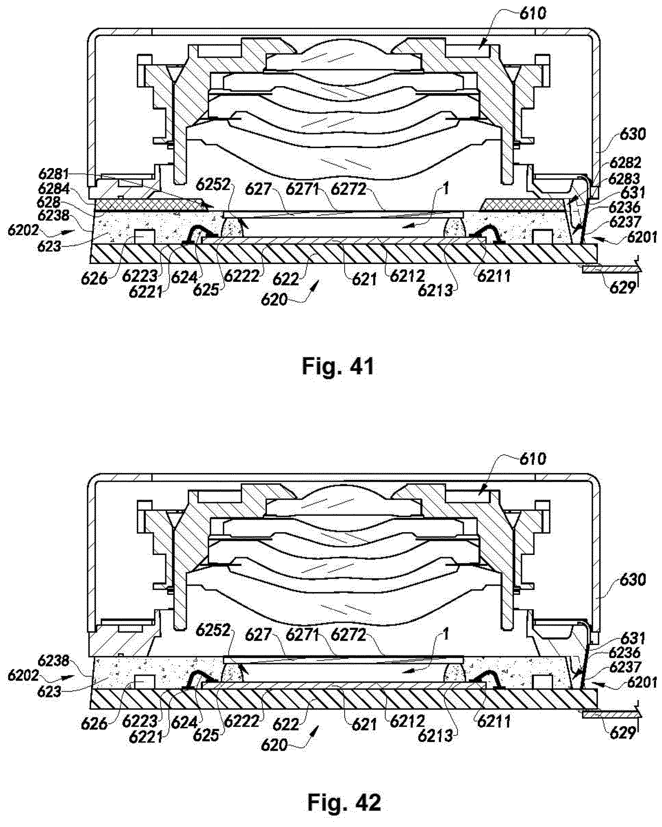

In another modified embodiment of the image capturing module shown in Fig. 41, the support member 628 may also be separately formed, and then the support member 628 is clingingly mounted on the top surface of the molded base 623, for example, may be clingingly mounted on the top surface of the molded base 623 by but not limited to, glue, and in a subsequent process, the driver 630 is clingingly mounted on the top surface of the support member 628, so that the support member 628 is held between the driver 630 and the molded base 623.

In another modified embodiment of the image capturing module shown in Fig. 42, the driver 630 may also be clingingly mounted on the top surface of the molded base 623 directly, that is, the support member 628 is not required between the driver 630 and the molded bases 623. It will be understood by those skilled in the art that the back focus distance of the image capturing module can be ensured by increasing the height of the driver 630.

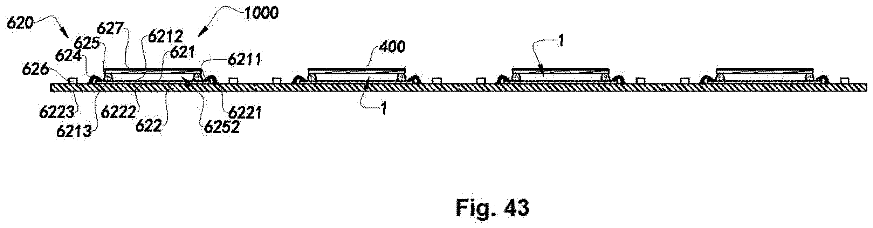

Referring to Figs. 43 to 50 of the drawings of the present disclosure, the states of another manufacturing method of the image capturing module at various stages are shown.

Specifically, in this exemplary illustration, after the stage shown in Fig. 18, a fourth medium 400 is further applied to the upper surface of the protective element 627, to make the fourth medium 400 cover the entirety of the upper surface of the protective element 627, so that the fourth medium 400 forms a compensation portion 500 overlapped with the protective element 627 on the upper surface of the protective element 627, with reference to the stage shown in Fig. 43.

It should be noted that the type of the fourth medium 400 may be the same as or different from the type of the first medium 6100. The image capturing module of the present disclosure is not limited in this regard. For example, the fourth medium 400 may be implemented as, but not limited to, glue or resin or ink in a specific example of the image capturing module of the present disclosure.

It should be noted that the fourth medium 400 also covers the circuit board 622. For example, in one embodiment, after the photosensitive element 621 is attached to the mounting region 622 of the circuit board 622 and the protective element 627 is disposed on the photosensitive element 621 in an overlapping manner, the surface of the protective element 627 and the edge region 6223 of the circuit board 622 simultaneously cover the fourth medium 400, so that the compensation portion 500 formed of the fourth medium 400 is simultaneously formed on the upper surface of the protective element 627 and the edge region 6223 of the circuit board 622. In another embodiment, the edge region 6223 of the circuit board 622 may also be covered only by the fourth medium 400, so that the compensation portion 500 is formed only in the edge region 6223 of the circuit board 622. In another embodiment, the mounting region 6222 and/or the edge region 6223 of the circuit board 622 may be firstly covered by the fourth medium 400, so that after the photosensitive element 621 is attached to the mounting region 6222 of the circuit board 622, the compensation portion 500 formed of the fourth medium 400 is held between the photosensitive element 621 and the circuit board 6223.

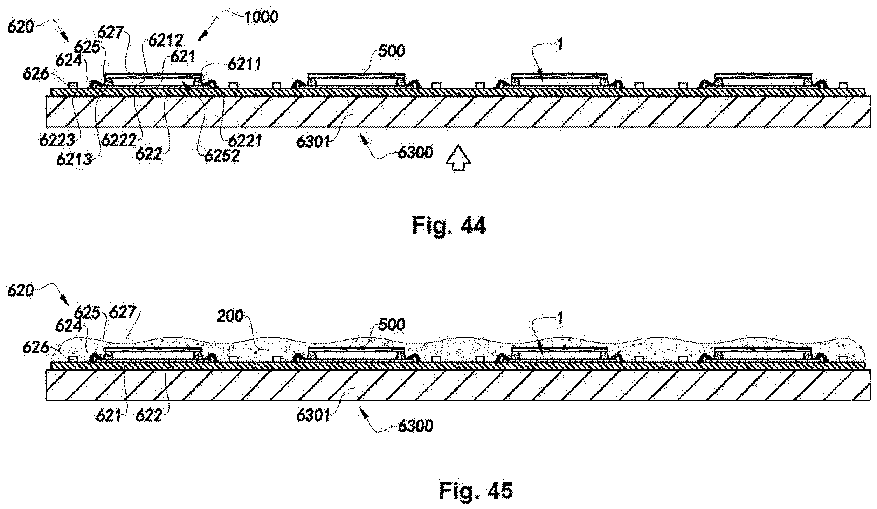

At a stage shown in Fig. 44, the splicing unit 1000 is first placed in a first die 6301 of the molding die 6300, and then the second medium 200 is overlaid on the splicing unit 1000 so as to make the second medium 200 cover the circuit board 622 and the lead wire 626. It can be understood that the photosensitive element 621 is also covered with the second medium 200. In this exemplary illustration, the second medium 200 may also cover at least a part of an upper surface of the protective element 627, such as at a stage illustrated in Fig. 45, and the second medium 200 may cover the entirety of the upper surface of the protective element 627. At this time, the compensation portion 500 is held between the second medium 200 and the protective element 627.

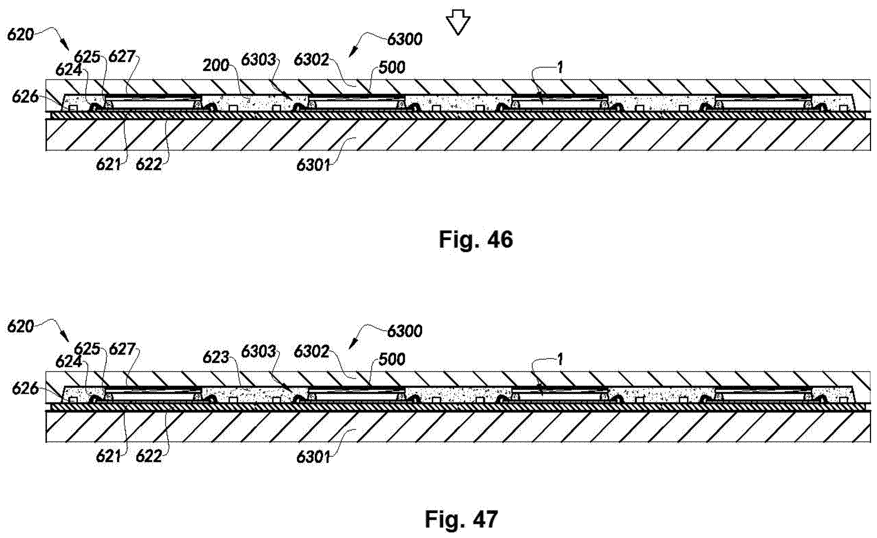

Then, at a stage shown in Fig. 46, a second die 6302 of the molding die 6300 is overlaid on the second medium 200 so that the splicing unit 1000 and the second medium 200 are held between the first die 6301 and the second medium 6302, and the splicing unit 1000 and the second medium 200 are held within a molding space 6303 formed between the first die 6301 and the second die 6302.

Nevertheless, it will be understood by those skilled in the art that a stage shown in Fig. 46 can also precede the stage shown in Fig. 45, so that the second die 6302 and the first die 6301 are firstly clamped so as to form the molding space 6303 between the first die 6301 and the second die 6302, and hold the splicing unit 1000 within the molding space 6303, and then the second medium 200 are added into the molding space 6303 so that the second medium 200 covers at least the circuit board 622 and the lead wire 626. At this stage shown in Fig. 621, the second medium 200 also covers the upper surface of the protective element 627, and the compensation portion 500 is held between the second medium 200 and the protective element 627.

At a stage shown in Fig. 47, at least one of the first die 6301 and the second die 6302 of the molding die 6300 is heated so as to make the second medium 200 containing solid particles held within the molding space 6303 melted. In one example, after the second medium 200 is melted, the temperature of at least one of the first die 6301 and the second die 6302 of the molding die 6300 is continued to be raised, to cause the melted second medium 200 to be cured and form the molded base 623. In another example, after the second medium 200 is melted, the temperature of the first die 6301 and the second die 6302 of the molding die 6300 is reduced, to cause the melted second medium 200 to be cured and form the molded base 623. Of course, those skilled in the art can understand that the melted second medium 200 can also be cured by ultraviolet light irradiation or the like, and the disclosure is not limited in this regard.

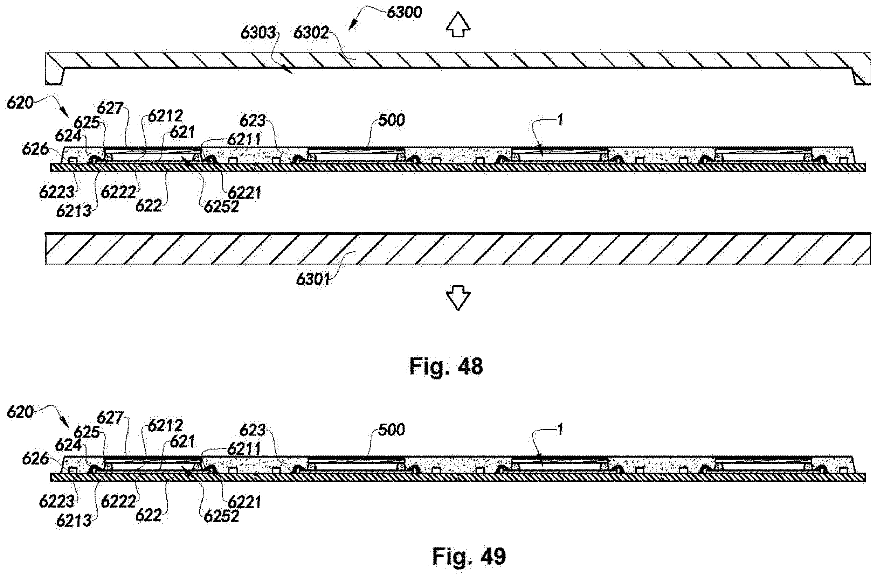

At the stages shown in Figs. 48 and 49, after the second medium 200 is cured within the molding space 6303 to form the molded base 623 integrally bonded to the circuit board 622, the lead wire 624, the photosensitive element 621 and the protective element 627, a drafting operation is performed on the molding die 6300 so as to form a semi-finished product of molded photosensitive assembly 620.

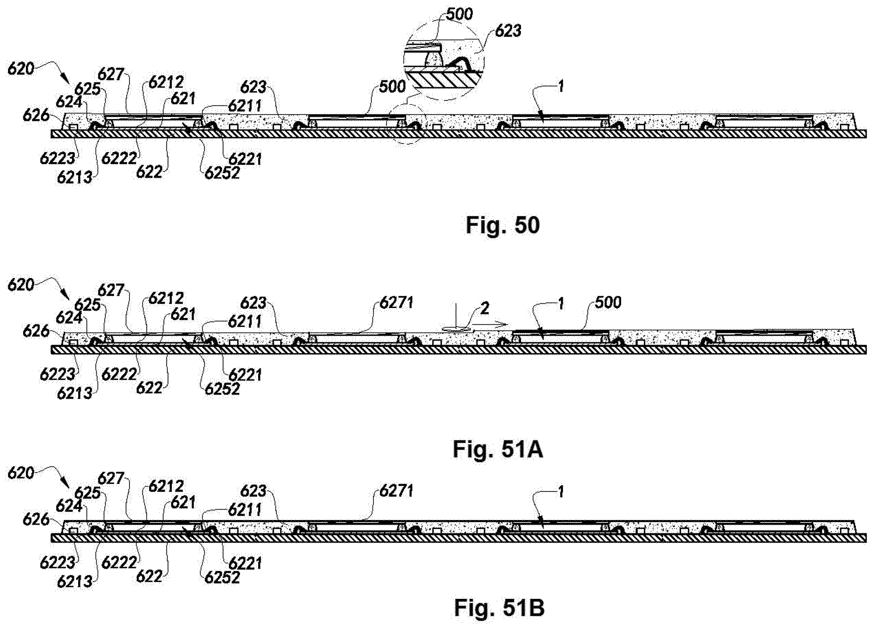

At a stage shown in Fig. 50, a baking process is performed on the semi-finished product of molded photosensitive assembly 620 so as to further cure the molded base 623. During the baking process, there is a difference in the deformation amplitudes of the protective element 627 and the molded base 623 formed by the second medium 200, and at this time, the compensating portion 500 held between the molded base 623 and the protective elements 627 can compensate for the difference between the deformation amplitude of the molded base 623 and the deformation amplitude of the protective element 627 by means of generating deformation, thereby avoiding the occurrence of an undesirable phenomenon that the molded base 623 pulls the protection element 627 because the deformation amplitude of the molded base 623 is greater than the deformation amplitude of the protection member 627, thereby preventing the protection member 627 from being cracked or the like, so as to ensure the product yield of the image capturing module.

At a stage shown in Figs. 51A and 51B, at least a part of the top of the semi-finished product of molded photosensitive assembly 620 is removed so that a part of the protective element 627 corresponding to the photosensitive region 6212 of the photosensitive element 621 is exposed, thereby subsequently allowing light to be received by the photosensitive region 6212 of the photosensitive element 621 after passing through the protective element 627.

Preferably, at least a part of the top portion of the semi-finished product of molded photosensitive assembly 620 is removed by a grinding process, to expose a part of the protective element 627 corresponding to the photosensitive region 6212 of the photosensitive element 621. It will be understood by those skilled in the art that the manner in which at least a part of the top portion of the semi-finished product of molded photosensitive assembly 620 is removed by a grinding process can ensure the flatness of the top portion of the semi-finished product of molded photosensitive assembly 620, especially ensuring the flatness of the exposed face 6271 of the protective element 627, so that when light is incident from the exposed face 6271 of the protective element 627, light does not occur refraction and other undesirable phenomena, so as to ensure the product yield of the image capturing module.

It will be understood by those skilled in the art that at least a part of the compensation portion 500 can also be removed by a grinding process so that a part of the protective element 627 corresponding to the photosensitive region 6212 of the photosensitive element 621 is exposed, to form the exposed face 6271 of the protective element 627.

Specifically, in the example shown in Fig. 51A, the label of the molded photosensitive assembly 620 may be ground by the grinding apparatus 2 so as to remove at least a part of the upper portion of the semi-finished product of molded photosensitive assembly 620, thereby obtaining a semi-finished product of molded photosensitive assembly 620 shown in Fig. 51B.

After the grinding process is performed, the stages shown in Figs. 27A to 35 can be continued.

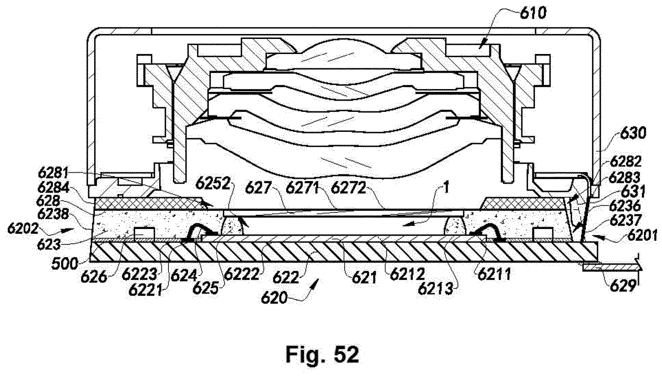

Fig. 52 shows a modified embodiment of the image capturing module, a part of the compensation portion 500 is held between the molded base 623 and the circuit board 622, a part of the compensation portion 500 is held between the molded base 623 and at least a part of the edge region 6223 of the circuit board 622, to compensate the difference between the deformation amplitude of the molded base 623 and the deformation amplitude of the circuit board 622 by the compensation portion 500 in the baking process, so that the good electrical properties of the circuit board 622 are ensured by means of avoiding the deformation of the circuit board 622 due to the molded base 623 pulling the circuit board 622.

At a stage shown in Fig. 43, the fourth medium 400 is applied not only to the upper surface of the protective element 627, but also to at least a part of the edge region 6223 of the circuit board 622, so that the fourth medium 400 forms the compensation portion 500 overlapped with the protection member 627 and at least a part of the edge region 6223 of the circuit board 622, respectively, and in a subsequent process, a part of the compensating portion 500 is held between the molded base 623 and the protective element 627, and another part of the compensating portion 500 is held between the molded base 623 and the circuit boards 622. And, in the subsequent grinding process, the part of the compensating portion 500 held in the molded base 623 and the protective element 627 is removed, and after completing the subsequent process, the image capturing module shown in Fig. 52 is obtained.

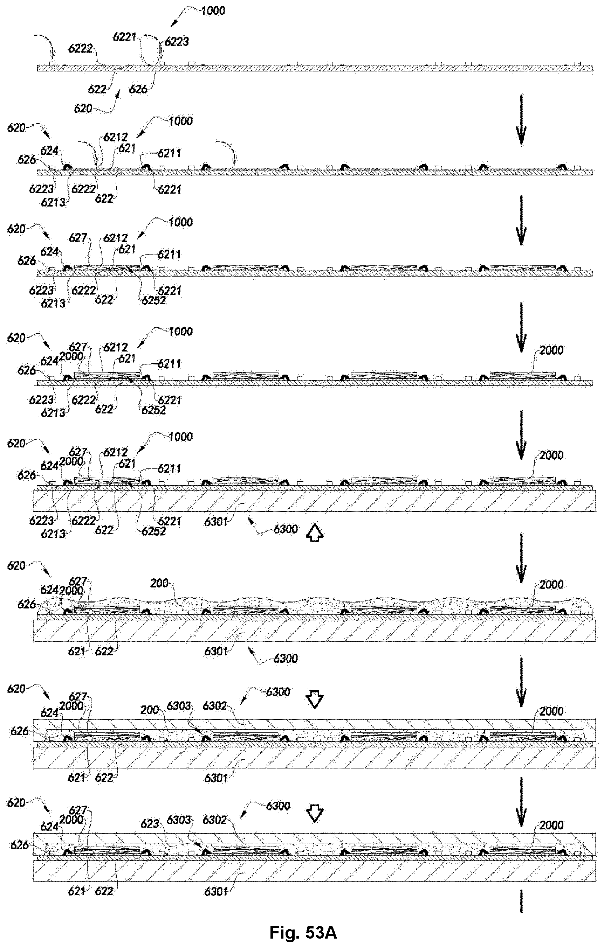

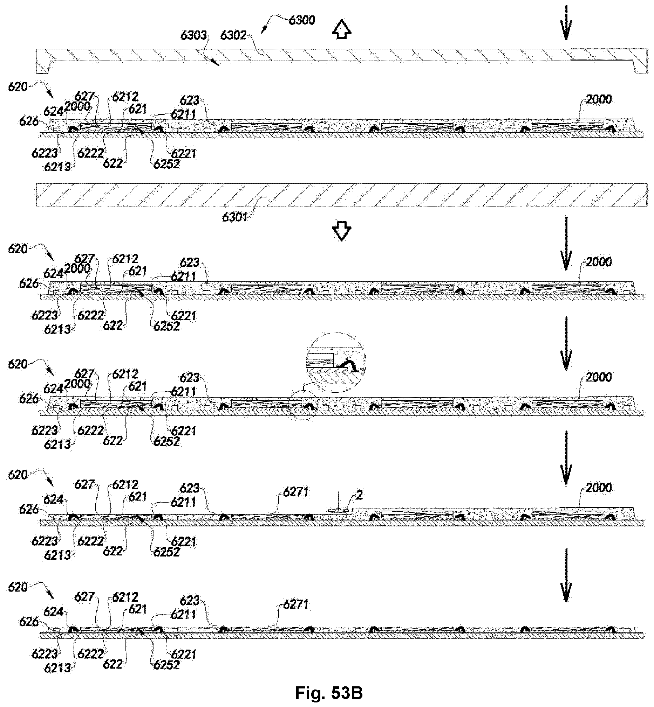

Fig. 53A and Fig. 53B show the states of another manufacturing method of the image capturing module at various manufacturing stages. In this example, the photosensitive element 621 is firstly conductively connected to the circuit board 622, the light-transmitting protective element 627 is then disposed on the photosensitive element 621 in an overlapping manner, and at least the photosensitive region 6212 of the photosensitive element 621 is covered by the protective element 627. It should be noted that although in the example shown in Fig. 53A and Fig. 53B, the support element 625 is not present between the protective element 627 and the non-photosensitive region 6213 of the photosensitive element 621, in other examples of the image capturing module, the support member 625 may also be held between the protective element 627 and the non-photosensitive region 6213 of the photosensitive element 621. Then, an auxiliary element 2000 is disposed on the upper surface of the protective element 627 in an overlapping manner, and in the subsequent molding process, at least a part of the top surfaces of the splicing unit 1000 and the auxiliary element 2000 is covered with the second medium 200, and after the second medium 200 is cured, the molded base 623 that is integrally bonded to the circuit board 622, the lead wire 624, the photosensitive element 621, the protective element 627, and the auxiliary element 2000 is formed, and a semi-finished product of the molded photosensitive assembly 620 is obtained.

It should be noted that in one example of the image capturing module of the present disclosure, the type of the auxiliary element 2000 is the same as the type of the protective element 2000, whereas in another example of the image capturing module of the present disclosure, the auxiliary element 2000 may also be implemented as an opaque element, as long as the protective element 2000 can be protected by isolating the upper surface of the protective element 2000 and the second medium 200 in the molding process.

Then, in the subsequent grinding process, the auxiliary element 2000 can be ground away. Alternatively, a part of the protective element 627 may also be removed during the grinding process, so that the protective element 627 forms the exposed surface 6271, and the photosensitive region 6212 of the photosensitive element 621 corresponds to the exposed surface 6271 of the protective element 627.

According to another aspect of the present disclosure, the present disclosure further provides a manufacturing method for an image capture module, wherein the manufacturing method comprises steps of:
(a) conductively connecting at least one photosensitive element 621 and a circuit board 622;
(b) disposing a light-transmitting protective element 627 on the photosensitive element 621 in an overlapping manner, and making the protective element 627 cover at least a photosensitive region 6212 of the photosensitive element 621;
(c) covering at least a part of a non-photosensitive region 6213 of the photosensitive element 621 and at least a part of an edge region 6223 of the circuit board 622 with a second medium 200;
(d) making the second medium 200 form a molded base 623 integrally bonded to the photosensitive element 621 and the circuit board 623 after being cured, to obtain a semi-finished product of molded photosensitive assembly 620;
(e) removing an upper portion of the semi-finished product of molded photosensitive assembly 620 to obtain a molded photosensitive assembly 620, wherein the protective element 627 forms an exposed face 6271, and the photosensitive region 6212 of the photosensitive element 621 corresponds to the exposed face 6271 of the protective element 627; and
(f) making an optical lens unit 610 be held in a photosensitive path of the photosensitive element 621 to obtain the image capture module.

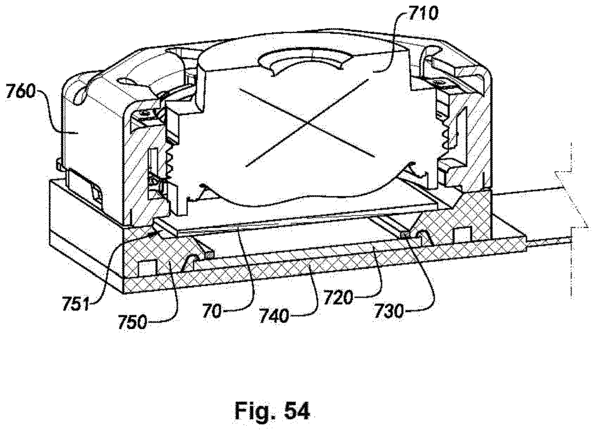

Referring to Figs. 54 to 56F of the accompanying drawings, an image capturing module in accordance with another preferred embodiment of the present disclosure is explained in the following description. The image capturing module includes at least one optical lens unit 710, at least one photosensitive chip 720, at least one protective frame 730, at least one circuit board 740, and at least one integrated package holder 750.

Specifically, in the image capturing module of the present disclosure, the photosensitive element 720 has a photosensitive area 721 and a non-photosensitive area 722 surrounding the photosensitive are 721. The protective frame 730 is convexly provided on the outer peripheral side of the photosensitive area of the photosensitive element 720. The photosensitive element 720 is electrically connected to the circuit board 740, and the integrated package holder 750 is provided to wrap the circuit board 740 and the non-photosensitive area of the photosensitive element 720, so that the integrated package holder 750, the photosensitive element 720 and the circuit board 740 are integrated to form a single piece. The optical lens 710 is disposed in a photosensitive path of the photosensitive element 720. Light reflected by the object can be concentrated by the optical lens 710 to the inside of the image capturing module and be further received and photoelectrically converted by the photosensitive element 720 to generate an image related to the object.

In a specific example of the image capturing module of the present disclosure, the photosensitive element 720 is mounted on the circuit board 740 and the photosensitive element 720 is electrically connected with the circuit board 740. For example, the photosensitive element 720 may be electrically connected to the circuit board 740 by a wire bonding process. For example, a gold wire is connected between the non-photosensitive area of the photosensitive element 720 and the circuit board 740 to electrically connect the photosensitive element 720 and the circuit board 740 by the gold wire as shown in Fig. 54.

In another specific example of the image capturing module of the present disclosure, the photosensitive element 720 is electrically connected to the circuit board 740 while being mounted on the circuit board 740. For example, the non-photosensitive area of the photosensitive element 720 is provided with a chip pad, and the circuit board 740 is provided with a circuit board pad. When the photosensitive element 720 is mounted on the circuit board 740, the chip pad of the photosensitive element 720 is electrically connected with the circuit board pad of the circuit board 740.

The protective frame 730 is a hollow structure that the protective frame 730 can be looped on the outer peripheral of the photosensitive area of the photosensitive element 720. Preferably, the size of the inner side of the protective frame 730 is greater than or equal to the size of the photosensitive area of the photosensitive element 720, so that when the protective frame 730 is protrudedly formed on the photosensitive element 720, the protective frame 730 can be held on the outer peripheral side of the photosensitive area of the photosensitive element 720 so that the protective frame 730 does not block the photosensitive area of the photosensitive element 720.

Preferably, the size of the outer side of the protective frame 730 is smaller than the size of the photosensitive element 720, so that when the protective frame 730 is protrudedly formed on the photosensitive element 720, the outer side of the non-photosensitive area of the photosensitive element 720 can be electrically conducted with the photosensitive element 720 and the circuit board 740 by a wire bonding process. However, it will be understood by one skilled in the art that when the photosensitive element 720 and the circuit board 740 are electrically connected through the chip pad and the circuit board pad, the size of the outer side of the protective frame 730 may be the same as the size of the photosensitive element 720.

The integrated package holder 750 wraps the circuit board 740 and the non-photosensitive area of the photosensitive element 720 after being molded, for integrating the integrated package holder 750, the circuit board 740 and the photosensitive element 720 into an integral body. In this way, the structural stability of the image capturing module can be increased, and the size of the image capturing module can be reduced, so that the image capturing module can be applied to an electronic device which is thin and in lightweight.

Furthermore, the integrated package holder 750 is arranged to wrap the outer peripheral side of the protective frame 730, so that the integrated package holder 750, the circuit board 740, the protective frame 730, and the photosensitive element 720 are integrated into an integral body.

Furthermore, as shown in Fig. 54, the image capturing module comprises at least one lens holding member 760, wherein the lens holding member 760 is provided above an upper portion of the integrated package holder 750, and the optical lens 710 is disposed on the lens holding member 760 to hold the optical lens 710 in the photosensitive path of the photosensitive element 720 by the lens holding member 760.

In a specific example of the image capturing module of the present disclosure, the lens holding member 760 is disposed on an upper portion of the integrated package holder 750 after molded. In another specific example of the image capturing module of the present disclosure, the lens holding member 760 can be integrally formed with the integrated package holder 750. In this way, the packaging error of manufacturing the image capturing module can be reduced to improve the imaging quality of the image capturing module.

Preferably, the lens holding member 760 may be embodied as a driver, such as a motor. That is, the optical lens 710 is operatively provided on the lens holding member 760 to be driven by the lens holding member 760. The optical lens 710 moves back and forth along the photosensitive path of the photosensitive element 720 for adjusting the focal length of the image capturing module by changing the position between the optical lens 710 and the photosensitive element 720. It is worth mentioning that the lens holding member 760 may be a variety of drivers for driving the optical lens 710 to move reciprocatedly along the photosensitive path of the photosensitive element 720. For example, in this preferred embodiment of the disclosure, the lens holding member 760 may be implemented as a voice coil motor.

One skilled in the art will understand that once the lens holding member 760 is embodied as a motor, the lens holding member 760 is electrically connected to the circuit board 740.

Furthermore, as shown in Fig. 54A, the image capturing module comprises a filter member 770, wherein the filter member 770 is disposed between the optical lens 710 and the photosensitive element 720. When light reflected by an object is collected from the optical lens 710 to the inside of the image capturing module, the light is filtered by the filter member 770 and received and photoelectrically converted by the photosensitive element 720 to improve the imaging quality of the image capturing module. In other words, the filter member 770 can function as a noise reduction to improve the imaging quality of the image capturing module.

It is worth to mention that the type of the filter member 770 can be unrestricted. For example, in a specific example of the image capturing module of the present disclosure, the filter member 770 can be embodied as an infrared cutoff filter for filtering infrared portion of the light by the filter member 770, and in another specific example of the image capturing module of the present disclosure, the filter member 770 is embodied as a full-transmission spectral filter.

The integrated package holder 750 forms at least one mounting platform 751 for mounting the filter member 770. For example, the mounting platform 751 may be a mounting recess formed in an upper portion of the integrated package holder 750 or the mounting platform 751 may be a flat surface formed on an upper portion of the integrated package holder 750. In other words, the filter member 770 can be directly mounted on the upper portion of the integrated package holder 750.

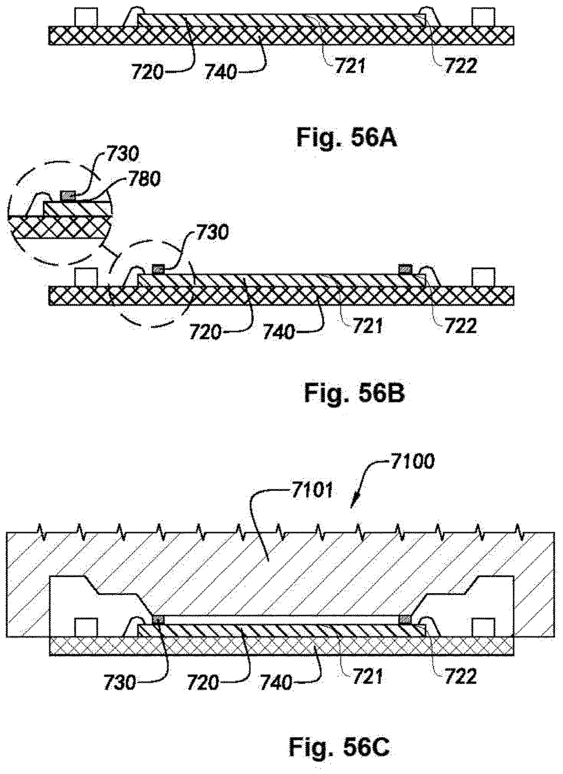

Fig.56A to 56F are sectional views illustrating a manufacturing method of the image capturing module according to the present disclosure, wherein in the Figs. 56A to 56F, the description of the image capturing module is shown in a sectional view for convenience of description of the structural relationship between the optical lens 710, the photosensitive element 720, the protective frame 730, the circuit board 740, and the integrated package holder 750.

In the step shown in Fig. 56A, the photosensitive element 720 is conducted with the circuit board 740. One skilled in the art will understand that, in the step as illustrated in Fig. 36A, after the photosensitive element 720 is mounted on the circuit board 740, the photosensitive element 720 is electrically conducted with the circuit board 740 by a wire bonding process. The manner of which the photosensitive element 720 being electrically connected with the circuit board 740 is merely exemplified. The manner in which the photosensitive element 720 and the circuit board 740 are electrically connected does not constitute a limitation on the scope of the present disclosure. In another example of the image capturing module of the present disclosure, the photosensitive element 720 and the circuit board 740 may also be directly electrically connected through the chip pad and the circuit board pad.

In the step as illustrated in Fig. 56B, the protective frame 730 is protrudedly provided on the outer peripheral side of the photosensitive area of the photosensitive element 720. Specifically, in the manufacturing method of the image capturing module of the present disclosure, after the protective frame 730 is provided, the protective frame 730 is protrudedly formed on the outer peripheral side of the photosensitive area of the photosensitive element 720. Preferably, a cementing layer 780 is formed between the protective frame 730 and the outer peripheral side of the photosensitive area of the photosensitive element 720, and the cementing layer 780 is used to connect the protective frame 730 and the outer peripheral side of the photosensitive area the photosensitive element 720.

For example, in an example of the image capturing module of the present disclosure, the glue is disposed on the outer peripheral side of the photosensitive frame 730 and/or the photosensitive area of the photosensitive element 720 to form the adhesive layer 780 between the protective frame 730 and/or the outer peripheral side of the photosensitive area of the photosensitive element 720. That is, at least one of the surfaces of the protective frame 730 and the outer peripheral side of the photosensitive area of the photosensitive element 720 forms the cementing layer 780. Subsequently, the cementing layer 780 is used to connect the protective frame 730 and the outer peripheral side of the photosensitive area of the photosensitive element 720.

Preferably, after the glue is disposed on the outer peripheral side of the photosensitive frame 730 and the photosensitive area of the photosensitive element 720, the glue may be rapidly solidified and cured to form the cementing layer 780 by heat curing or UV light curing for connecting the protective frame 730 and the outer peripheral side of the photosensitive area of the photosensitive element 720. In another example of the image capturing module of the present disclosure, the protective frame 730 may be provided with the cementing layer 780, so that the protective frame 730 may be directly used in the process of packaging the image capturing module. It is provided on the outer peripheral side of the photosensitive area 721 of the photosensitive element 720.

In addition, the protective frame 730 may be formed by an injection molding process or a stamping process. For example, the protective frame 730 may be a plastic product formed by an injection molding process.

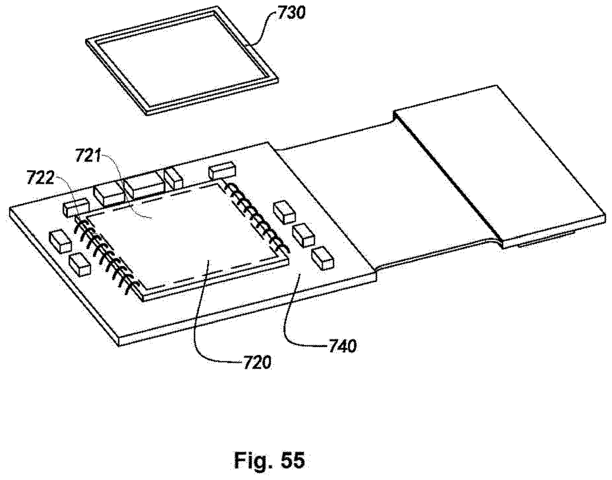

As shown in Fig. 55, the protective frame 730 is a hollow structure such that the protective frame 730 can be protrudedly formed on the outer peripheral side of the photosensitive area of the photosensitive element 720 for isolating the photosensitive area of the photosensitive element 720 with the external environment, so that during the subsequent encapsulation of the image capturing module, the protective frame 730 can prevent contaminants from entering the photosensitive area of the photosensitive element 720 to cause a bad stain point.

In the step as illustrated in Fig. 56C, the integral package holder 750 is formed by a molding-die 7100 during the process of packaging the image capturing module, wherein the molding-die 7100 comprises an upper mold 7101. An inner surface of the upper mold 7101 is pressed against the protective frame 730 to isolate the photosensitive area of the photosensitive element 720 and the external environment.

One skilled in the art would understand that the protective frame 730 is protrudedly formed on the outer peripheral side of the photosensitive area of the photosensitive element 720, so that when the inner surface of the upper mold 7101 is pressed, the protective frame 730 can prevent the inner surface of the upper mold 7101 from contacting the photosensitive area of the photosensitive element 720, so that the protective frame 730 can stop the inner surface of the upper mold 7101 causing damages or scratches to the photosensitive area of the photosensitive element 720.

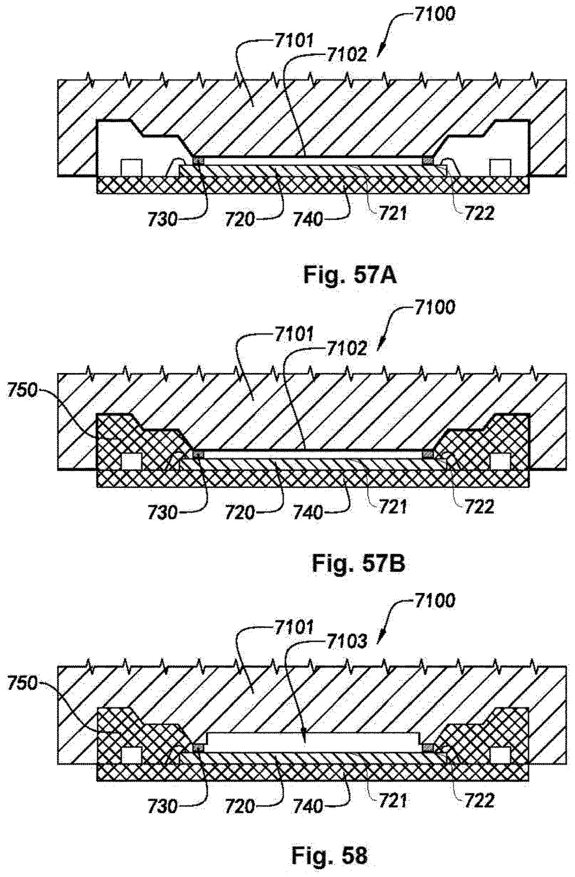

Furthermore, an alternative mode of the manufacturing method of the image capturing module as illustrated in Fig. 58, wherein a security recess 7102 is formed in a concave manner in an inner surface of the upper mold 7101 with respect to a part of the photosensitive area of the photosensitive element 720, so that the security recess 7102 can maintain a safe distance between the photosensitive area of the photosensitive element 720 and the inner surface of the upper mold 7101 during the process of molding the integral package holder 750 by the molding-die 7100. The safe distance further reduces the influence of the upper mold 7101 on the photosensitive element 720 to prevent the photosensitive element 720 from being damaged or scratched by the inner surface of the upper mold 7101.

Preferably, the protective frame 730 has a predetermined elasticity such that when the inner surface of the upper mold 7101 is pressed against the protective frame 730, the protective frame 730 can serve as a buffer to prevent the impact force generated by the upper mold 7101 when contacting the protective frame 730 to damage the photosensitive element 720. In addition, limited to the manufacturing method of the photosensitive element 720 and the manufacturing method of the circuit board 740 and the mounting process of the photosensitive element 720 and the circuit board 740, there may be a mounting tilt after the photosensitive element 720 is mounted on the circuit board 740. Accordingly, when the inner surface of the upper mold 7101 is pressed against the protective frame 730, the protective frame 730 can be deformed and the photosensitive area of the photosensitive element 720 is isolated from the external environment to prevent the molding material for forming the integral package holder 750 from entering the photosensitive area of the photosensitive element 720.

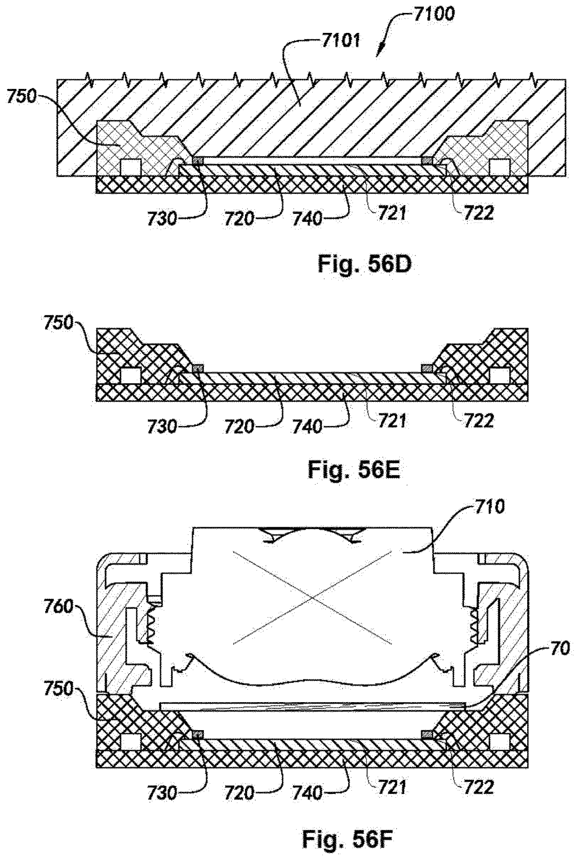

In the step as illustrated in Fig. 56D, the molding material is added and filled into the upper mold 7101, and the integral package holder 750 is formed after the molding material is cured, wherein the integral package holder 750 wraps the circuit board 740 and the non-photosensitive area of the photosensitive element 720, such that the integrated package holder 750, the circuit board 740, and the photosensitive element 720 are integrated to form an integral body. Preferably, the integrated package holder 750 further wraps the outer peripheral side of the protective frame 730 to integrate the integrated package holder 750, the circuit board 740, the protective frame 730, and the photosensitive element 720to form an integral body. It is worth mentioning that the molding material is fluid or granular. After the molding-die 7100 is removed, the integrally packaged holder 750, the circuit board 740, the protective frame 730, and the photosensitive element 720 are integrally connected as shown in Fig. 56E.

One skilled in the art would understand that the photosensitive area of the photosensitive element 720 and the external environment are isolated, so that the molding material will not flow to the photosensitive area of the photosensitive element 720 after the molding material is added to the upper mold 7101, so that the protective frame 730 can prevent the molding material from damaging the photosensitive area of the photosensitive element 720. In addition, the protective frame 730 has a predetermined elasticity such that there is no gap between the protective frame 730 and the upper mold 7101 pressed against the protective frame 730.Therefore, during the curing of the molding material added to the upper mold 7101, the phenomenon of "flashing" does not happen to ensure the image quality of the image capturing module.

Furthermore, according to an alternative mode of the manufacturing method of the image capturing module as illustrated in Figs. 57A and 57B, wherein the inner surface of the upper mold 7101 is provided with a covering film 7103. When the inner surface of the upper mold 7101 is pressed against the protective frame 730, the covering film 7103 provided on the upper mold 7101 is in direct contact with the protective frame 730, so that the covering film 7103 provides further protection to the photosensitive element 720. In addition, it can be understood that the covering film 7103 can reduce the difficulty of demolding and increase the sealing property by preventing the phenomenon "flash" appearing of the molding material on the inner side of the integrated package holder 750 during curing.

In the step as illustrated in Fig. 56F, the filter member 770 and the optical lens 710 are respectively arranged in the photosensitive path of the photosensitive element 720 to manufacture the image capturing module. Preferably, the filter member 770 is mounted on the integral package holder 750 and the optical lens 710 is held along the photosensitive path of the photosensitive element 720 by the lens holding member 760 provided to the integrated package holder 750.

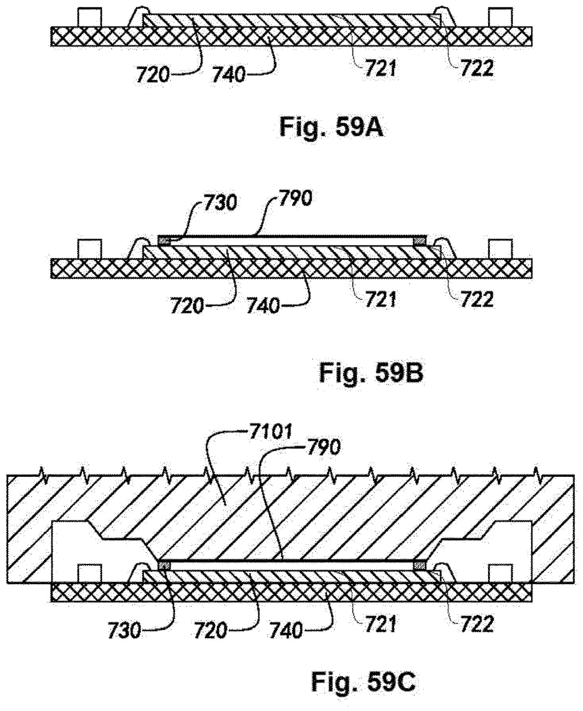

Figs. 59A to 59G are sectional views illustrating another manufacturing method of the image capturing module according to the present disclosure. In the step as illustrated in Fig. 59A, the photosensitive element 720 is electrically connected with the circuit board 740.

In the step as illustrated in Fig. 59B, the protective frame 730 is protrudedly formed on the outer peripheral side of the photosensitive area of the photosensitive element 720. Preferably, the upper portion of the protective frame 730 is provided with a protective film 790 to facilitate the suction of the protective frame 730 by vacuum adsorption and the mounting of the protective frame 730 to the periphery of the photosensitive area of the photosensitive element 720. It is understood by one skilled in the art that, after the protective frame 730 is disposed on the outer peripheral side of the photosensitive area of the photosensitive element 720, the protective film 790 correspondingly covers the upper portion of the photosensitive area of the photosensitive element 720 to isolate the photosensitive area of the photosensitive element 720 and the external environment by the protective film 790 and the protective frame 730, thereby preventing the molding material from flowing to the photosensitive area of the photosensitive element 720 in the subsequent steps.

In the step as illustrated in Fig. 59C, the inner surface of the upper mold 7101 of the molding-die 7100 is pressed against the protective frame 730 to further isolate the photosensitive area of the photosensitive element 720 and the external environment.

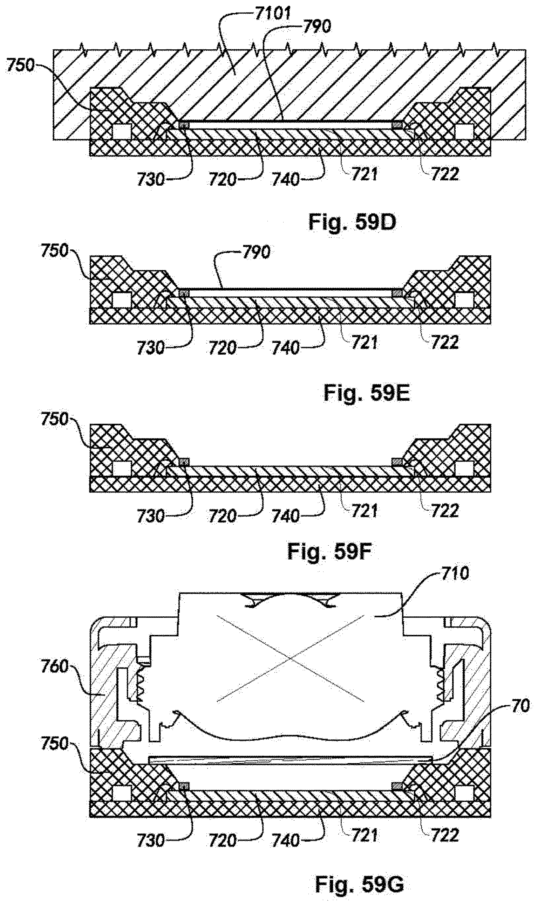

In the step as illustrated in Fig. 59D, the molding material is added to the molding-die 7100, and the integral package holder 750 is formed after the molding material is solidified and cured, wherein the integrated package holder 750 wraps the circuit board 740 and a non-photosensitive area of the photosensitive element 720, so that the integrated package holder 750, the circuit board 740 and the photosensitive element 720 are integrated to form an integral body. Preferably, the integrated package holder 750 further wraps the outer peripheral side of the protective frame 730 to integrate the integrated package holder 750, the circuit board 740, the protective frame 730, and the photosensitive element 720. After the molding-die 7100 is opened, an integral body of the integrated package holder 750, the circuit board 740, the protective frame 730, and the photosensitive element 720 can be obtained as shown in Fig. 59E, wherein the film 790 is still disposed on the protective frame 730.

In the step as illustrated in Fig. 59F, the protective film 790 is removed from the protective frame 730 to obtain an integral body of the integrated package holder 750, the circuit board 740, the protective frame 730, and the photosensitive element 720.

In the step as illustrated in Fig. 59G, the filter member 770 and the optical lens 710 are aligned and disposed along the photosensitive path of the photosensitive element 720 to manufacture the image capturing module.

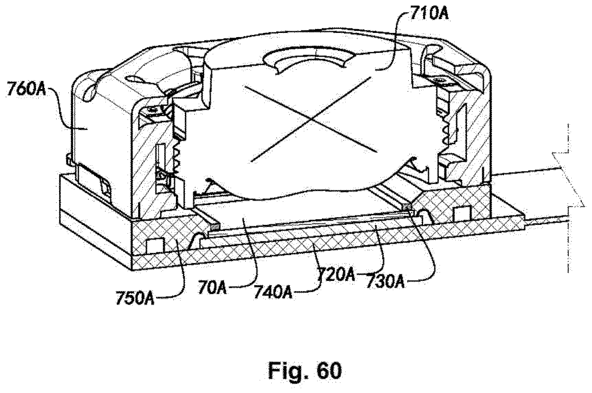

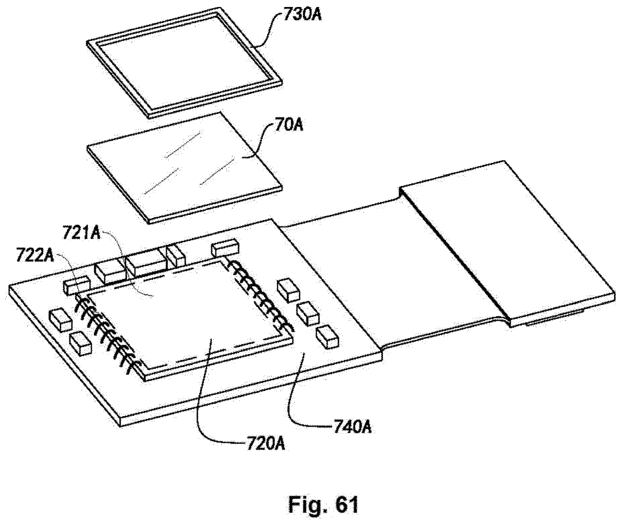

Referring to Fig. 60 to Fig. 62G of the drawings, the image capturing module according to another preferred embodiment of the present disclosure is illustrated, wherein the image capturing module comprises at least one optical lens 710A, at least one photosensitive element 720A, at least one a protective frame 730A, at least one circuit board 740A, at least one integrated package holder 750A, and at least one filter member 770A, wherein the photosensitive element 720A and the circuit board 740A are electrically connected and the at least one filter member 770A is overlapped on the photosensitive element 720A, wherein the protective frame 730A is disposed on the outer periphery of the filter member 770A such that the protective frame 730A does not block the photosensitive area of the photosensitive element 720A. The integrated package holder 750A is arranged to wrap the outer periphery of the circuit board 740A and the filter member 770A to integrate the integrated package holder 750A, the filter member 770A, the photosensitive element 720A, and the circuit board 740A to form an integral body. The optical lens 710A is disposed in a photosensitive path of the photosensitive element 720A. Light reflected by the object is collected by the optical lens 710A into the inside of the image capturing module and received by the photosensitive element 720A for photoelectrically conversion to generate an image related to the object.

Preferably, the integrated package holder 750A wraps the outer periphery of the circuit board 740A and the filter member 770A during molding, so that the integrated package holder 750A, the filter member 770A, and the photosensitive element 720A are integrally combined with the circuit board 740A.

More preferably, the integral package holder 750A further wraps the outer side of the protective frame 730A to make the integrated package holder 750A, the filter member 770A, the photosensitive element 720A, the circuit board 740A, and the protective frame 730A being integrally combined.

The protective frame 730A is protrudedly formed on the outer periphery of the filter member 770A, so that when the inner surface of the upper mold 7101A of a molding-die 7100A is pressed against the protective frame 730A, the inner surface of the upper mold 7101A does not contact with the surface of the filter member 770A, thereby preventing the inner surface of the upper mold 7101A from being damaged or scratching the filter member 770A. That is, the protective frame 730A that is protrudedly formed on the outer periphery of the filter member 770A to maintain a safe distance between the surface of the filter member 770A and the inner surface of the upper mold 7101A to prevent the inner surface of the upper mold 7101A causing damages or scratches on the filter member 770A.

Furthermore, the image capturing module comprises at least one lens holding member 760A, wherein the lens holding member 760A is disposed on an upper portion of the integrated package holder 750A, and the optical lens 710A is disposed on the lens holding member 760A. The optical lens 710A is held in the photosensitive path of the photosensitive element 720A by the lens holding member 760A.

In a specific example of the image capturing module of the present disclosure, the lens holding member 760A is disposed at an upper portion of the integrated package holder 750A after molded. In another specific example of the image capturing module of the present disclosure, the lens holding member 760A can be integrally formed with the integrated package holder 750A. In this way, the packaging error of the image capturing module can be reduced in order to improve the imaging quality of the image capturing module.

Preferably, the lens holding member 760A may be embodied as a motor, i.e. the optical lens 710A being operatively disposed on the lens holding member 760A to be drivenby the lens holding member 760A. The optical lens 710A moves back and forth along the photosensitive path of the photosensitive element 720A, thereby adjusting the focal length of the image capturing module by changing the position between the optical lens 710A and the photosensitive element 720A. It is worth mentioning that the lens holding member 760A may be various drivers for driving the optical lens 710A to move back and forth along the photosensitive path of the photosensitive element 720A, for example, in this preferred embodiment of the disclosure. The lens holding member 760A can be embodied as a voice coil motor.

One skilled in the art would understand that when the lens holding member 760A is embodied as a motor, the lens holding member 760A is electrically connected to the circuit board 740A.

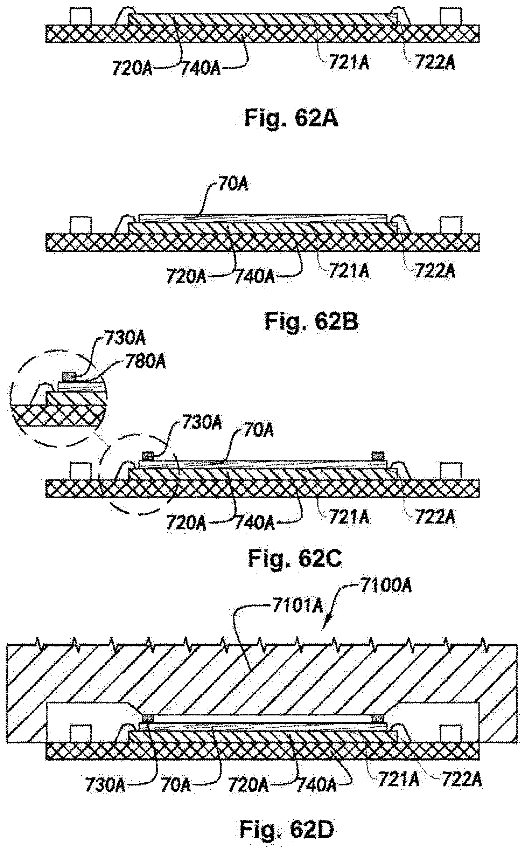

Figs. 62A to 62G are sectional views illustrating a manufacturing method of the image capturing module of the present disclosure. In the step as illustrated in Fig. 62A, the photosensitive element 720A is electrically connected to the circuit board 740A, wherein the manner of how the photosensitive element 720A and the circuit board 740A are electrically connected is not limited in this disclosure, similarly to the above-described preferred embodiments of the present disclosure.

In the step as illustrated in Fig. 62B, the filter member 770A is overlappedly disposed on the photosensitive element 720A. One skilled in the art would understand that the manner that the filter member 770A and the photosensitive element 720A are overlapped can reduce the back focus of the image capturing module, thereby facilitating miniaturization of the image capturing module to enable the image capturing module to be applied to electronic devices that are thin and lightweight.

In the step, as illustrated in step 62C, the protective frame 730A is placed on the outer periphery of the filter member 770A, wherein the protective frame 730A does not block the photosensitive area of the photosensitive element 720A. One skilled in the art would understand that after the protective frame 730A is provided, the protective frame 730A can be disposed on the outer periphery of the filter member 770A through a cementing layer 780A. That is, the cementing layer 780A disposed between the protective frame 730A and the filter member 770A is used to connect the protective frame 730A with the filter member 770A.

In the step as illustrated in Fig. 62D, the protective frame 730A is pressed by the inner surface of the upper mold 7101A to isolate the inner region and the outer periphery of the filter member 770A, wherein the size of an inner region of the filter member 770A is greater than or equal to the photosensitive area of the photosensitive element 720A to prevent the protective frame 730A from blocking the photosensitive area of the photosensitive element 720A. One skilled in the art would understand that the protective frame 730A is protrudedly formed on the outer periphery of the filter member 770A, so that when the pressing surface 1011 D of the upper mold 7101A is pressed against the protective frame 730A, the protective frame 730A can prevent the pressing surface 1011 D of the upper mold 7101A from contacting the photosensitive area of the filter member 770A, so that the protective frame 730A can block the pressing surface of the upper mold 7101A to cause damages or scratches on the inner region of the filter member 770A.

Preferably, the protective frame 730A has a predetermined elasticity such that when the inner surface of the upper mold 7101A is pressed against the protective frame 730A, the protective frame 730A can serve as a buffer to prevent the pressure generated by the upper mold 7101A damaging the filter member 770A.

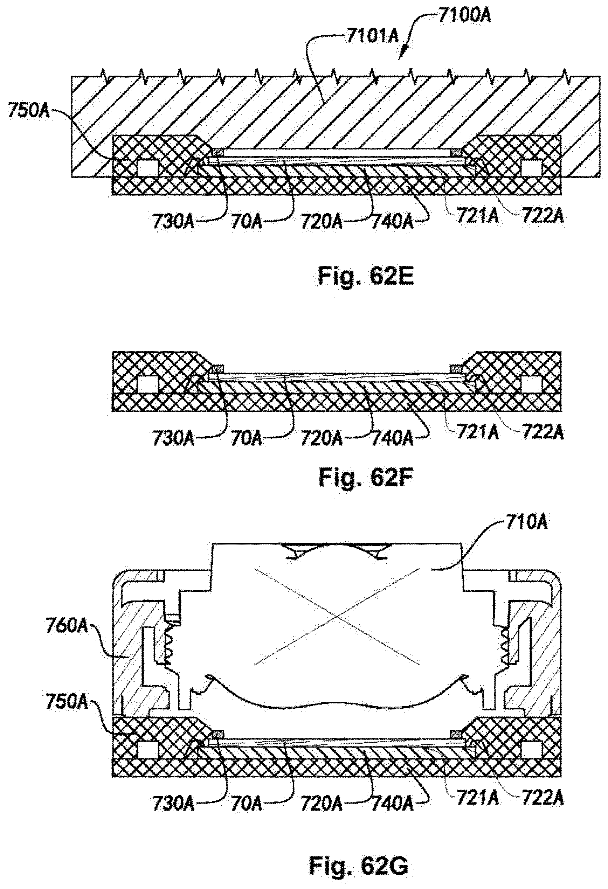

In the step as illustrated in Fig. 62E, the molding material is added to the upper mold 7101A, and the integral package holder 750A is formed after the molding material is solidified and cured, wherein the integral package holder 750A wraps the circuit board 740A and the non-photosensitive area of the photosensitive element 720A, such that the integrated package holder 750A, the circuit board 740A, and the photosensitive element 720A are integrated to form an integral body. Preferably, the integrated package holder 750A further wraps the outer peripheral side of the protective frame 730A to integrate the integrated package holder 750A, the circuit board 740A, the protective frame 730A, and the photosensitive element 720A to form an integral body. It is worth mentioning that the molding material is fluid or granular. After the molding-die 7100A is removed, the integrally packaged holder 750A, the circuit board 740A, the protective frame 730A, and the photosensitive element 770A are integrally connected as shown in Fig. 62F.

One skilled in the art would understand that the photosensitive area of the photosensitive element 770A and the external environment are isolated, so that the molding material does not flow to the photosensitive area of the photosensitive element 720A after the molding material is added to the upper mold 7101A, so that the protective frame 730Acan prevent the molding material from damaging the photosensitive area of the photosensitive element 720A. In addition, the protective frame 730A has a predetermined elasticity such that there is no gap between the protective frame 730A and the upper mold 7101A pressed against the protective frame 730A. Therefore, during the solidifying and curing of the molding material added to the upper mold 7101A, the phenomenon of "flashing" does not happen to ensure the image quality of the image capturing module.

In the step as illustrated in Fig. 62G, the filter member 770A and the optical lens 710A are aligned and disposed along the photosensitive path of the photosensitive element 720A to fabricate the image capturing module.

Furthermore, the present disclosure further provides a manufacturing method of an image capturing module, wherein the manufacturing method comprises the following steps:
(a) electrically connecting at least one photosensitive element 720 with at least one circuit board 740;
(b) providing at least one protective frame 730, wherein the protective frame 730 is formed on an outer peripheral side of a photosensitive area of the at least one photosensitive element 720;
(c) pressing an inner surface of an upper mold 7101 of a molding-die 7100 against the at least one protective frame 730 to isolate the photosensitive area and anon-photosensitive area of the at least one photosensitive element 720;
(d) wrapping the at least one circuit board 740 and the non-photosensitive area of the at least one photosensitive element 720 by a molding material added and cured in the molding-die 7100, wherein after the molding material is solidified and cured, an integrated package holder 750 is integrally formed and coupled with the photosensitive element 720 and the circuit board 740; and
(e) providing at least one optical lens 710, wherein the optical lens 710 is disposed in a photosensitive path of the at least one photosensitive element 720 to form the image capturing module.

Furthermore, the present disclosure also provides a manufacturing method of an image capturing module, wherein the manufacturing method comprises the following steps:
(A) electrically connecting at least one photosensitive element 720 and at least one circuit board 740;
(B) overlapping a filter member 770 on the at least one photosensitive element 720;
(C) providing at least one protective frame 730, wherein the protective frame 730 is disposed on an outer peripheral side of the filter member 770;
(D) pressing an inner surface of an upper mold 7101 of a molding-die 7100 against the protective frame 730 to isolate an inner region and an outer peripheral side of the filter member 770;
(E) wrapping the at least one circuit board 740 and the outer peripheral side of the filter member 620 by a molding material added and cured in the molding-die 7100, wherein after the molding material is solidified and cured, an integrated package holder 750 is integrally formed and coupled with the photosensitive element 720 and the circuit board 740; and
(F) providing at least one optical lens 710, wherein the at least one optical lens 710 is aligned and disposed in a photosensitive path of the at least one photosensitive element 720 to form the image capturing module.

Those skilled in the art should understand that the embodiments of the present disclosure described in the above description and the accompanying drawings are merely by way of illustration and not to limit the present disclosure. The scope of protection of the present application is defined by the appended claims.

## Claims

1. An image capturing module, comprising:
at least one optical lens unit (610);
at least one circuit board (622);
at least one light-transmitting protective element (627);
at least one photosensitive element (621), wherein the photosensitive element is conductively connected to the circuit board (622), wherein the photosensitive element has a photosensitive region (6212) and a non-photosensitive region (6213) surrounding the photosensitive region, wherein the protective element (627) is disposed on the photosensitive element in an overlapping manner, and the protective element (627) covers at least the photosensitive region (6212) of the photosensitive element;
wherein
the image capturing module comprises at least one frame-shaped supporting element (625) formed of a first medium, at least a part of the supporting element is held between the non-photosensitive region (6213) of the photosensitive element (621) and the protective element (627), wherein the supporting element (625) is resilient and forms a buffer portion held between the photosensitive element (621) and the protective element (627), and a sealed space (1) is formed among the protective element (627), the photosensitive element (621) and the supporting element (625), wherein the photosensitive region (6212) of the photosensitive element (621) is held in the sealed space (1) so as to prevent the photosensitive region (6212) of the photosensitive element (621) from being contaminated in subsequent molding process; and
the image capturing module comprises at least one molded base (623) formed of a second medium, wherein the molded base is integrally bonded to the circuit board (622), the photosensitive element (621), and the protective element (627), wherein at least a part of a top surface of the molded base is removed so that a part of the protective element corresponding to the photosensitive region of the photosensitive element is exposed to form an exposed face (6271) of the protective element (627), and the photosensitive region (6212) of the photosensitive element (621) corresponds to the exposed face (6271) of the protective element (627), wherein the optical lens unit (610) is held in a photosensitive path of the photosensitive element (621);
wherein the image capturing module further comprises at least one compensation portion (500),
wherein the compensation portion is formed of a fourth medium applied to an edge region of the circuit board (622), and the compensation portion is held between the molded base (623) and
the edge region of the circuit board (622) and configured to compensate the difference between the deformation amplitude of the molded base (623) and the deformation amplitude of the circuit board (622) in baking process.

2. The image capturing module according to claim 1, further comprising at least one frame-shaped light blocking portion, wherein the light blocking portion has at least one light passage, wherein the light blocking portion is overlapped with the protective element (627), and the photosensitive region (6212) of the photosensitive element (621) corresponds to the light passage of the light blocking portion, preferably wherein the light blocking portion extends from the protective element (627) to an upper surface of the molded base (623).

3. The image capturing module according to claim 1, wherein the supporting element (625) is formed of the first medium applied to the non-photosensitive region (6213) of the photosensitive element (621),
or
wherein the supporting element (625) is formed of the first medium applied to the non-photosensitive region (6213) of the photosensitive element (621) and edge region of the circuit board (622).

4. The image capturing module according to claim 1, further comprising at least one set of lead wires (624), wherein the lead wires are conductively connected to a chip connector (6211) of the photosensitive element (621) and a circuit board connector (6221) of the circuit board (622), so as to conductively connect the photosensitive element (621) and the circuit board (622) by the lead wires.

5. The image capturing module according to any one of claims 1 to 4, further comprising at least one electronic component (626), wherein the electronic component is conductively connected to the circuit board (622), preferably wherein the electronic component (626) protrudes from the circuit board (622), and the molded base (623) embeds at least a part of at least one of the electronic components (626) protruding from the circuit board (622).

6. The image capturing module according to any one of claims 1 to 5, further comprising at least one support member (628) having at least one light passing hole (6281), wherein the support member integrally extends from the top surface of the molded base (623), and the photosensitive region (6212) of the photosensitive element (621) corresponds to the light passing hole (6281) of the support member (628).

7. The image capturing module according to any one of claims 1 to 5, further comprising at least one support member (628), wherein the support member has at least one light passing hole (6281), wherein the support member is formed of a third medium held on the top surface of the molded base (623), and the light passing hole of the support member is simultaneously formed, and the photosensitive region (6212) of the photosensitive element (621) corresponds to the light passing hole (6281) of the support member (628).

8. The image capturing module according to any one of claims 1 to 5, further comprising at least one support member (628), wherein the support member has at least one light passing hole (6281), wherein the support member is disposed on the top surface of the molded base (623), and the photosensitive region (6212) of the photosensitive element (621) corresponds to the light passing hole (6281) of the support member (628).

9. The image capturing module according to any one of claims 1 to 5, wherein the image capturing module is implemented as a zoom image capturing module and further comprises at least one driver (630), wherein the optical lens unit (610) is drivably disposed on the driver, and the driver (630) is disposed on the top surface of the molded base (623), so as to hold the optical lens unit (610) in a photosensitive path of the photosensitive element (621) by the driver (630).

10. The image capturing module according to claim 6, 7 or 8, wherein the image capturing module is implemented as a zoom image capturing module and further comprises at least one driver (630), wherein the optical lens unit (610) is drivably disposed on the driver, and the driver (630) is disposed on the support member (628) so that the support member is held between the driver (630) and the molded base (623), and the optical lens unit (610) is held in a photosensitive path of the photosensitive element (621) by the driver (630).

11. The image capturing module according to any one of claims 1 to 5, wherein the image capturing module is implemented as a fixed focus image capturing module and further comprises at least one lens holder, wherein the optical lens unit (610) is disposed in the lens holder, and the lens holder is disposed on the top surface of the molded base (623), so as to hold the optical lens unit (610) in a photosensitive path of the photosensitive element (621) by the lens holder.

12. The image capturing module according to claim 6 or 7, wherein the image capturing module is implemented as a fixed focus image capturing module and further comprises at least one lens holder, wherein the optical lens unit (610) is disposed in the lens holder, and the lens holder is disposed on the support member (628) so that the support member is held between the lens holder and the molded base (623), and the optical lens unit (610) is held in a photosensitive path of the photosensitive element (621) by the lens holder.

13. The image capturing module according to any one of claims 1 to 5, wherein the image capturing module is implemented as a fixed focus image capturing module and further comprises at least one lens holder, wherein the optical lens unit (610) is disposed in the lens holder, and the lens holder integrally extends from the molded base (623), so as to hold the optical lens unit (610) in a photosensitive path of the photosensitive element (621) by the lens holder.

14. The image capturing module according to claim 6, 7 or 8, wherein the image capturing module is implemented as a fixed focus image capturing module and further comprises at least one lens holder, wherein the optical lens unit (610) is disposed in the lens holder, and the lens holder integrally extends from the support member (628), so as to hold the optical lens unit (610) in a photosensitive path of the photosensitive element (621) by the lens holder.

15. The image capturing module according to any one of claims 1 to 4, 6 to 8, further comprising a filter layer, wherein the filter layer is formed of an absorbing material applied to the exposed face (6271) of the protective element (627), and the filter layer is held between the optical lens unit (610) and the photosensitive element (621).

16. The image capturing module according to any one of claims 1 to 4, 6 to 8, further comprising a filter layer, wherein the filter layer is formed of an absorbing material applied to at least one lens of the optical lens unit (610).

## Patentansprüche

1. Bildaufnahmemodul, umfassend:
mindestens eine optische Linseneinheit (610);
mindestens eine Leiterplatte (622);
mindestens ein lichtdurchlässiges Schutzelement (627);
mindestens ein lichtempfindliches Element (621), wobei das lichtempfindliche Element leitend mit der Leiterplatte (622) verbunden ist, wobei das lichtempfindliche Element einen lichtempfindlichen Bereich (6212) und einen den lichtempfindlichen Bereich umgebenden nicht-lichtempfindlichen Bereich (6213) aufweist, wobei das Schutzelement (627) überlappend auf dem lichtempfindlichen Element angeordnet ist, und das Schutzelement (627) zumindest den lichtempfindlichen Bereich (6212) des lichtempfindlichen Elements bedeckt;
wobei das Bildaufnahmemodul mindestens ein rahmenförmiges Stützelement (625) umfasst, das aus einem ersten Medium gebildet ist, wobei mindestens ein Teil des Stützelements zwischen dem nicht-lichtempfindlichen Bereich (6213) des lichtempfindlichen Elements (621) und dem Schutzelement (627) gehalten ist, wobei das Stützelement (625) elastisch ist und einen Pufferabschnitt bildet, der zwischen dem lichtempfindlichen Element (621) und dem Schutzelement (627) gehalten ist, und wobei ein abgedichteter Raum (1) zwischen dem Schutzelement (627), dem lichtempfindlichen Element (621) und dem Stützelement (625) gebildet ist, wobei der lichtempfindliche Bereich (6212) des lichtempfindlichen Elements (621) in dem abgedichteten Raum (1) gehalten ist, um zu verhindern, dass der lichtempfindliche Bereich (6212) des lichtempfindlichen Elements (621) in einem nachfolgenden Formprozess verunreinigt wird; und
wobei das Bildaufnahmemodul mindestens eine geformte Basis (623) umfasst, die aus einem zweiten Medium gebildet ist, wobei die geformte Basis integral mit der Leiterplatte (622), dem lichtempfindlichen Element (621) und dem Schutzelement (627) verbunden ist, wobei mindestens ein Teil einer oberen Oberfläche der geformten Basis entfernt ist, so dass ein Teil des Schutzelements, der dem lichtempfindlichen Bereich des lichtempfindlichen Elements entspricht, freiliegt, um eine freiliegende Fläche (6271) des Schutzelements (627) zu bilden, und der lichtempfindliche Bereich (6212) des lichtempfindlichen Elements (621) der freiliegenden Fläche (6271) des Schutzelements (627) entspricht, wobei die optische Linseneinheit (610) in einem lichtempfindlichen Pfad des lichtempfindlichen Elements (621) gehalten ist;
wobei das Bildaufnahmemodul ferner mindestens einen Kompensationsabschnitt (500) umfasst, wobei der Kompensationsabschnitt aus einem vierten Medium gebildet ist, das auf einen Randbereich der Leiterplatte (622) aufgebracht ist, und der Kompensationsabschnitt zwischen der geformten Basis (623) und dem Randbereich der Leiterplatte (622) gehalten ist und dazu konfiguriert ist, den Unterschied zwischen der Verformungsamplitude der geformten Basis (623) und der Verformungsamplitude der Leiterplatte (622) im Backprozess auszugleichen.

2. Bildaufnahmemodul nach Anspruch 1, weiterhin umfassend mindestens einen rahmenförmigen Lichtblockierabschnitt, wobei der Lichtblockierabschnitt mindestens einen Lichtdurchlass aufweist, wobei der Lichtblockierabschnitt mit dem Schutzelement (627) überlappt ist, und der lichtempfindliche Bereich (6212) des lichtempfindlichen Elements (621) dem Lichtdurchlass des Lichtblockierabschnitts entspricht, vorzugsweise wobei sich der Lichtblockierabschnitt vom Schutzelement (627) bis zu einer oberen Oberfläche der geformten Basis (623) erstreckt.

3. Bildaufnahmemodul nach Anspruch 1, wobei das Stützelement (625) aus dem ersten Medium gebildet ist, das auf den nicht-lichtempfindlichen Bereich (6213) des lichtempfindlichen Elements (621) aufgebracht ist, oder
wobei das Stützelement (625) aus dem ersten Medium gebildet ist, das auf den nicht-lichtempfindlichen Bereich (6213) des lichtempfindlichen Elements (621) und den Randbereich der Leiterplatte (622) aufgebracht ist.

4. Bildaufnahmemodul nach Anspruch 1, weiterhin umfassend mindestens einen Satz von Anschlussdrähten (624), wobei die Anschlussdrähte leitend mit einem Chipanschluss (6211) des lichtempfindlichen Elements (621) und einem Leiterplattenanschluss (6221) der Leiterplatte (622) verbunden sind, um das lichtempfindliche Element (621) und die Leiterplatte (622) durch die Anschlussdrähte leitend zu verbinden.

5. Bildaufnahmemodul nach einem der Ansprüche 1 bis 4, weiterhin umfassend mindestens eine elektronische Komponente (626), wobei die elektronische Komponente leitend mit der Leiterplatte (622) verbunden ist, vorzugsweise wobei die elektronische Komponente (626) von der Leiterplatte (622) hervorsteht, und die geformte Basis (623) mindestens einen Teil von mindestens einer der elektronischen Komponenten (626) einbettet, die von der Leiterplatte (622) hervorsteht.

6. Bildaufnahmemodul nach einem der Ansprüche 1 bis 5, weiterhin umfassend mindestens ein Trägerelement (628) mit mindestens einem Lichtdurchgangsloch (6281), wobei das Trägerelement integral von der oberen Oberfläche der geformten Basis (623) erstreckt, und der lichtempfindliche Bereich (6212) des lichtempfindlichen Elements (621) dem Lichtdurchgangsloch (6281) des Trägerelements (628) entspricht.

7. Bildaufnahmemodul nach einem der Ansprüche 1 bis 5, weiterhin umfassend mindestens ein Trägerelement (628), wobei das Trägerelement mindestens ein Lichtdurchgangsloch (6281) aufweist, wobei das Trägerelement aus einem dritten Medium gebildet ist, das auf der oberen Oberfläche der geformten Basis (623) gehalten ist, und das Lichtdurchgangsloch des Trägerelements gleichzeitig gebildet wird, und der lichtempfindliche Bereich (6212) des lichtempfindlichen Elements (621) dem Lichtdurchgangsloch (6281) des Trägerelements (628) entspricht.

8. Bildaufnahmemodul nach einem der Ansprüche 1 bis 5, weiterhin umfassend mindestens ein Trägerelement (628), wobei das Trägerelement mindestens ein Lichtdurchgangsloch (6281) aufweist, wobei das Trägerelement auf der oberen Oberfläche der geformten Basis (623) angeordnet ist, und der lichtempfindliche Bereich (6212) des lichtempfindlichen Elements (621) dem Lichtdurchgangsloch (6281) des Trägerelements (628) entspricht.

9. Bildaufnahmemodul nach einem der Ansprüche 1 bis 5, wobei das Bildaufnahmemodul als Zoom-Bildaufnahmemodul ausgeführt ist und ferner mindestens einen Treiber (630) umfasst, wobei die optische Linseneinheit (610) antreibbar auf dem Treiber angeordnet ist, und der Treiber (630) auf der oberen Oberfläche der geformten Basis (623) angeordnet ist, um die optische Linseneinheit (610) durch den Treiber (630) in einem lichtempfindlichen Pfad des lichtempfindlichen Elements (621) zu halten.

10. Bildaufnahmemodul nach Anspruch 6, 7 oder 8, wobei das Bildaufnahmemodul als Zoom-Bildaufnahmemodul ausgeführt ist und weiterhin mindestens einen Treiber (630) umfasst, wobei die optische Linseneinheit (610) antreibbar auf dem Treiber angeordnet ist, und der Treiber (630) auf dem Trägerelement (628) angeordnet ist, so dass das Trägerelement zwischen dem Treiber (630) und der geformten Basis (623) gehalten wird, und die optische Linseneinheit (610) durch den Treiber (630) in einem lichtempfindlichen Pfad des lichtempfindlichen Elements (621) gehalten wird.

11. Bildaufnahmemodul nach einem der Ansprüche 1 bis 5, wobei das Bildaufnahmemodul als Bildaufnahmemodul mit festem Fokus ausgeführt ist und ferner mindestens einen Linsenhalter umfasst, wobei die optische Linseneinheit (610) im Linsenhalter angeordnet ist, und der Linsenhalter auf der oberen Oberfläche der geformten Basis (623) angeordnet ist, um die optische Linseneinheit (610) durch den Linsenhalter in einem lichtempfindlichen Pfad des lichtempfindlichen Elements (621) zu halten.

12. Bildaufnahmemodul nach Anspruch 6 oder 7, wobei das Bildaufnahmemodul als Bildaufnahmemodul mit festem Fokus ausgeführt ist und ferner mindestens einen Linsenhalter umfasst, wobei die optische Linseneinheit (610) im Linsenhalter angeordnet ist, und der Linsenhalter auf dem Trägerelement (628) angeordnet ist, so dass das Trägerelement zwischen dem Linsenhalter und der geformten Basis (623) gehalten wird, und die optische Linseneinheit (610) durch den Linsenhalter in einem lichtempfindlichen Pfad des lichtempfindlichen Elements (621) gehalten wird.

13. Bildaufnahmemodul nach einem der Ansprüche 1 bis 5, wobei das Bildaufnahmemodul als Bildaufnahmemodul mit festem Fokus ausgeführt ist und ferner mindestens einen Linsenhalter umfasst, wobei die optische Linseneinheit (610) in dem Linsenhalter angeordnet ist, und der Linsenhalter integral von der geformten Basis (623) erstreckt, um die optische Linseneinheit (610) durch den Linsenhalter in einem lichtempfindlichen Pfad des lichtempfindlichen Elements (621) zu halten.

14. Bildaufnahmemodul nach Anspruch 6, 7 oder 8, wobei das Bildaufnahmemodul als Bildaufnahmemodul mit festem Fokus ausgeführt ist und ferner mindestens einen Linsenhalter umfasst, wobei die optische Linseneinheit (610) in dem Linsenhalter angeordnet ist, und der Linsenhalter integral von dem Trägerelement (628) erstreckt, um die optische Linseneinheit (610) durch den Linsenhalter in einem lichtempfindlichen Pfad des lichtempfindlichen Elements (621) zu halten.

15. Bildaufnahmemodul nach einem der Ansprüche 1 bis 4, 6 bis 8, weiterhin umfassend eine Filterschicht, wobei die Filterschicht aus einem absorbierenden Material gebildet ist, das auf die freiliegende Fläche (6271) des Schutzelements (627) aufgebracht ist, und die Filterschicht zwischen der optischen Linseneinheit (610) und dem lichtempfindlichen Element (621) gehalten ist.

16. Bildaufnahmemodul nach einem der Ansprüche 1 bis 4, 6 bis 8, weiterhin umfassend eine Filterschicht, wobei die Filterschicht aus einem absorbierenden Material gebildet ist, das auf mindestens eine Linse der optischen Linseneinheit (610) aufgebracht ist.

## Revendications

1. Un module de capture d'images, comprenant :
au moins une unité de lentille optique (610) ;
au moins une carte de circuit imprimé (622) ;
au moins un élément de protection transmettant la lumière (627) ;
au moins un élément photosensible (621), dans lequel l'élément photosensible est relié par conduction à la carte de circuit imprimé (622), dans lequel l'élément photosensible a une région photosensible (6212) et une région non photosensible (6213) entourant la région photosensible, dans lequel l'élément de protection (627) est disposé sur l'élément photosensible de manière superposée, et l'élément de protection (627) couvre au moins la région photosensible (6212) de l'élément photosensible ;
dans lequel le module de capture d'images comprend au moins un élément de support en forme de cadre (625) formé d'un premier support, au moins une partie de l'élément de support est maintenue entre la région non photosensible (6213) de l'élément photosensible (621) et l'élément de protection (627), dans lequel l'élément de support (625) étant élastique et formant une partie tampon maintenue entre l'élément photosensible (621) et l'élément de protection (627), et un espace scellé (1) est formé entre l'élément de protection (627), l'élément photosensible (621) et l'élément de support (625), dans lequel la région photosensible (6212) de l'élément photosensible (621) est maintenue dans l'espace scellé (1) de manière à empêcher la région photosensible (6212) de l'élément photosensible (621) d'être contaminée lors d'un processus de moulage ultérieur ;
et le module de capture d'images comprend au moins une base moulée (623) formée d'un second support, dans laquelle la base moulée est intégralement liée à la carte de circuit imprimé (622), à l'élément photosensible (621) et à l'élément de protection (627), dans lequel au moins une partie d'une surface supérieure de la base moulée est retirée de sorte qu'une partie de l'élément de protection correspondant à la région photosensible de l'élément photosensible est exposée pour former un face (6271) de l'élément de protection (627), et la région photosensible (6212) de l'élément photosensible (621) correspond à la face exposée (6271) de l'élément de protection (627), dans laquelle l'unité de lentille optique (610) est maintenue dans un chemin photosensible de l'élément photosensible (621) ;
dans lequel le module de capture d'image comprend en outre au moins une partie de compensation (500), dans laquelle la partie de compensation est formée d'un quatrième support appliqué à une région de bord de la carte de circuit imprimé (622), et la partie de compensation est maintenue entre la base moulée (623) et la région de bord de la carte de circuit imprimé (622) et configurée pour compenser la différence entre l'amplitude de déformation de la base moulée (623) et l'amplitude de déformation du circuit planche (622) en cours de cuisson.

2. Module de capture d'images selon la revendication 1, comprenant en outre au moins une partie bloquant la lumière en forme de cadre, dans lequel la partie bloquant la lumière ayant au moins un passage de la lumière, dans lequel la partie bloquant la lumière étant recouverte de l'élément de protection (627), et la région photosensible (6212) de l'élément photosensible (621) correspondant au passage de la lumière de la partie bloquant la lumière, de préférence dans lequel la partie bloquant la lumière s'étend de l'élément de protection (627) à une surface supérieure de la base moulée (623).

3. Module de capture d'images selon la revendication 1, dans lequel l'élément de support (625) est formé du premier support appliqué à la région non photosensible (6213) de l'élément photosensible (621), ou
dans lequel l'élément de support (625) est formé du premier milieu appliqué à la région non photosensible (6213) de l'élément photosensible (621) et à la région de bord de la carte de circuit imprimé (622).

4. Module de capture d'images selon la revendication 1, comprenant en outre au moins un ensemble de fils conducteurs (624), dans lequel les fils conducteurs sont reliés par conduction à un connecteur à puce (6211) de l'élément photosensible (621) et à un connecteur de carte de circuit imprimé (6221) de la carte de circuit imprimé (622), de manière à connecter par conduction l'élément photosensible (621) et la carte de circuit imprimé (622) par les fils conducteurs.

5. Module de capture d'images selon l'une quelconque des revendications 1 à 4, comprenant en outre au moins un composant électronique (626), dans lequel le composant électronique est relié par conduction à la carte de circuit imprimé (622), de préférence dans lequel le composant électronique (626) dépasse de la carte de circuit imprimé (622), et la base moulée (623) intègre au moins une partie d'au moins un des composants électroniques (626) dépassant de la carte de circuit imprimé (622).

6. Module de capture d'images selon l'une quelconque des revendications 1 à 5, comprenant en outre au moins un élément de support (628) ayant au moins un trou de passage de la lumière (6281), dans lequel l'élément de support s'étend intégralement à partir de la surface supérieure de la base moulée (623), et la région photosensible (6212) de l'élément photosensible (621) correspond au trou de passage de la lumière (6281) de l'élément de support (628).

7. Module de capture d'images selon l'une quelconque des revendications 1 à 5, comprenant en outre au moins un élément de support (628), dans lequel l'élément de support a au moins un trou de passage de la lumière (6281), dans lequel l'élément de support est formé d'un troisième milieu maintenu sur la surface supérieure de la base moulée (623), et le trou de passage de la lumière de l'élément de support est formé simultanément, et la région photosensible (6212) de l'élément photosensible (621) correspond au trou de passage de la lumière (6281) de l'élément de support (628).

8. Module de capture d'images selon l'une quelconque des revendications 1 à 5, comprenant en outre au moins un élément de support (628), dans lequel l'élément de support a au moins un trou de passage de la lumière (6281), dans lequel l'élément de support est disposé sur la surface supérieure de la base moulée (623), et la région photosensible (6212) de l'élément photosensible (621) correspond au trou de passage de la lumière (6281) de l'élément de support (628).

9. Module de capture d'images selon l'une quelconque des revendications 1 à 5, dans lequel le module de capture d'images est mis en oeuvre en tant que module de capture d'images zoom et comprend en outre au moins un pilote (630), dans lequel l'unité de lentille optique (610) est disposée de manière entraînable sur le pilote, et le pilote (630) est disposé sur la surface supérieure de la base moulée (623), de manière à maintenir l'unité de lentille optique (610) dans un chemin photosensible de l'élément photosensible (621) par le pilote (630).

10. Module de capture d'image selon la revendication 6, 7 ou 8, dans lequel le module de capture d'image est mis en oeuvre en tant que module de capture d'image zoom et comprend en outre au moins un pilote (630), dans lequel l'unité de lentille optique (610) est disposée de manière conduisive sur le pilote, et le pilote (630) est disposé sur l'élément de support (628) de sorte que l'élément de support est maintenu entre le pilote (630) et la base moulée (623), et l'unité de lentille optique (610) est maintenue dans un chemin photosensible de l'élément photosensible (621) par le pilote (630).

11. Module de capture d'images selon l'une quelconque des revendications 1 à 5, dans lequel le module de capture d'images est mis en oeuvre en tant que module de capture d'images à foyer fixe et comprend en outre au moins un support d'objectif, dans lequel l'unité de lentille optique (610) est disposée dans le support d'objectif, et le support d'objectif est disposé sur la surface supérieure de la base moulée (623), de manière à maintenir l'unité de lentille optique (610) dans un chemin photosensible de l'élément photosensible (621) par le support d'objectif.

12. Module de capture d'images selon la revendication 6 ou 7, dans lequel le module de capture d'images est mis en oeuvre en tant que module de capture d'images à foyer fixe et comprend en outre au moins un support d'objectif, dans lequel l'unité de lentille optique (610) est disposée dans le support d'objectif, et le support d'objectif est disposé sur l'élément de support (628) de sorte que l'élément de support est maintenu entre le support d'objectif et la base moulée (623), et l'unité de lentille optique (610) est maintenue dans un chemin photosensible de l'élément photosensible (621) par le support de lentille.

13. Module de capture d'images selon l'une quelconque des revendications 1 à 5, dans lequel le module de capture d'images est mis en oeuvre en tant que module de capture d'images à foyer fixe et comprend en outre au moins un support d'objectif, dans lequel l'unité de lentille optique (610) est disposée dans le support d'objectif, et le support d'objectif s'étend intégralement à partir de la base moulée (623), de manière à maintenir l'unité de lentille optique (610) dans un chemin photosensible de l'élément photosensible (621) par le support d'objectif.

14. Module de capture d'images selon la revendication 6, 7 ou 8, dans lequel le module de capture d'images est mis en oeuvre en tant que module de capture d'images à foyer fixe et comprend en outre au moins un support d'objectif, dans lequel l'unité de lentille optique (610) est disposée dans le support d'objectif, et le support d'objectif s'étend intégralement à partir de l'élément de support (628), de manière à maintenir l'unité de lentille optique (610) dans un chemin photosensible de l'élément photosensible (621) par le support d'objectif.

15. Module de capture d'images selon l'une quelconque des revendications 1 à 4, 6 à 8, comprenant en outre une couche filtrante, dans laquelle la couche filtrante est formée d'un matériau absorbant appliqué sur la face exposée (6271) de l'élément de protection (627), et la couche filtrante est maintenue entre l'unité de lentille optique (610) et l'élément photosensible (621).

16. Module de capture d'images selon l'une quelconque des revendications 1 à 4, 6 à 8, comprenant en outre une couche filtrante, dans laquelle la couche filtrante est formée d'un matériau absorbant appliqué sur au moins une lentille de l'unité de lentille optique (610).
